# EUROPEAN PATENT APPLICATION

(11) **EP 4 503 152 A1**
(43) Date of publication of application: **05.02.2025**
(21) Application number: 23781077.5
(22) Date of filing: 31.03.2023
(51) Int. Cl.: H01L 33/48, H01L 33/20

(54) **LAMINATE AND ELECTRONIC APPARATUS**

(30) Priority: 31.03.2022 JP 2022061262
(71) Applicant: Sony Semiconductor Solutions Corporation, Atsugi-shi, Kanagawa 243-0014 (JP)
(72) Inventor: SASAKI, Toru, Atsugi-shi, Kanagawa 243-0014 (JP); KASHIHARA, Hiroyuki, Atsugi-shi, Kanagawa 243-0014 (JP); KAWASHIMA, Satoshi, Atsugi-shi, Kanagawa 243-0014 (JP); FURUSE, Shunsuke, Atsugi-shi, Kanagawa 243-0014 (JP); KUROGI, Kana, Atsugi-shi, Kanagawa 243-0014 (JP); SAITO, Sotetsu, Atsugi-shi, Kanagawa 243-0014 (JP); SAITO, Suguru, Atsugi-shi, Kanagawa 243-0014 (JP); HIRATSUKA, Tatsumasa, Atsugi-shi, Kanagawa 243-0014 (JP); TANIKAWA, Seiya, Atsugi-shi, Kanagawa 243-0014 (JP)
(74) Representative: D Young & Co LLP
(86) International application number: PCT/JP2023/013604
(87) International publication number: WO 2023/191069

(57) **Abstract**

To provide a laminate capable of suppressing an occurrence of warping of a compound semiconductor layer.

The laminate includes: a driving circuit board and a semiconductor element layer which is provided on the driving circuit board and which includes a compound semiconductor layer. The compound semiconductor layer has an oval shape, a polygonal shape of which at least a corner has been cut off, or a polygonal shape of which at least a corner has been bent into a convex shape in a plan view.

## Description

### [Technical Field]

The present disclosure relates to a laminate and an electronic device including the laminate.

### [Background Art]

When affixing, on a supporting substrate, a compound semiconductor layer formed on a growth substrate, bonding strength is desirably secured. For example, PTL 1 describes bonding a solid-state imaging element to a support substrate in a method of manufacturing a solid-state imaging apparatus.

### [Citation List]

### [Patent Literature]

[PTL 1]
WO 2019/087764

### [Summary]

### [Technical Problem]

However, when temperature rises or falls during a bonding process, warping may occur due to a mismatch in coefficients of thermal expansion (CTEs) between the growth substrate and the compound semiconductor layer and corners of the compound semiconductor layer may be unable to retain bonding strength and may become uplifted. When such warping occurs in the compound semiconductor layer, there is a risk that a failure such as peeling of the compound semiconductor layer from the substrate may occur when the compound semiconductor layer is bonded to a substrate such as a driving circuit board or a supporting substrate in a subsequent process.

An object of the present disclosure is to provide a laminate capable of suppressing an occurrence of warping of a compound semiconductor layer and an electronic device including the laminate.

### [Solution to Problem]

In order to solve the problem described above, a laminate according to the present disclosure includes:
a driving circuit board; and
a semiconductor element layer which is provided on the driving circuit board and which includes a compound semiconductor layer,
wherein
the compound semiconductor layer has an oval shape, a polygonal shape of which at least a corner has been cut off, or a polygonal shape of which at least a corner has been bent into a convex shape in a plan view.

An electronic device according to the present disclosure includes the laminate according to the present disclosure.

### [Brief Description of Drawings]

[Fig. 1]

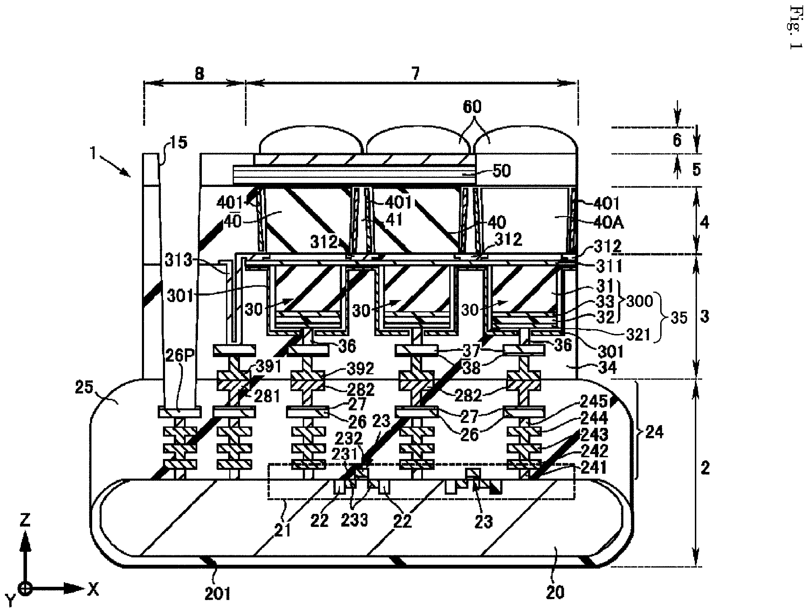

   Fig. 1 is a sectional view illustrating an example of a configuration of a light-emitting apparatus according to a first embodiment.
[Fig. 2]

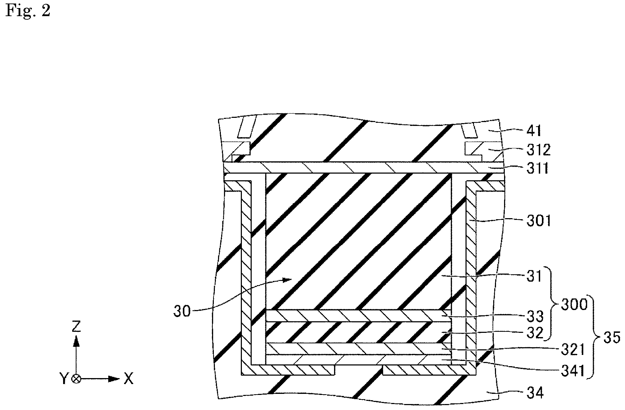

   Fig. 2 is an enlarged sectional view which enlarges a main part of the light-emitting apparatus illustrated in Fig. 1.
[Fig. 3]

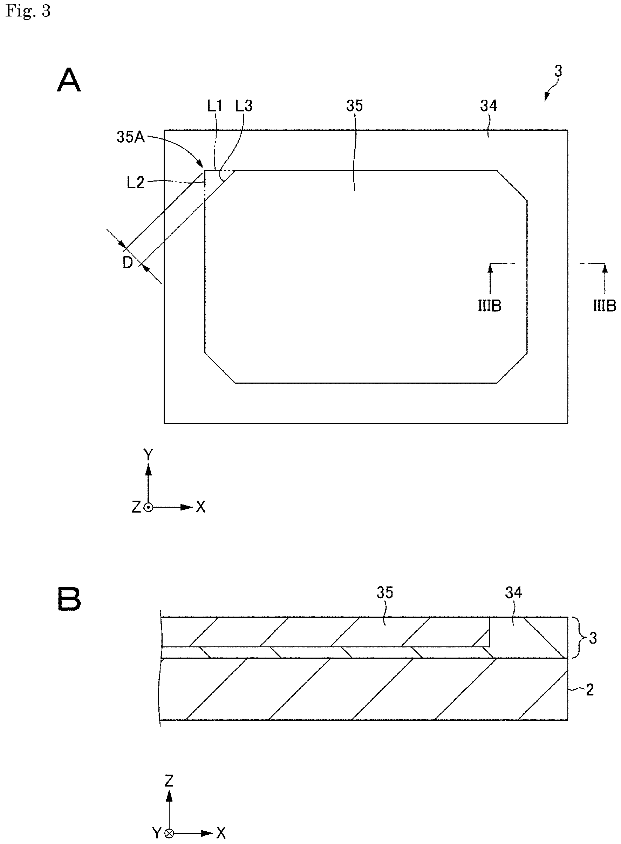

   Fig. 3A is a plan view illustrating an example of a configuration of a light-emitting element layer. Fig. 3B is a sectional view taken along line IIIB-IIIB in Fig. 3A.
[Fig. 4]

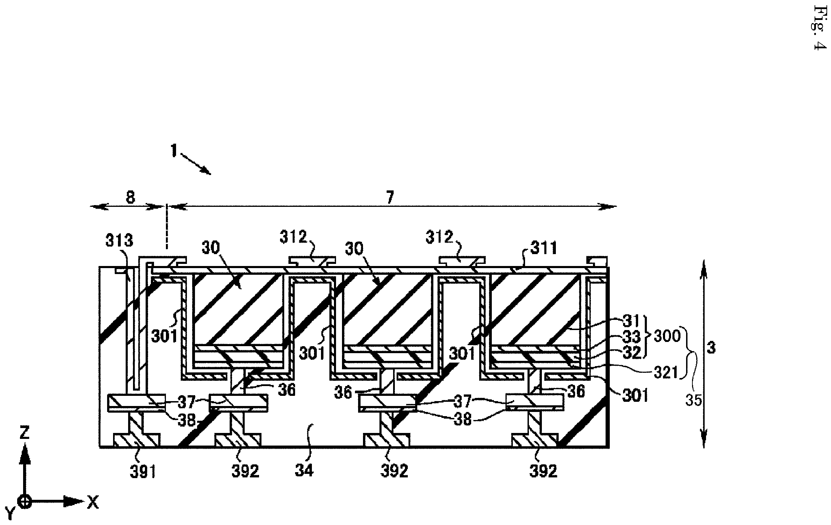

   Fig. 4 is an enlarged sectional view which enlarges a main part of the light-emitting apparatus illustrated in Fig. 1.
[Fig. 5]

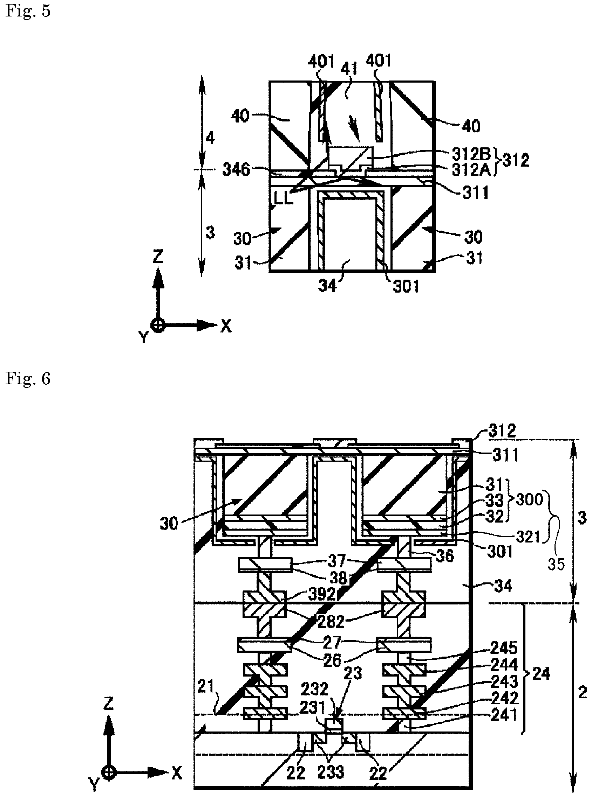

   Fig. 5 is a main-part enlarged sectional view which further enlarges a space between light-emitting elements of the light-emitting apparatus illustrated in Fig. 4.
[Fig. 6]
   Fig. 6 is an enlarged sectional view which enlarges a main part of the light-emitting apparatus illustrated in Fig. 1.
[Fig. 7]

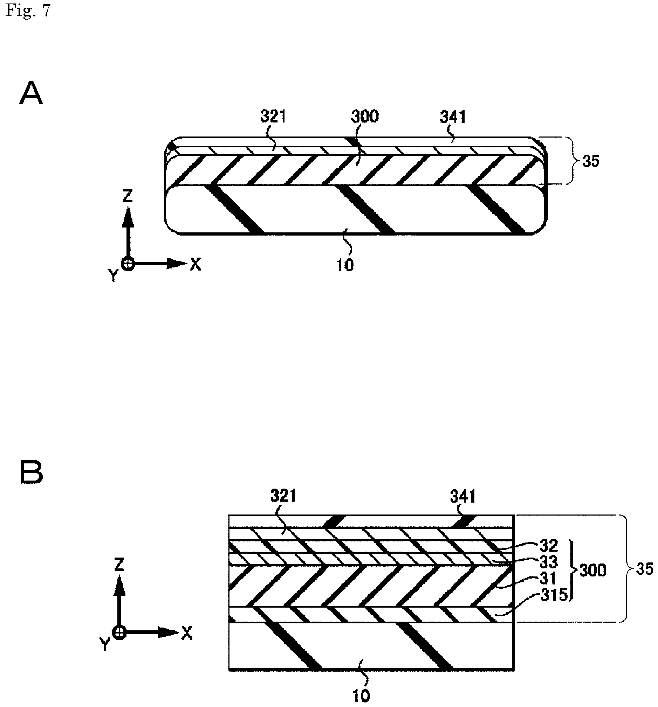

   Fig. 7A is a process chart for describing an example of a method of manufacturing the light-emitting apparatus. Fig. 7B is a sectional view which enlarges a main part of the process chart illustrated in Fig. 7A.
[Fig. 8]

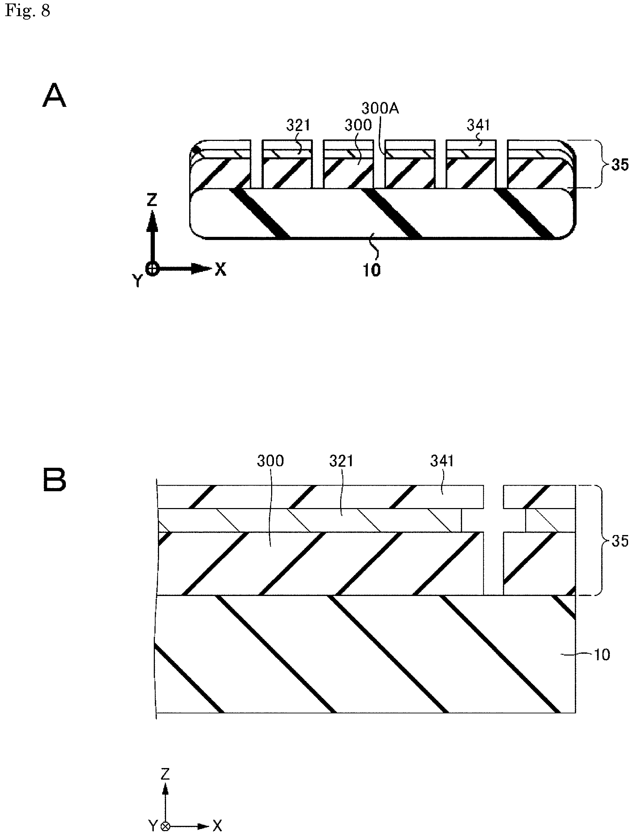

   Fig. 8A is a process chart for describing an example of the method of manufacturing the light-emitting apparatus. Fig. 8B is a sectional view for describing an example of the method of manufacturing the light-emitting apparatus.
[Fig. 9]

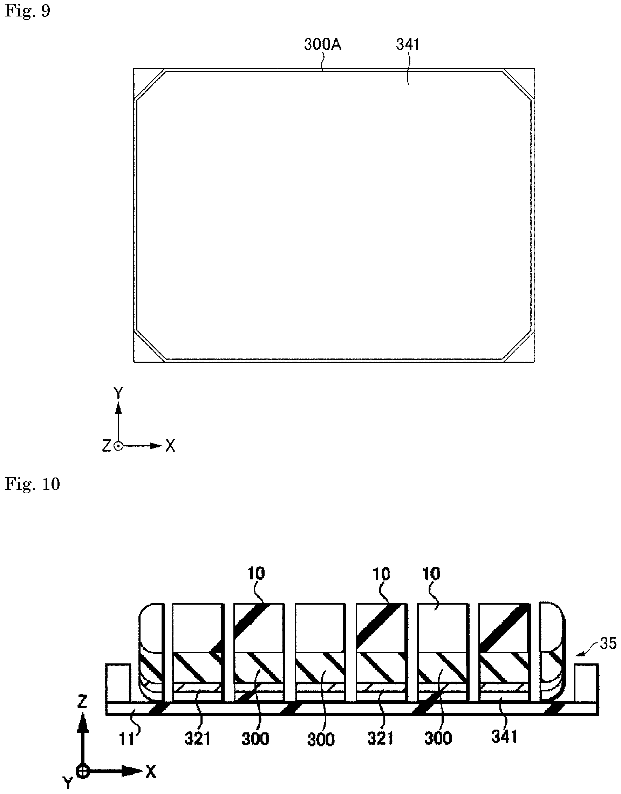

   Fig. 9 is a plan view for describing an example of the method of manufacturing the light-emitting apparatus.
[Fig. 10]
   Fig. 10 is a process chart for describing an example of the method of manufacturing the light-emitting apparatus.
[Fig. 11]

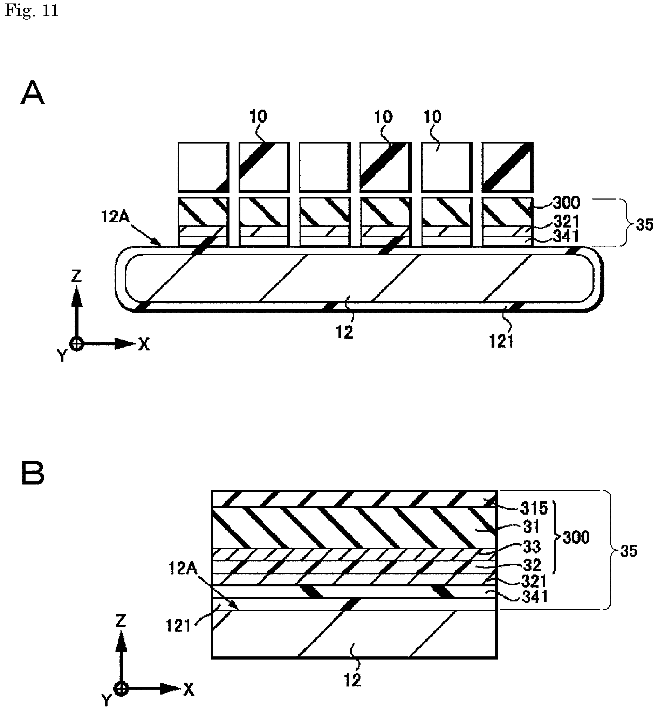

   Fig. 11A is a process chart for describing an example of the method of manufacturing the light-emitting apparatus. Fig. 11B is a sectional view which enlarges a main part of the process chart illustrated in Fig. 11A.
[Fig. 12]

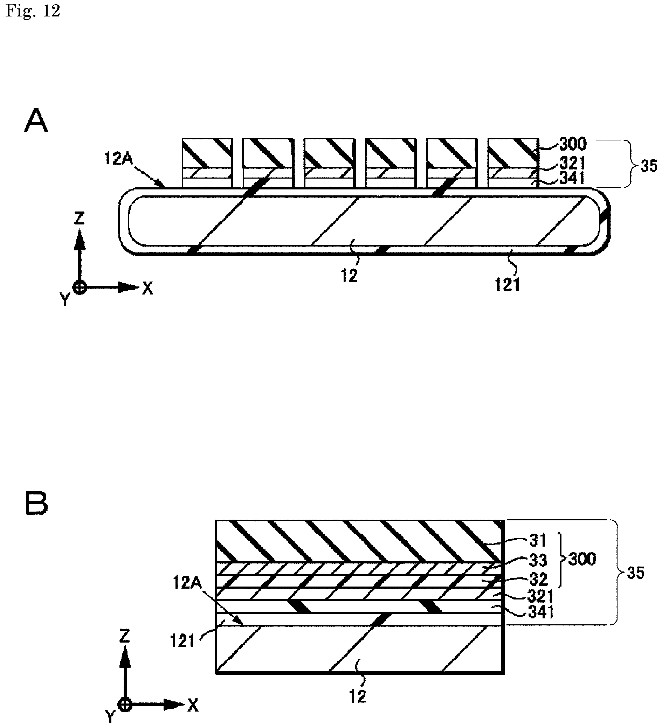

   Fig. 12A is a process chart for describing an example of the method of manufacturing the light-emitting apparatus. Fig. 12B is a sectional view which enlarges a main part of the process chart illustrated in Fig. 12A.
[Fig. 13]

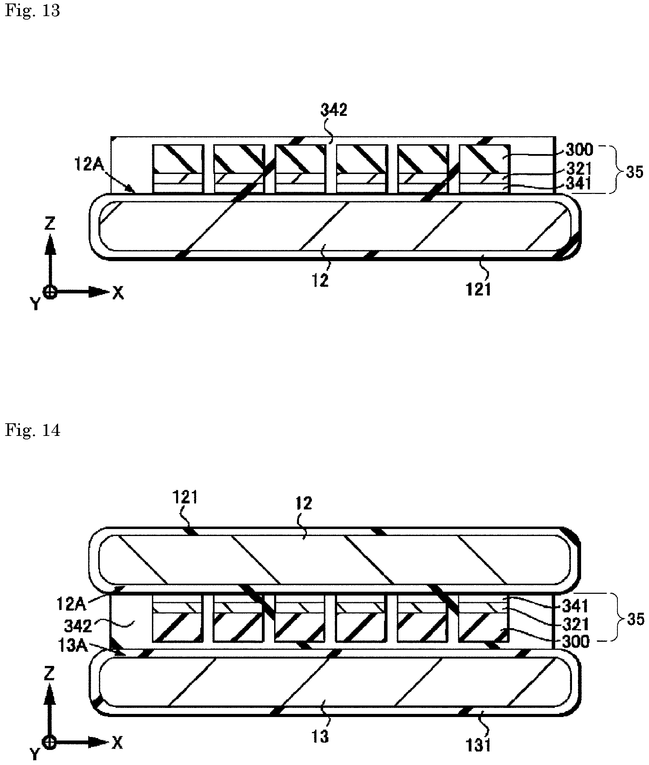

   Fig. 13 is a process chart for describing an example of the method of manufacturing the light-emitting apparatus.
[Fig. 14]
   Fig. 14 is a process chart for describing an example of the method of manufacturing the light-emitting apparatus.
[Fig. 15]

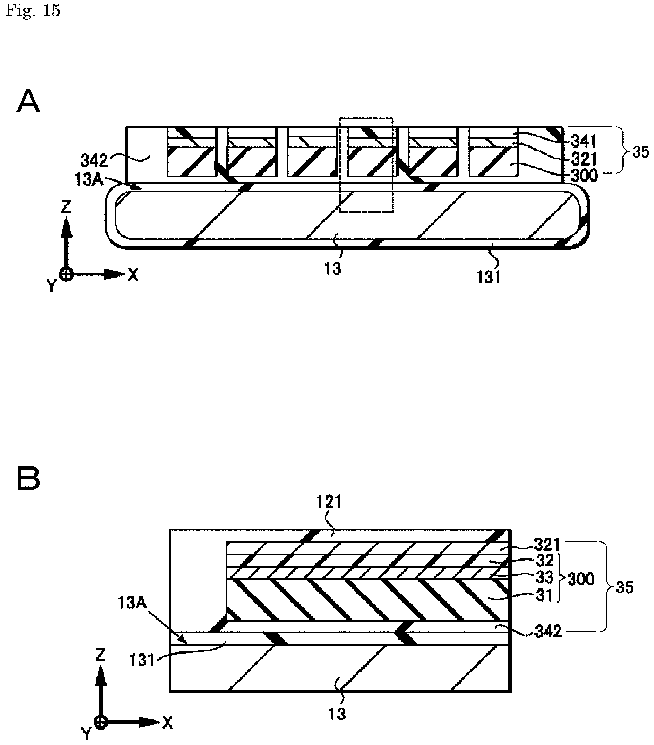

   Fig. 15A is a process chart for describing an example of the method of manufacturing the light-emitting apparatus. Fig. 15B is a sectional view which enlarges a main part of the process chart illustrated in Fig. 15A.
[Fig. 16]

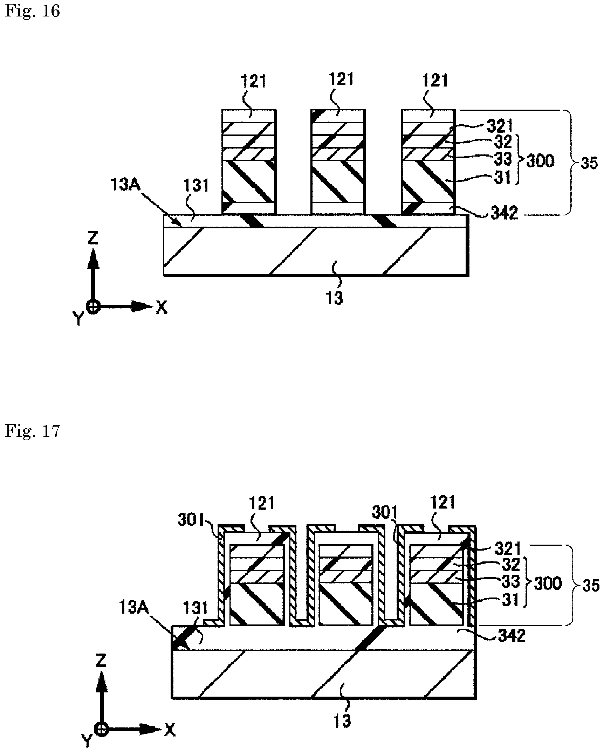

   Fig. 16 is a process chart for describing an example of the method of manufacturing the light-emitting apparatus.
[Fig. 17]
   Fig. 17 is a process chart for describing an example of the method of manufacturing the light-emitting apparatus.
[Fig. 18]

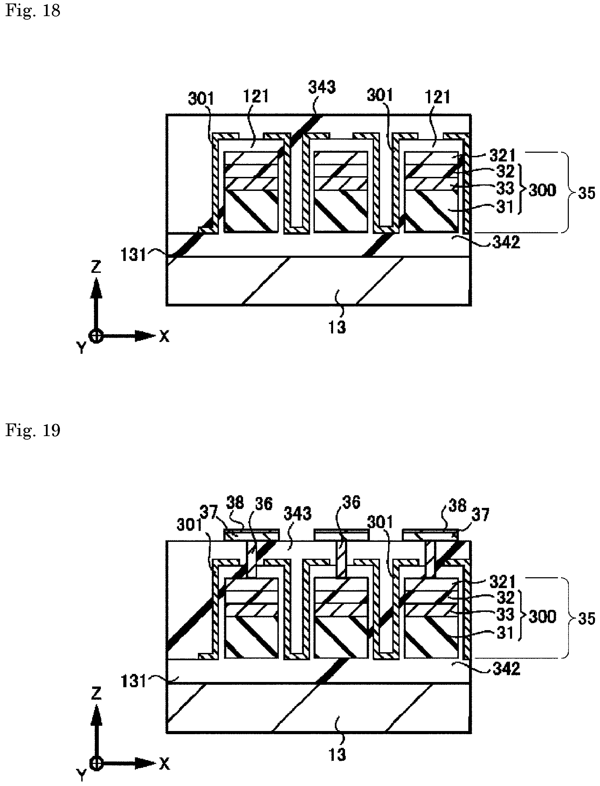

   Fig. 18 is a process chart for describing an example of the method of manufacturing the light-emitting apparatus.
[Fig. 19]
   Fig. 19 is a process chart for describing an example of the method of manufacturing the light-emitting apparatus.
[Fig. 20]

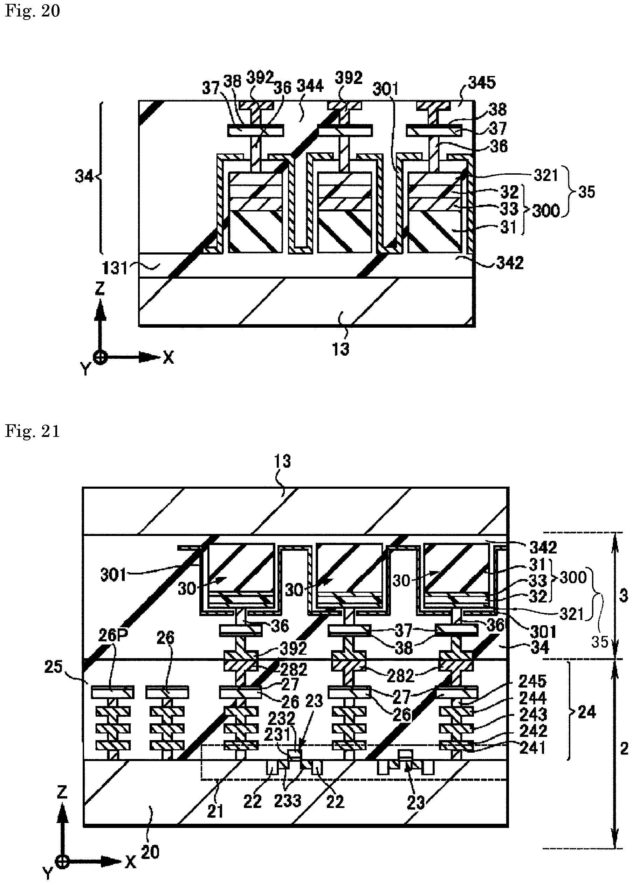

   Fig. 20 is a process chart for describing an example of the method of manufacturing the light-emitting apparatus.
[Fig. 21]
   Fig. 21 is a process chart for describing an example of the method of manufacturing the light-emitting apparatus.
[Fig. 22]

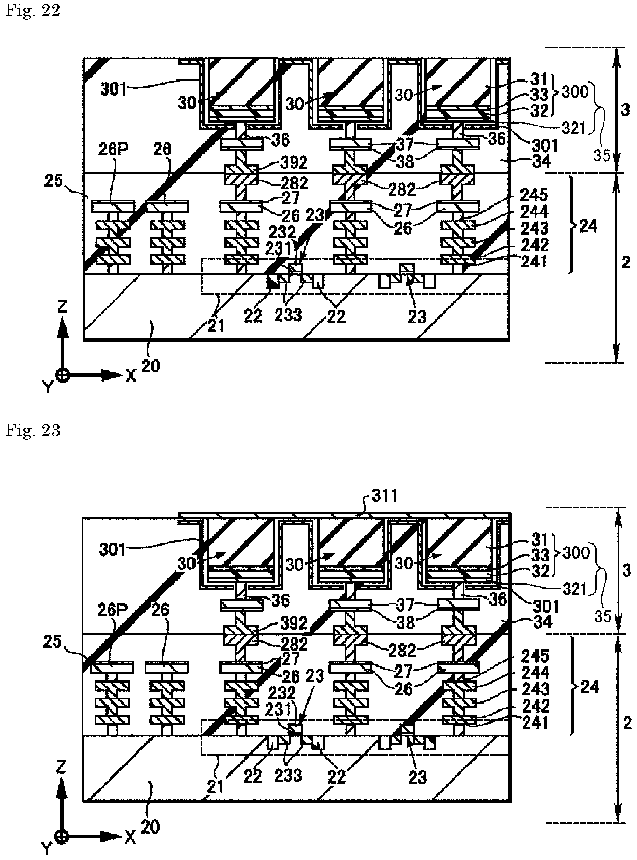

   Fig. 22 is a process chart for describing an example of the method of manufacturing the light-emitting apparatus.
[Fig. 23]
   Fig. 23 is a process chart for describing an example of the method of manufacturing the light-emitting apparatus.
[Fig. 24]

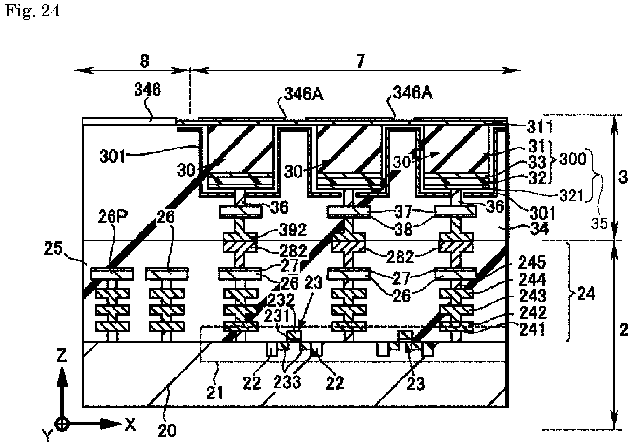

   Fig. 24 is a process chart for describing an example of the method of manufacturing the light-emitting apparatus.
[Fig. 25]

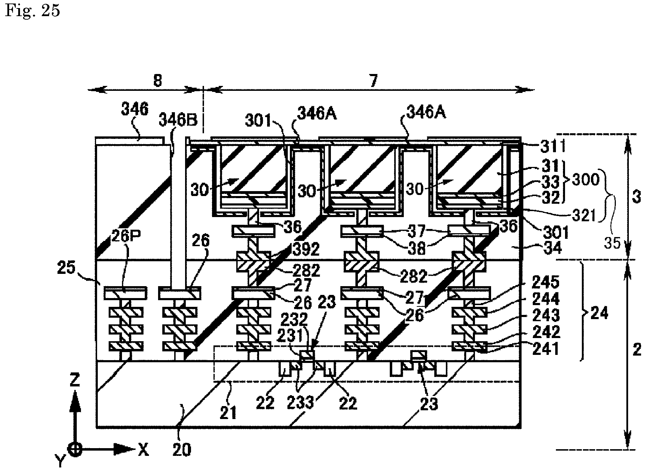

   Fig. 25 is a process chart for describing an example of the method of manufacturing the light-emitting apparatus.
[Fig. 26]

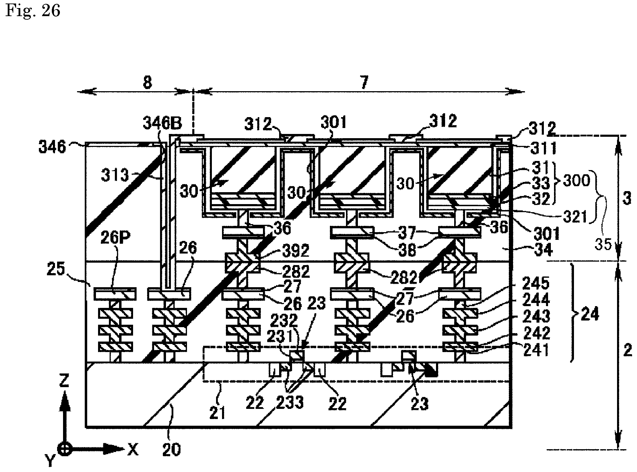

   Fig. 26 is a process chart for describing an example of the method of manufacturing the light-emitting apparatus.
[Fig. 27]

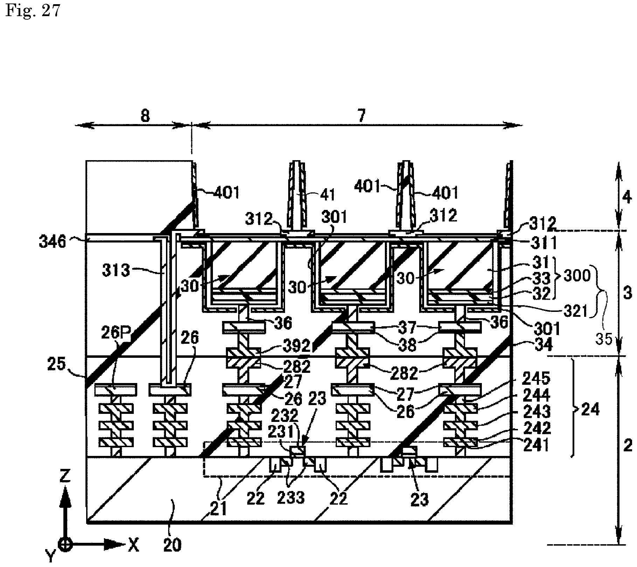

   Fig. 27 is a process chart for describing an example of the method of manufacturing the light-emitting apparatus.
[Fig. 28]

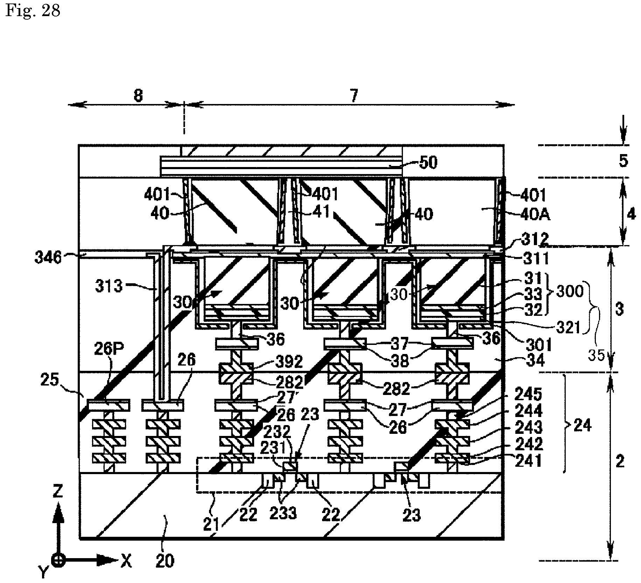

   Fig. 28 is a process chart for describing an example of the method of manufacturing the light-emitting apparatus.
[Fig. 29]

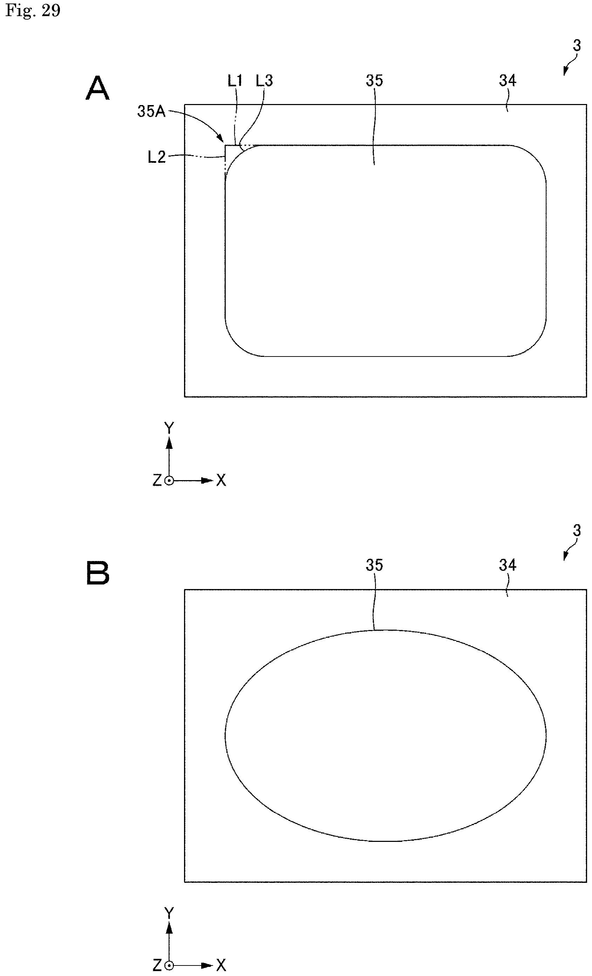

   Figs. 29A and 29B are plan views each illustrating a modification of the light-emitting element layer.
[Fig. 30]

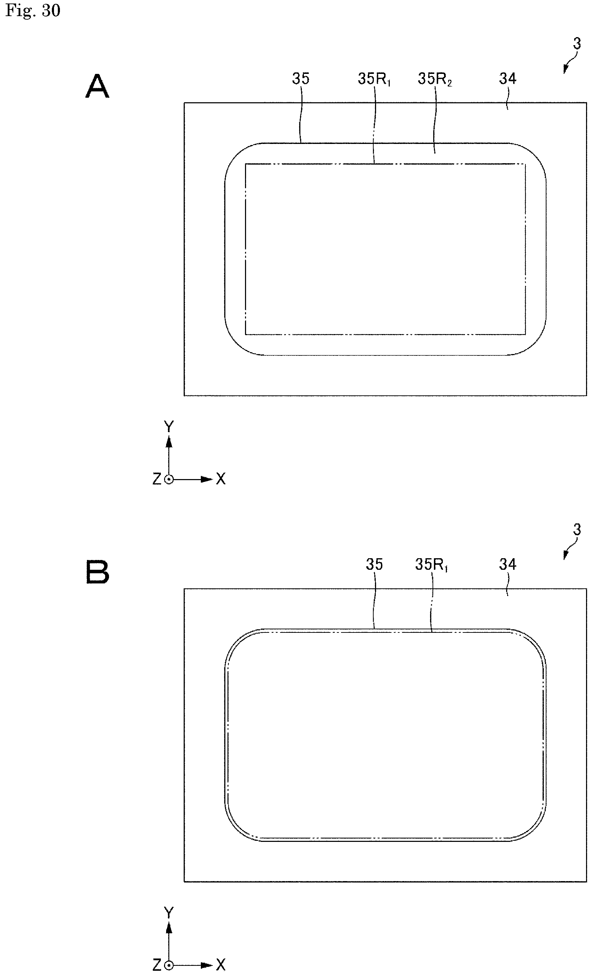

   Figs. 30A and 30B are plan views each illustrating a modification of the light-emitting element layer.
[Fig. 31]

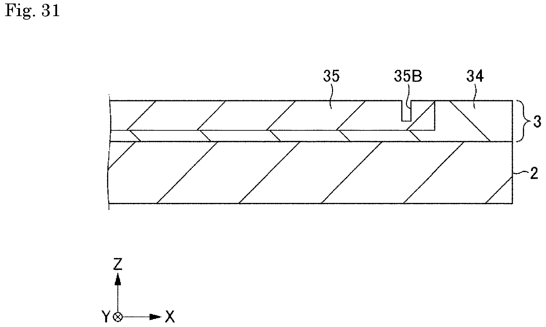

   Fig. 31 is a sectional view illustrating a modification of the configuration of the light-emitting element layer.
[Fig. 32]

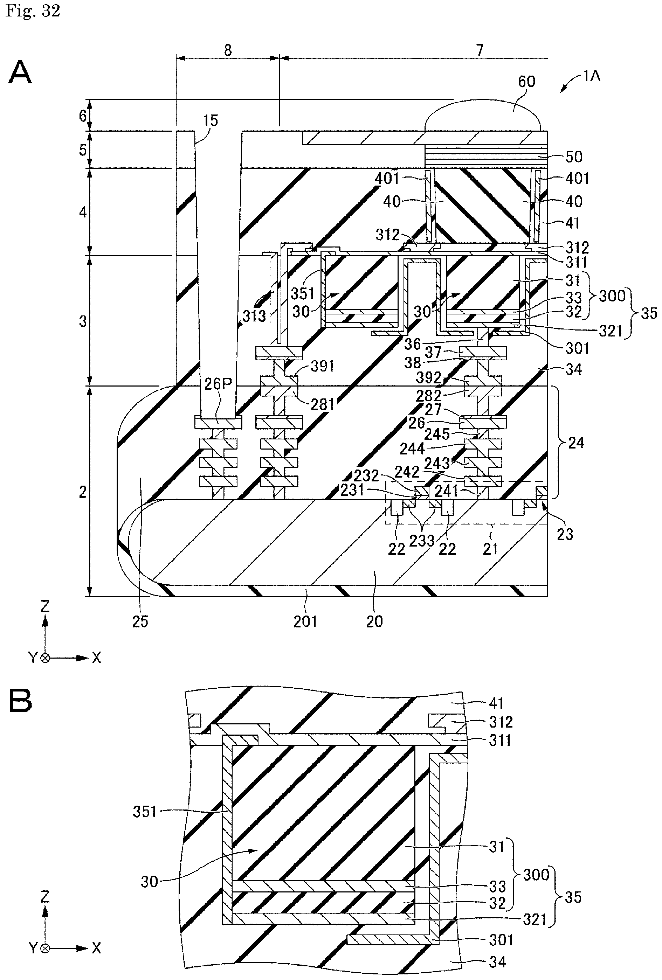

   Fig. 32A is a sectional view illustrating an example of a configuration of a light-emitting apparatus according to a second embodiment. Fig. 32B is an enlarged sectional view which enlarges a main part of the light-emitting apparatus illustrated in Fig. 32A.
[Fig. 33]

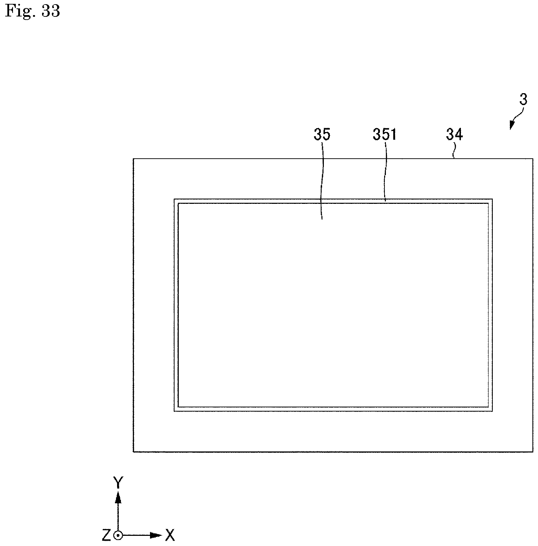

   Fig. 33 is a plan view illustrating an example of a configuration of a light-emitting element layer.
[Fig. 34]

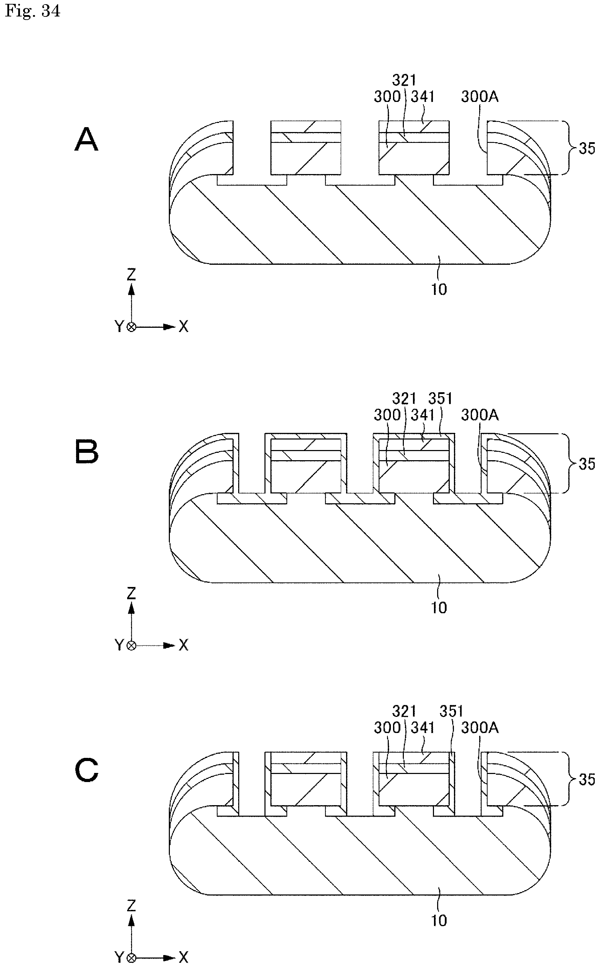

   Figs. 34A, 34B, and 34C are process charts for describing examples of a method of manufacturing the light-emitting apparatus.
[Fig. 35]

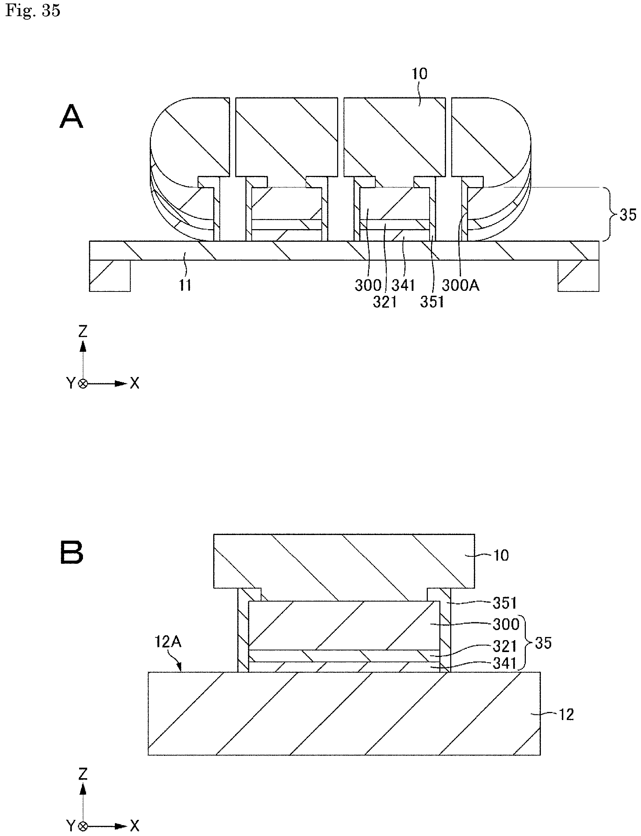

   Figs. 35A and 35B are process charts for describing examples of the method of manufacturing the light-emitting apparatus.
[Fig. 36]

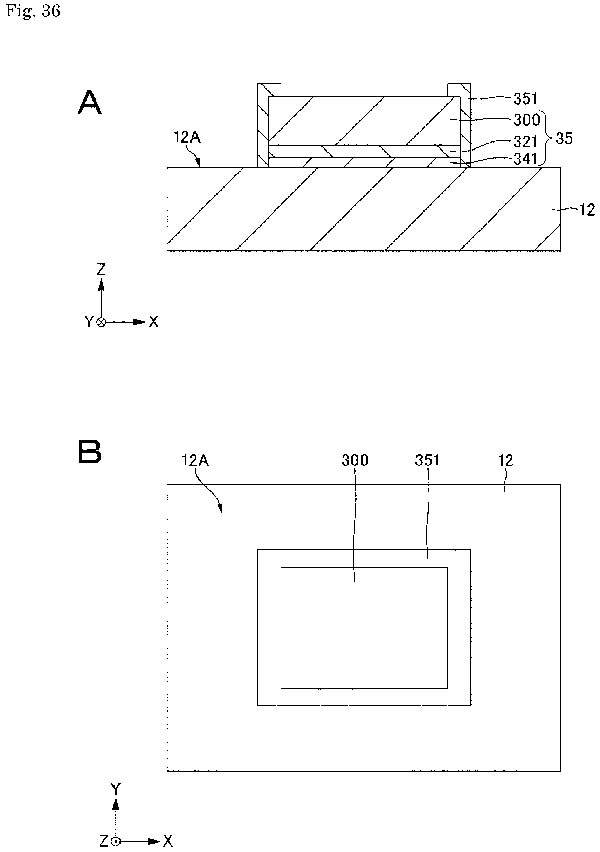

   Fig. 36A is a process chart for describing an example of the method of manufacturing the light-emitting apparatus. Fig. 36B is a plan view for describing an example of the method of manufacturing the light-emitting apparatus.
[Fig. 37]

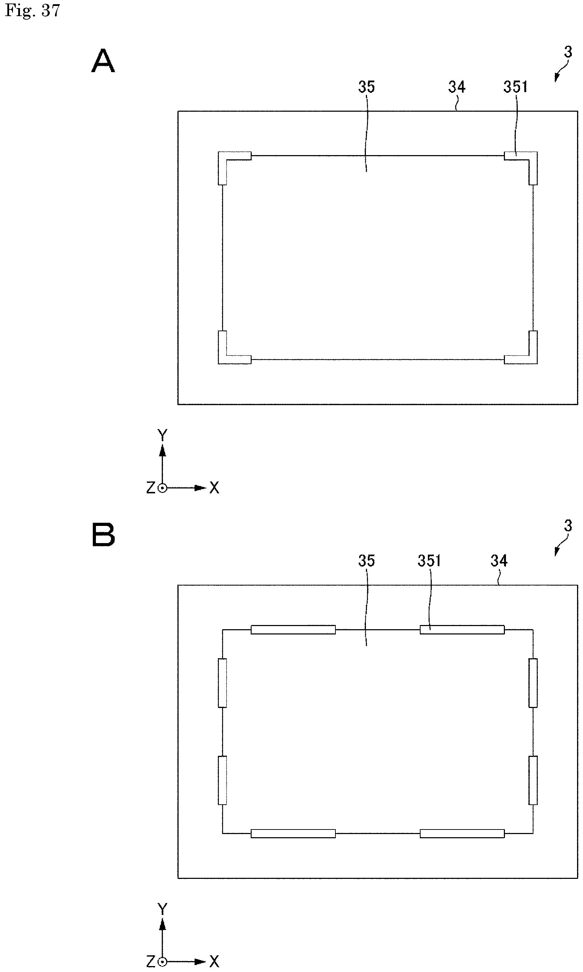

   Figs. 37A and 37B are plan views each illustrating a modification of the light-emitting element layer.
[Fig. 38]

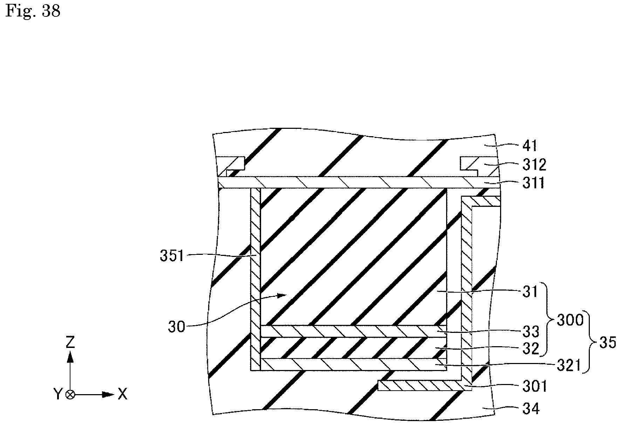

   Fig. 38 is a sectional view illustrating a modification of a protective layer.
[Fig. 39]

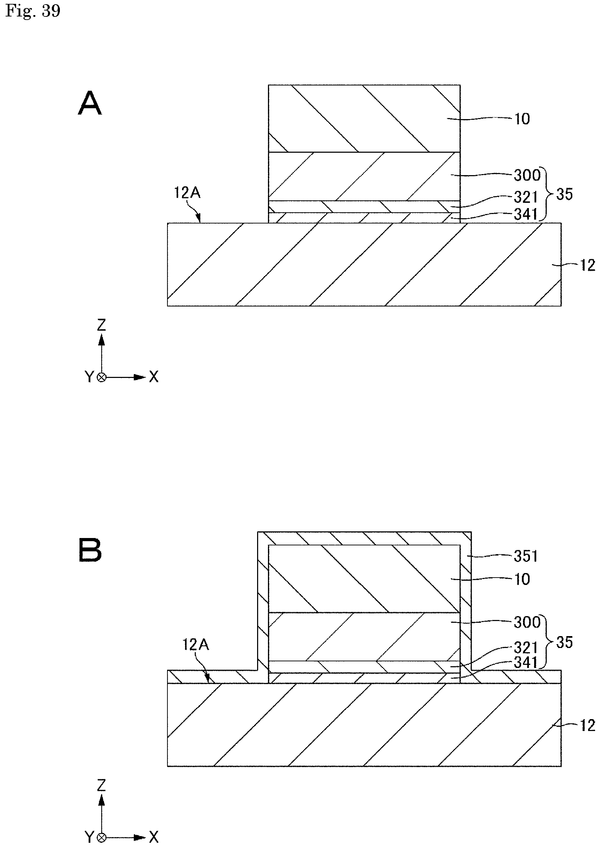

   Figs. 39A and 39B are process charts illustrating examples of a method of forming the protective layer illustrated in Fig. 38.
[Fig. 40]

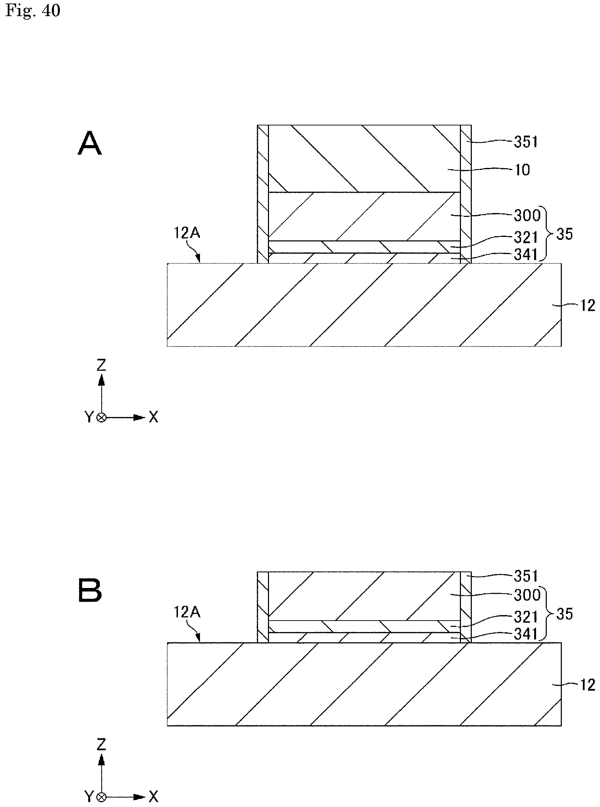

   Figs. 40A and 40B are process charts for describing examples of the method of manufacturing the light-emitting apparatus.
[Fig. 41]

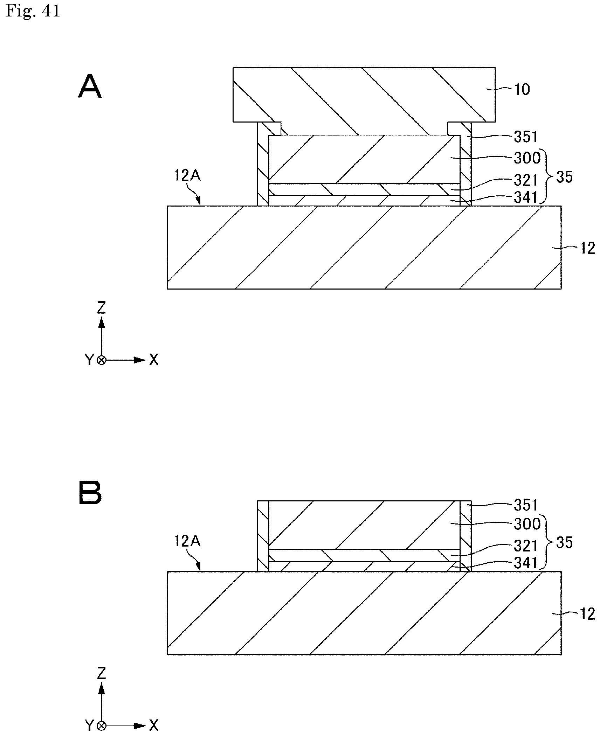

   Figs. 41A and 41B are process charts for describing examples of the method of manufacturing the light-emitting apparatus.
[Fig. 42]

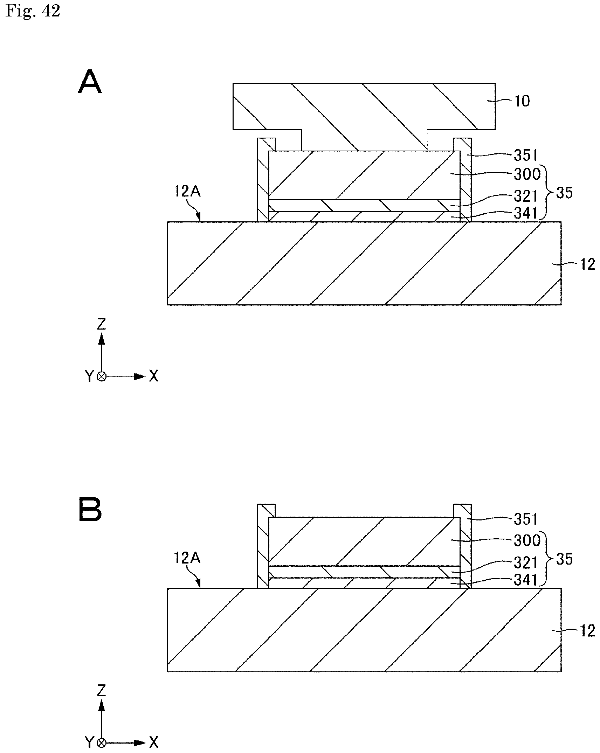

   Figs. 42A and 42B are process charts for describing examples of the method of manufacturing the light-emitting apparatus.
[Fig. 43]

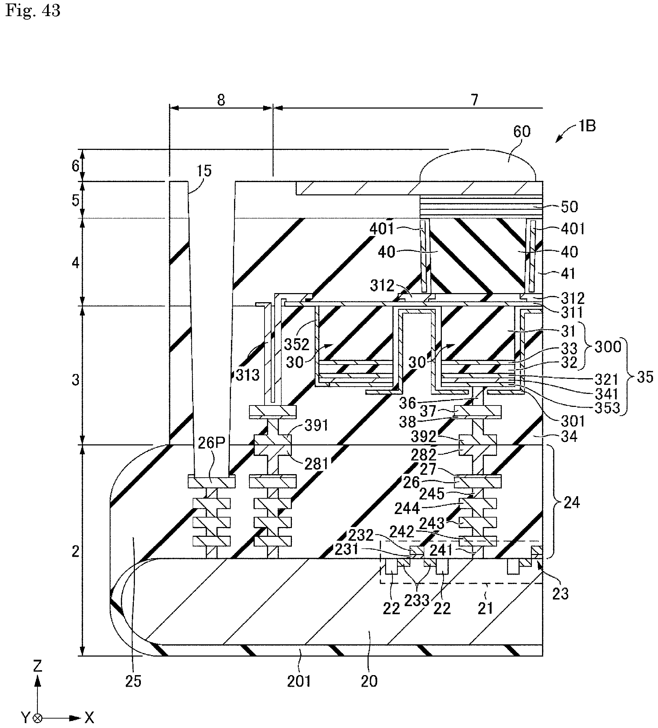

   Fig. 43 is a sectional view illustrating an example of a configuration of a light-emitting apparatus according to a third embodiment.
[Fig. 44]

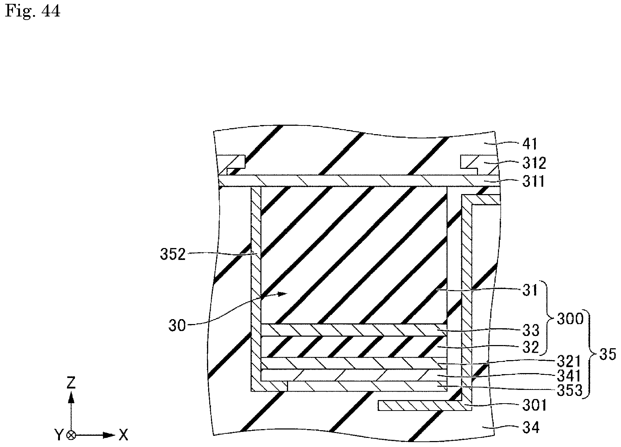

   Fig. 44 is an enlarged sectional view which enlarges a main part of the light-emitting apparatus illustrated in Fig. 43.
[Fig. 45]

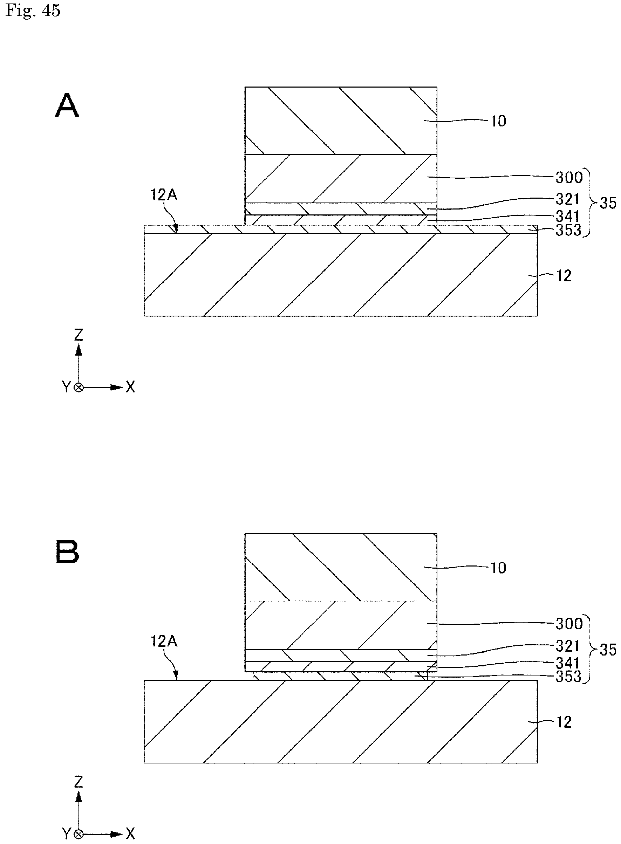

   Figs. 45A and 45B are process charts for describing examples of a method of manufacturing the light-emitting apparatus.
[Fig. 46]

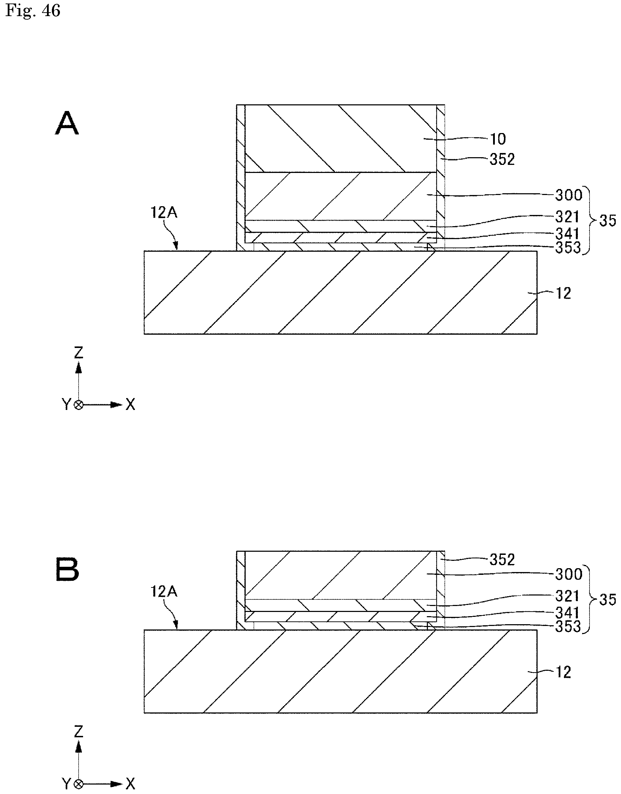

   Figs. 46A and 46B are process charts for describing examples of the method of manufacturing the light-emitting apparatus.
[Fig. 47]

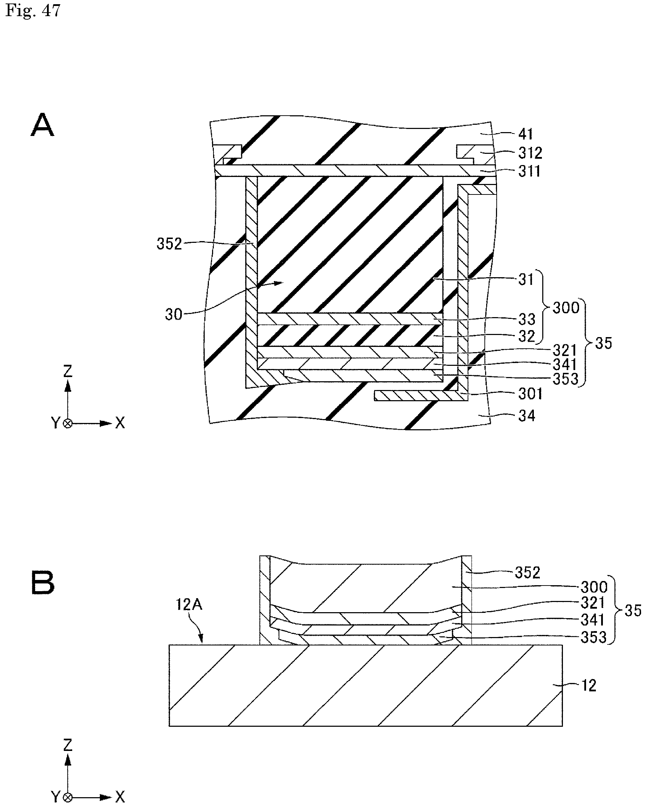

   Fig. 47A is an enlarged sectional view which enlarges a main part of the light-emitting apparatus. Fig. 47B is a process chart for describing an example of the method of manufacturing the light-emitting apparatus.
[Fig. 48]

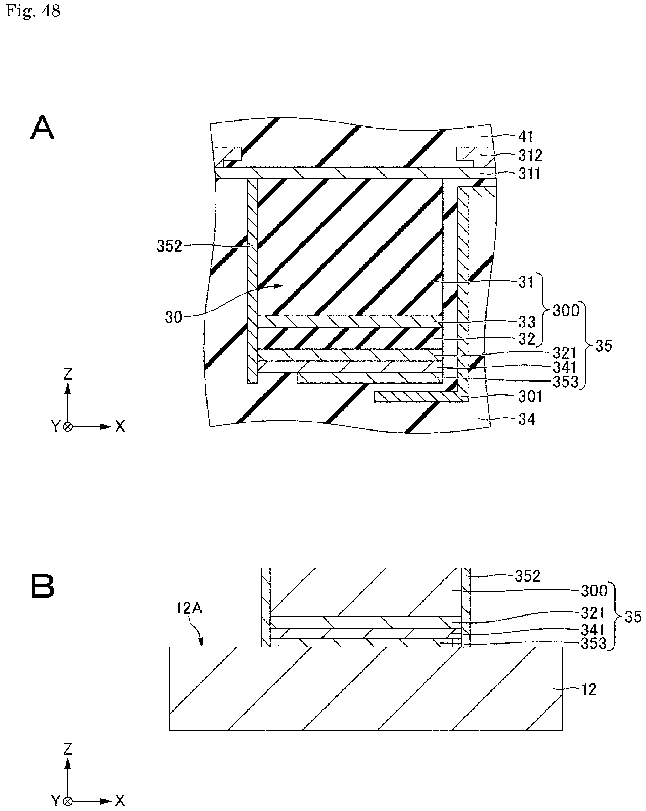

   Fig. 48A is an enlarged sectional view which enlarges a main part of the light-emitting apparatus. Fig. 48B is a process chart for describing an example of the method of manufacturing the light-emitting apparatus.
[Fig. 49]

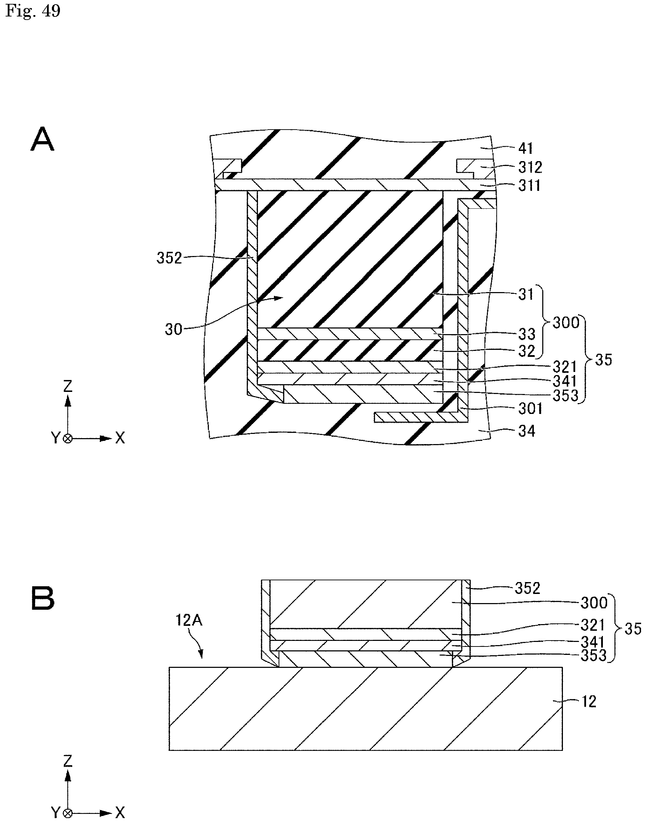

   Fig. 49A is an enlarged sectional view which enlarges a main part of the light-emitting apparatus. Fig. 49B is a process chart for describing an example of the method of manufacturing the light-emitting apparatus.
[Fig. 50]

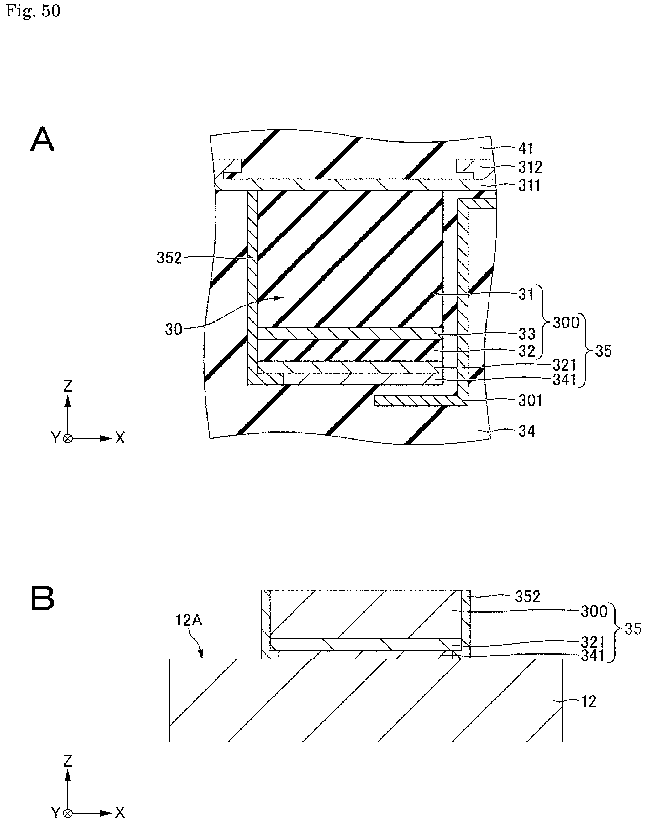

   Fig. 50A is an enlarged sectional view which enlarges a main part of the light-emitting apparatus. Fig. 50B is a process chart for describing an example of the method of manufacturing the light-emitting apparatus.
[Fig. 51]

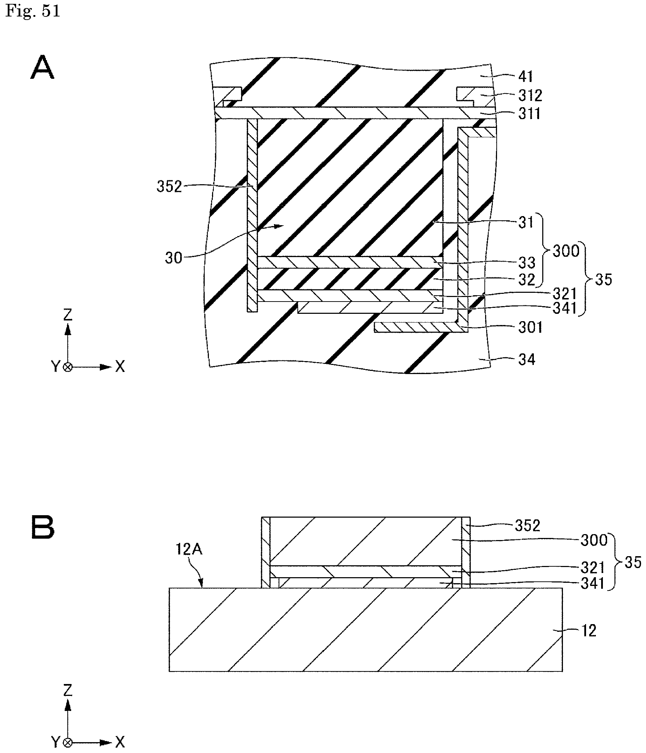

   Fig. 51A is an enlarged sectional view which enlarges a main part of the light-emitting apparatus. Fig. 51B is a process chart for describing an example of the method of manufacturing the light-emitting apparatus.
[Fig. 52]

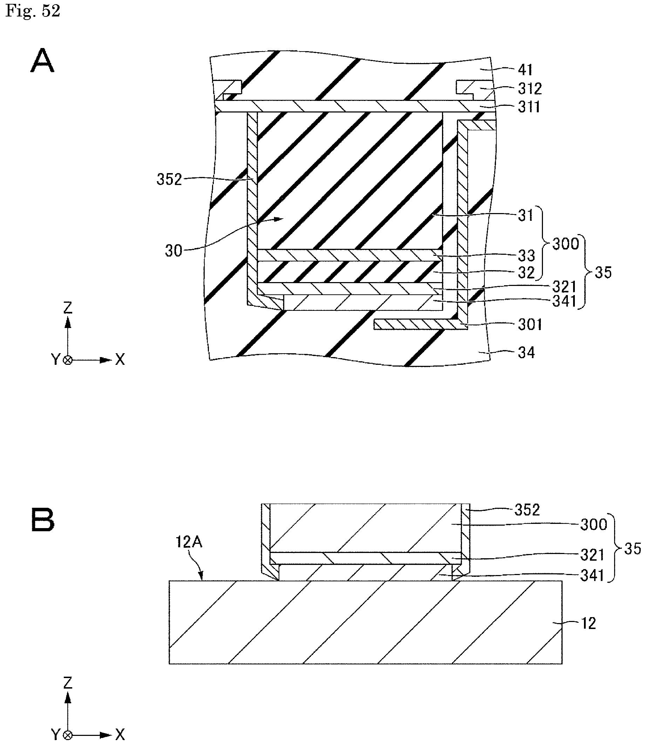

   Fig. 52A is an enlarged sectional view which enlarges a main part of the light-emitting apparatus. Fig. 52B is a process chart for describing an example of the method of manufacturing the light-emitting apparatus.
[Fig. 53]

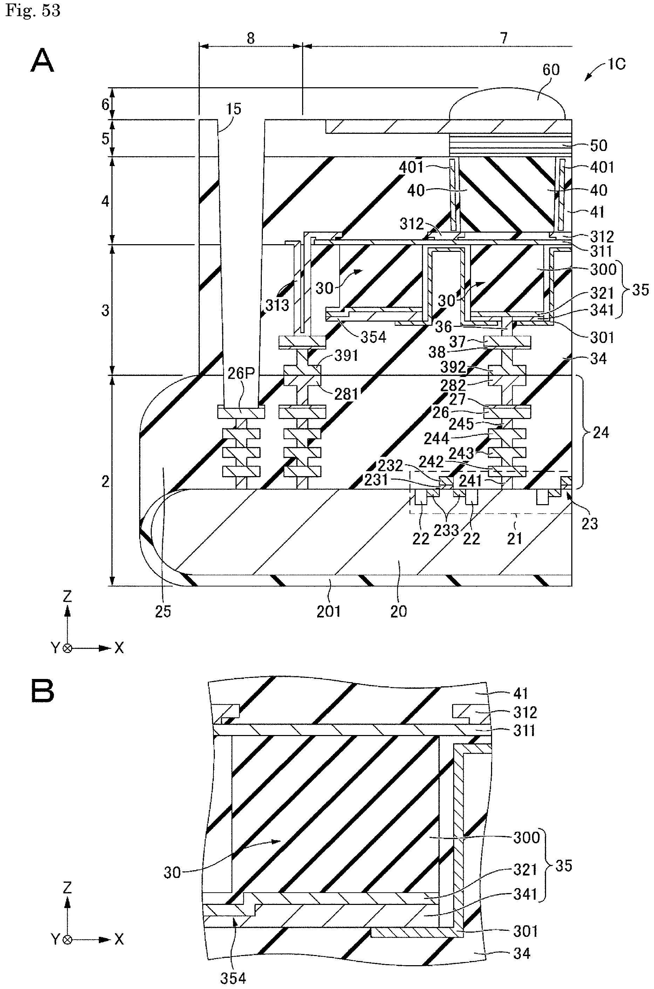

   Fig. 53A is a sectional view illustrating an example of a configuration of a light-emitting apparatus according to a fourth embodiment. Fig. 53B is an enlarged sectional view which enlarges a main part of the light-emitting apparatus illustrated in Fig. 53A.
[Fig. 54]

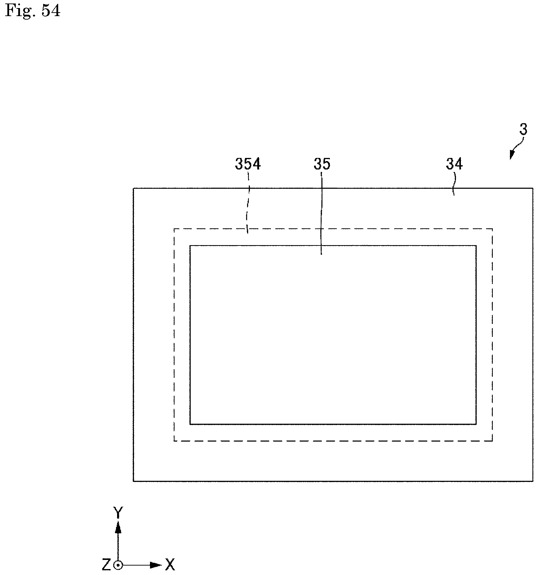

   Fig. 54 is a plan view illustrating an example of a configuration of a light-emitting element layer.
[Fig. 55]

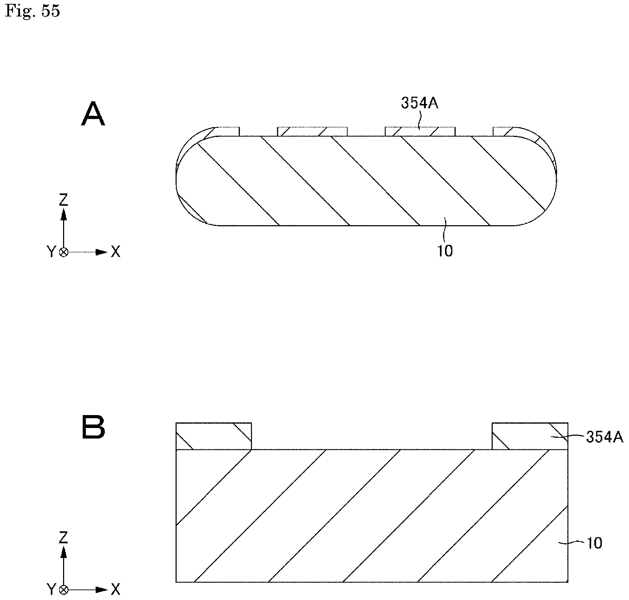

   Figs. 55A and 55B are process charts for describing examples of a method of manufacturing the light-emitting apparatus.
[Fig. 56]

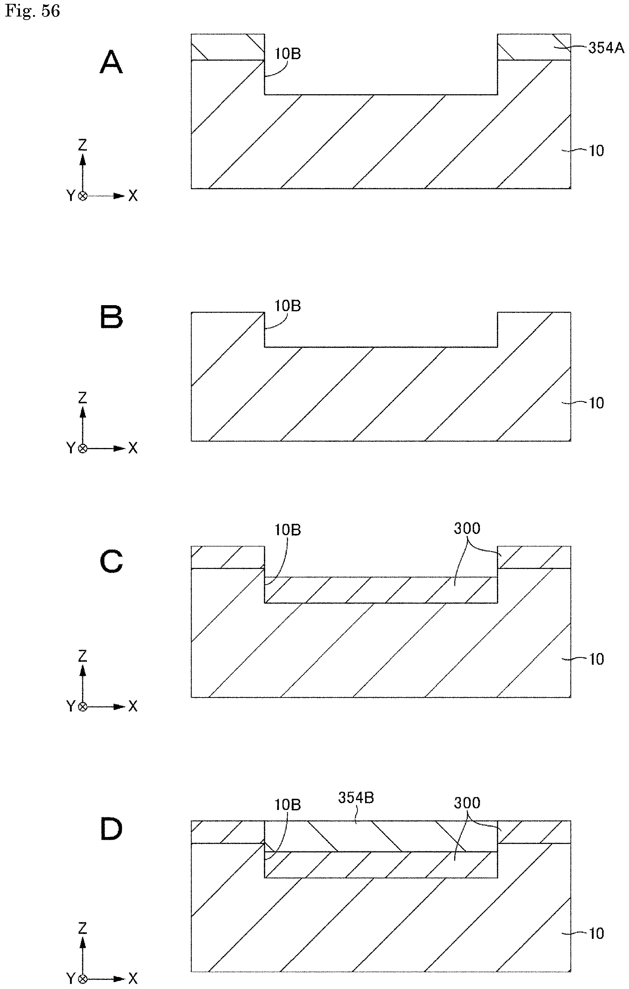

   Figs. 56A, 56B, 56C, and 56D are process charts for describing examples of the method of manufacturing the light-emitting apparatus.
[Fig. 57]

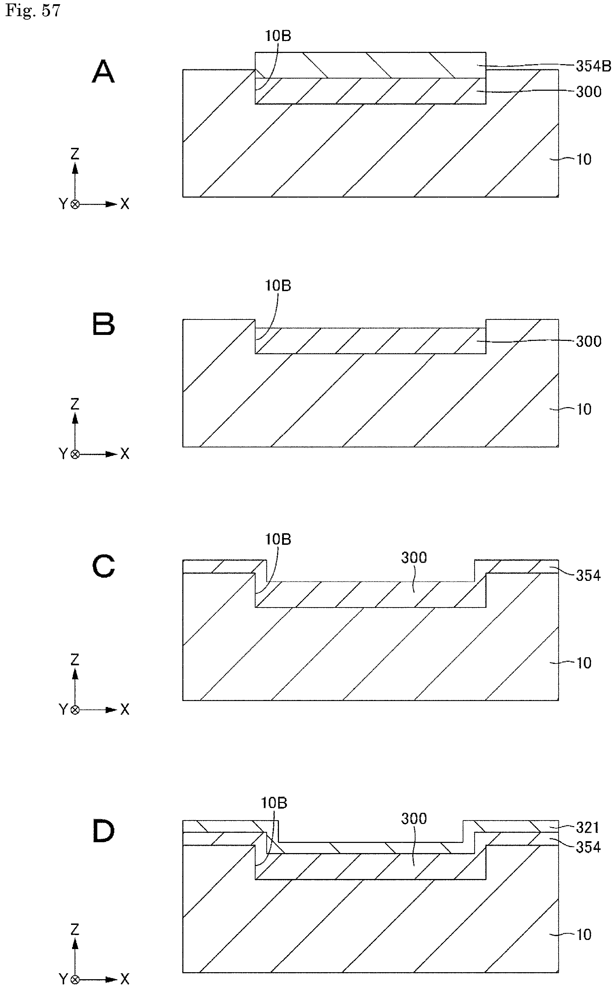

   Figs. 57A, 57B, 57C, and 57D are process charts for describing examples of the method of manufacturing the light-emitting apparatus.
[Fig. 58]

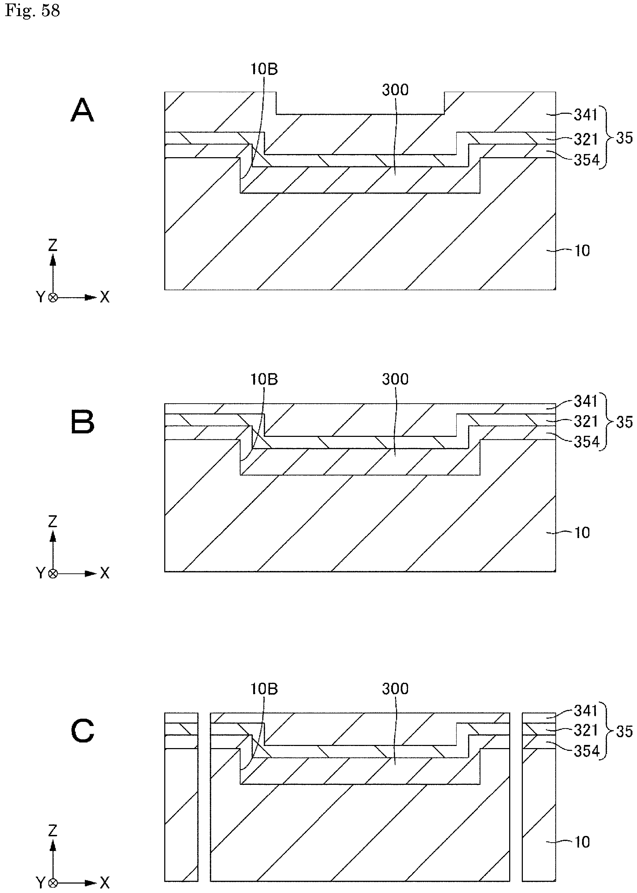

   Figs. 58A, 58B, and 58C are process charts for describing examples of the method of manufacturing the light-emitting apparatus.
[Fig. 59]

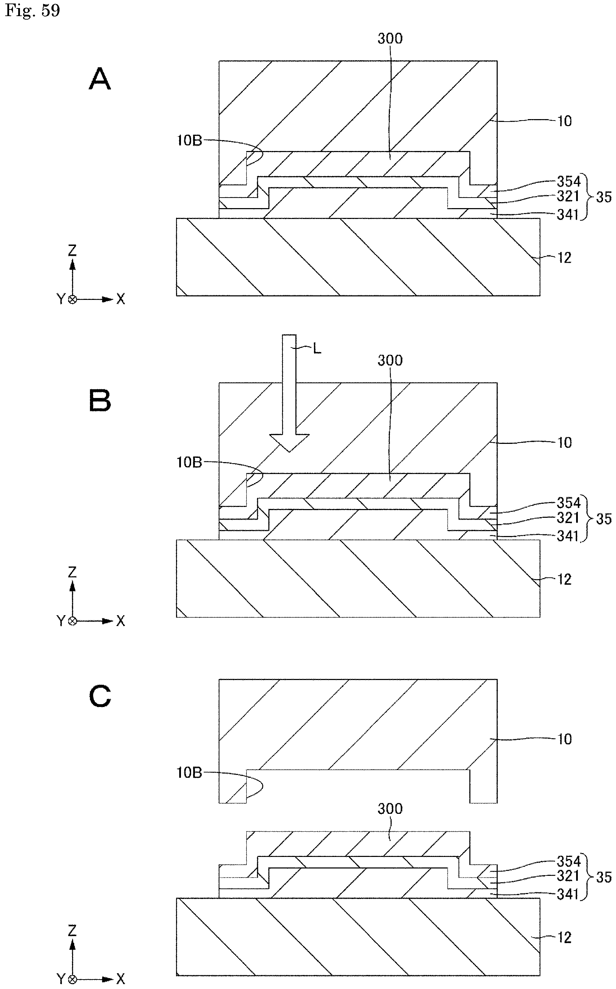

   Figs. 59A, 59B, and 59C are process charts for describing examples of the method of manufacturing the light-emitting apparatus.
[Fig. 60]

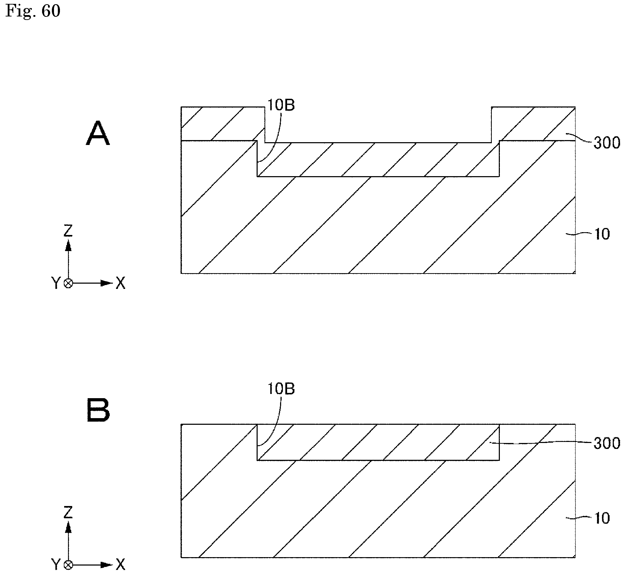

   Figs. 60A and 60B are process charts for describing examples of the method of manufacturing the light-emitting apparatus.
[Fig. 61]

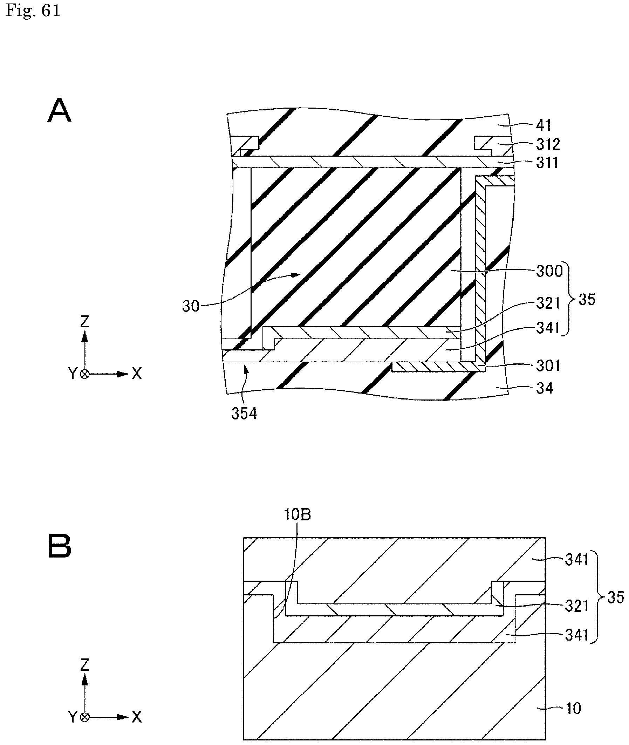

   Fig. 61A is an enlarged sectional view which enlarges a main part of the light-emitting apparatus. Fig. 61B is a process chart for describing an example of the method of manufacturing the light-emitting apparatus.
[Fig. 62]

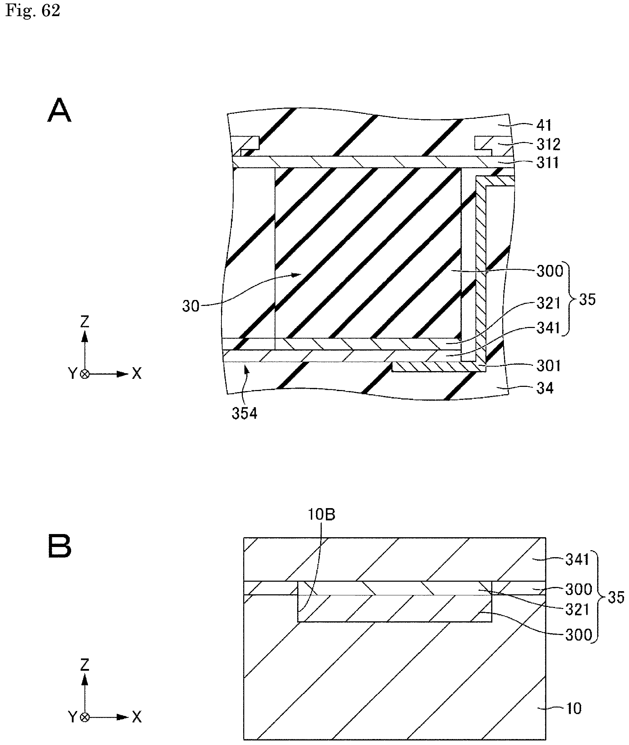

   Fig. 62A is an enlarged sectional view which enlarges a main part of the light-emitting apparatus. Fig. 62B is a process chart for describing an example of the method of manufacturing the light-emitting apparatus.
[Fig. 63]

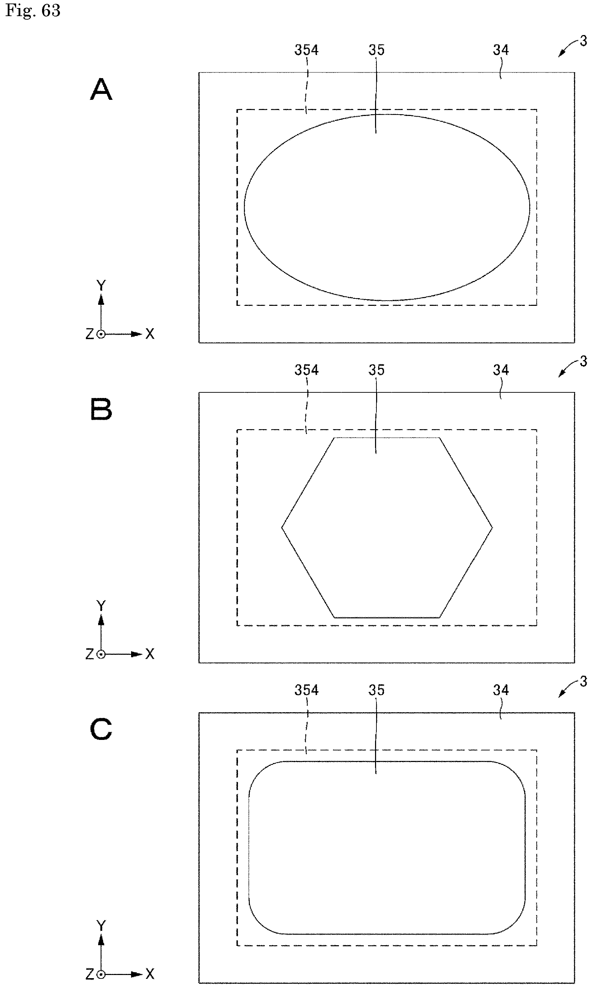

   Figs. 63A, 63B, and 63C are plan views each illustrating a modification of a light-emitting element layer.
[Fig. 64]

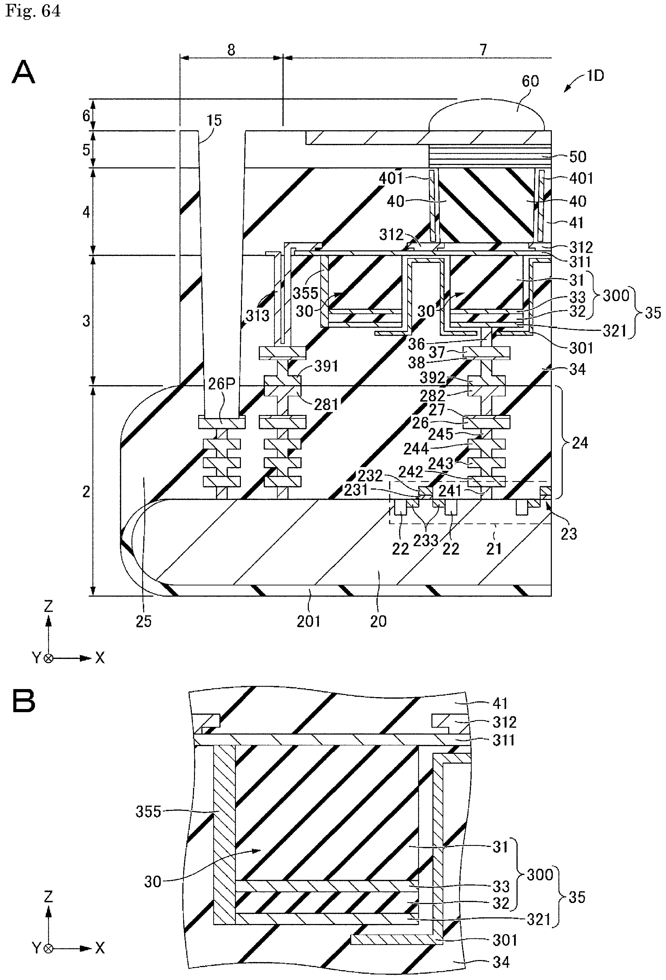

   Fig. 64A is a sectional view illustrating an example of a configuration of a light-emitting apparatus according to a fifth embodiment. Fig. 64B is an enlarged sectional view which enlarges a main part of the light-emitting apparatus illustrated in Fig. 64A.
[Fig. 65]

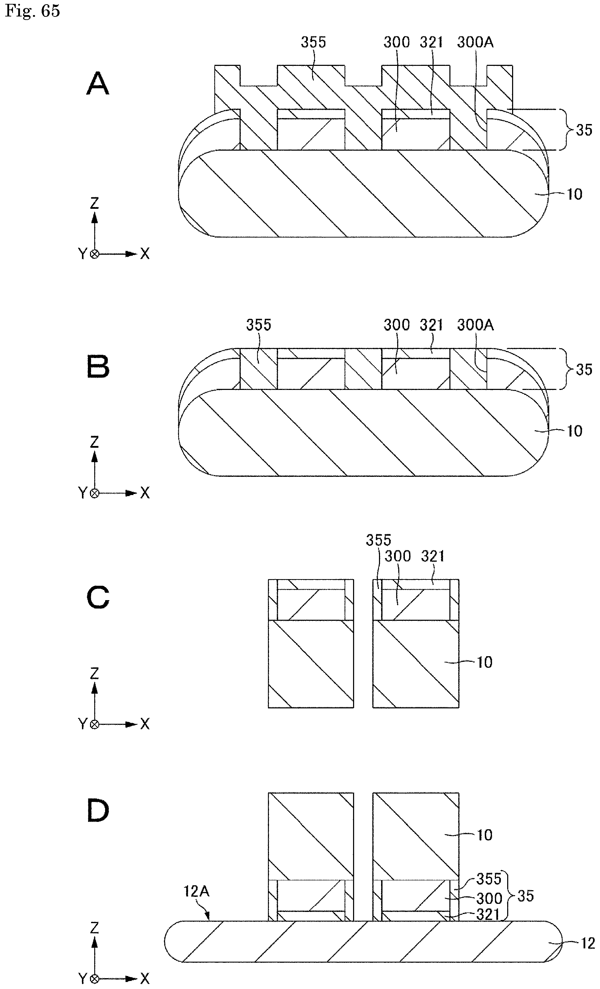

   Figs. 65A, 65B, 65C, and 65D are process charts for describing examples of a method of manufacturing the light-emitting apparatus.
[Fig. 66]

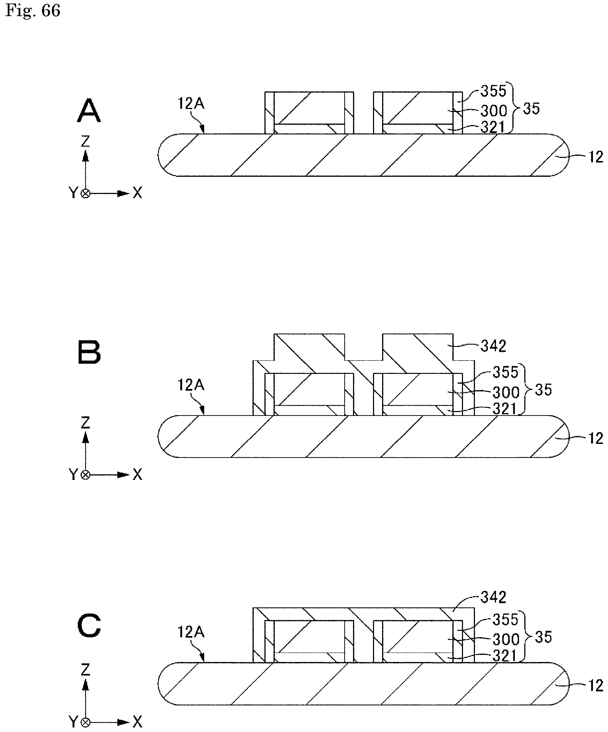

   Figs. 66A, 66B, and 66C are process charts for describing examples of the method of manufacturing the light-emitting apparatus.
[Fig. 67]

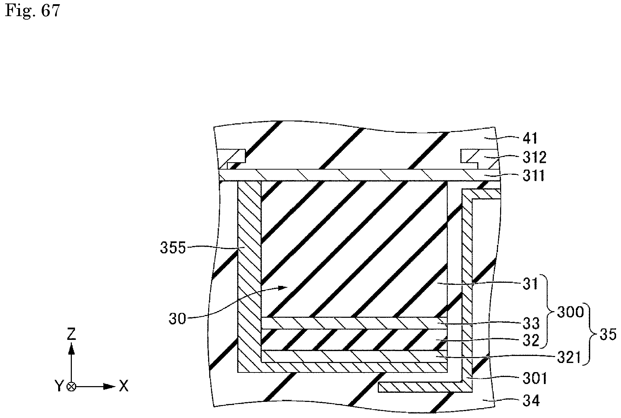

   Fig. 67 is an enlarged sectional view which enlarges a main part of the light-emitting apparatus.
[Fig. 68]

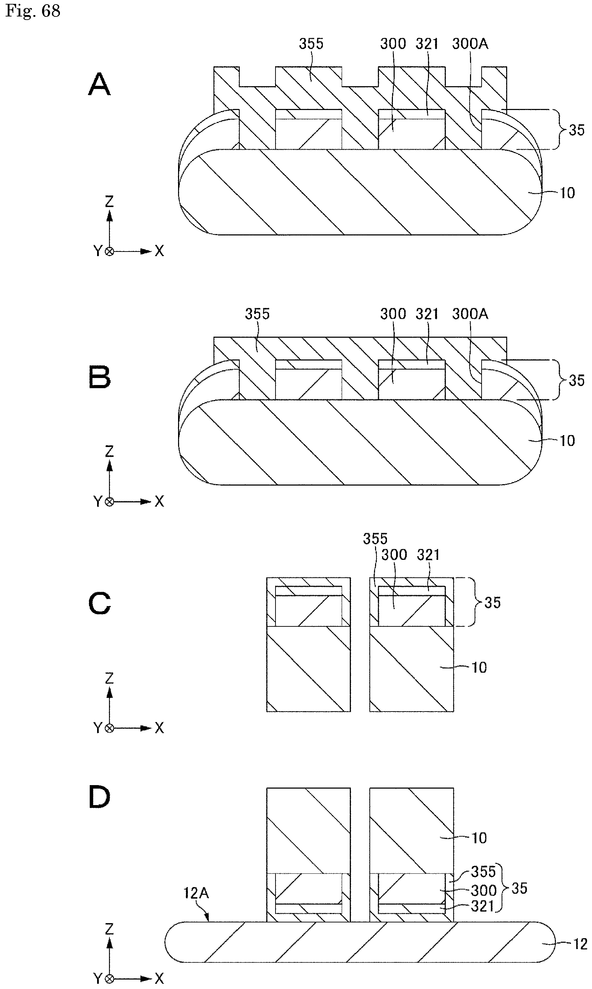

   Figs. 68A, 68B, 68C, and 68D are process charts for describing examples of the method of manufacturing the light-emitting apparatus.
[Fig. 69]

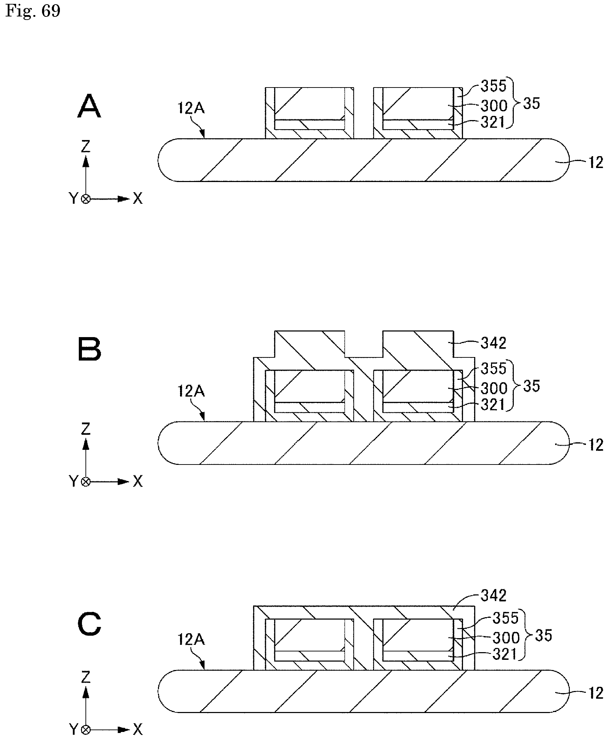

   Figs. 69A, 69B, and 69C are process charts for describing examples of the method of manufacturing the light-emitting apparatus.
[Fig. 70]

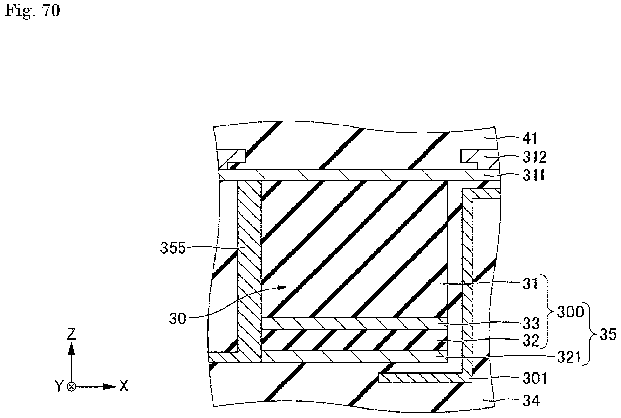

   Fig. 70 is an enlarged sectional view which enlarges a main part of the light-emitting apparatus.
[Fig. 71]

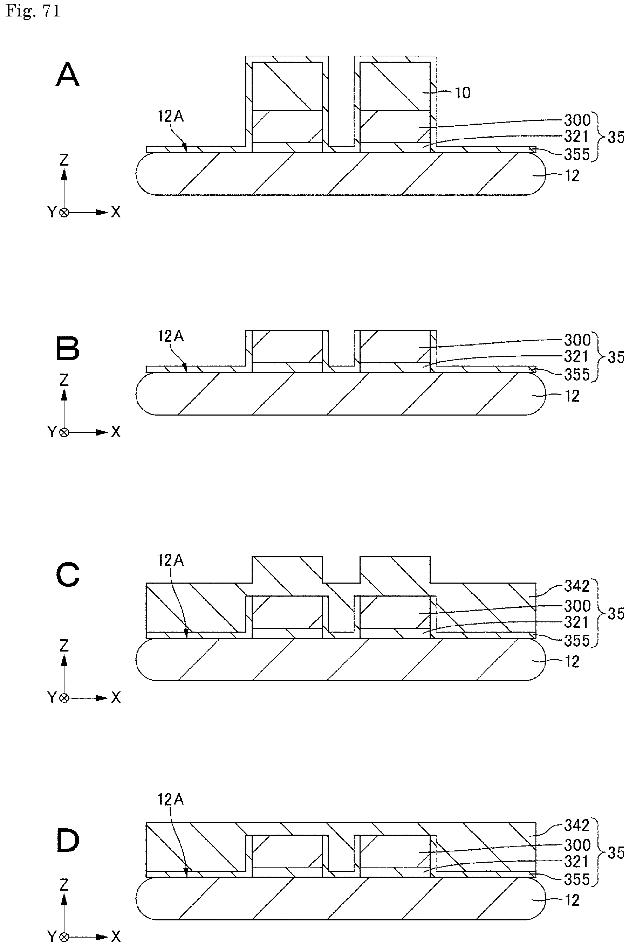

   Figs. 71A, 71B, 71C, and 71D are process charts for describing examples of the method of manufacturing the light-emitting apparatus.
[Fig. 72]

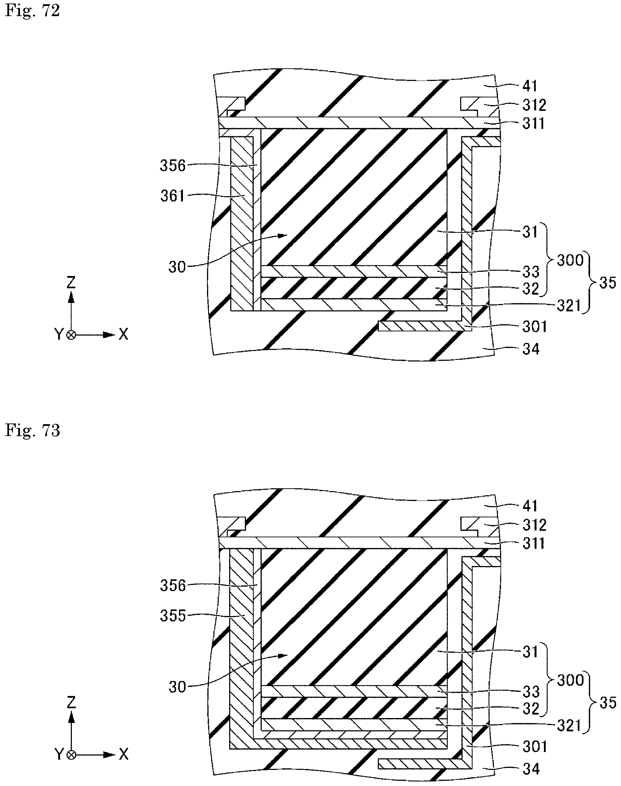

   Fig. 72 is an enlarged sectional view which enlarges a main part of the light-emitting apparatus.
[Fig. 73]
   Fig. 73 is an enlarged sectional view which enlarges a main part of the light-emitting apparatus.
[Fig. 74]

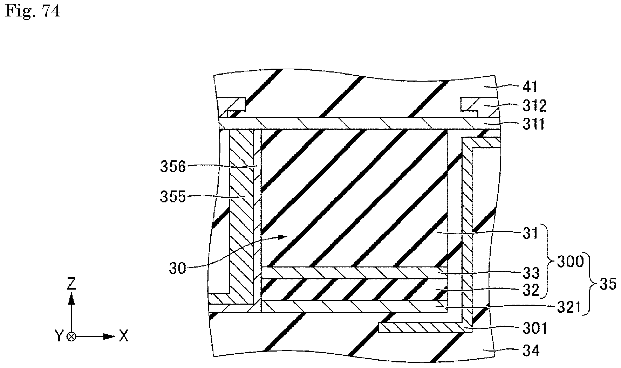

   Fig. 74 is an enlarged sectional view which enlarges a main part of the light-emitting apparatus.
[Fig. 75]

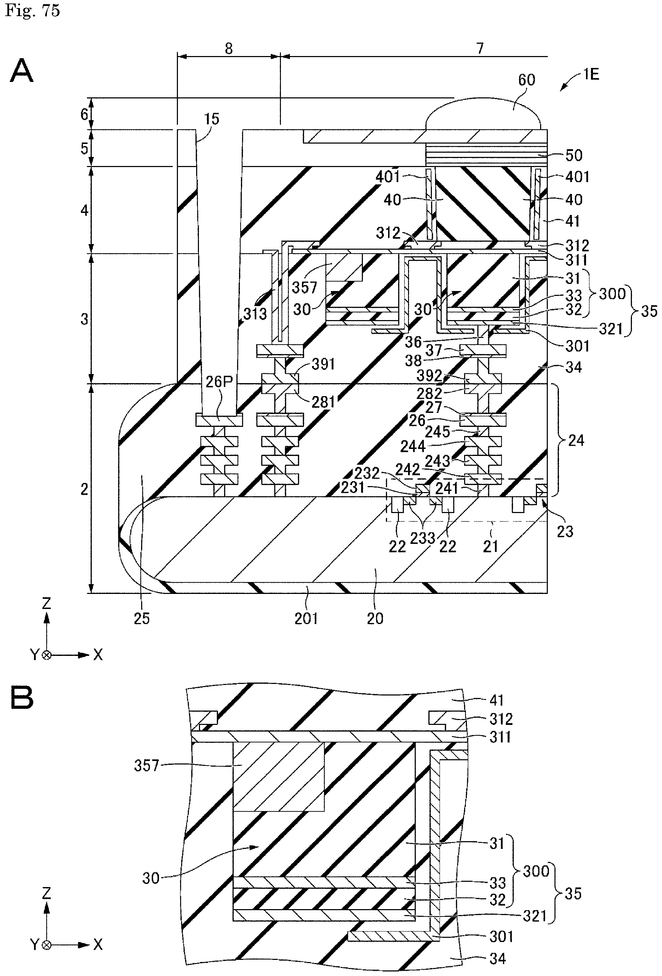

   Fig. 75A is a sectional view illustrating an example of a configuration of a light-emitting apparatus according to a sixth embodiment. Fig. 75B is an enlarged sectional view which enlarges a main part of the light-emitting apparatus illustrated in Fig. 75A.
[Fig. 76]

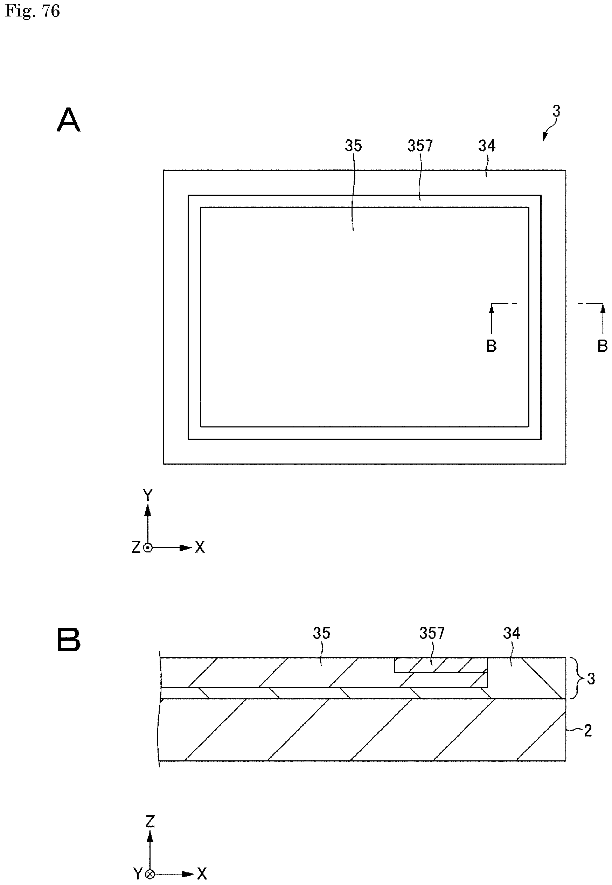

   Fig. 76A is a plan view illustrating an example of a configuration of a light-emitting element layer. Fig. 76B is a sectional view taken along a line B-B in Fig. 76A.
[Fig. 77]

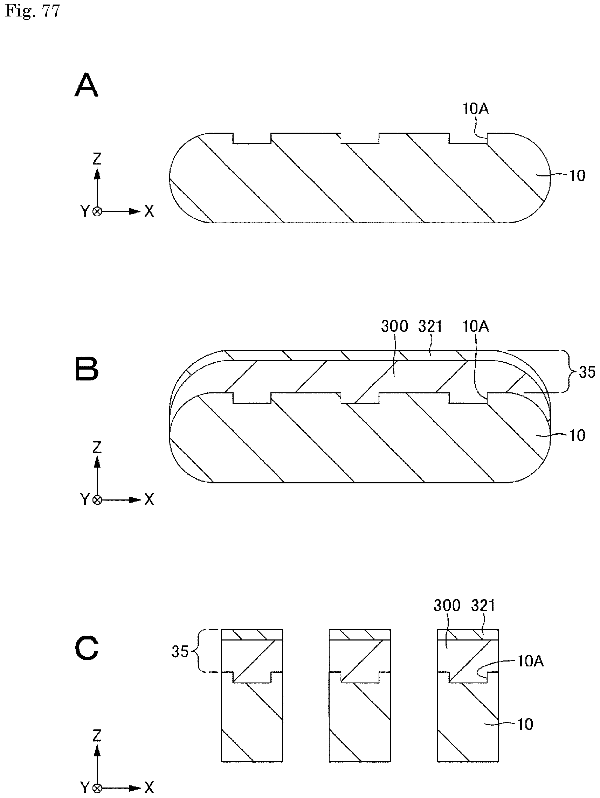

   Figs. 77A, 77B, and 77C are process charts for describing examples of a method of manufacturing the light-emitting apparatus.
[Fig. 78]

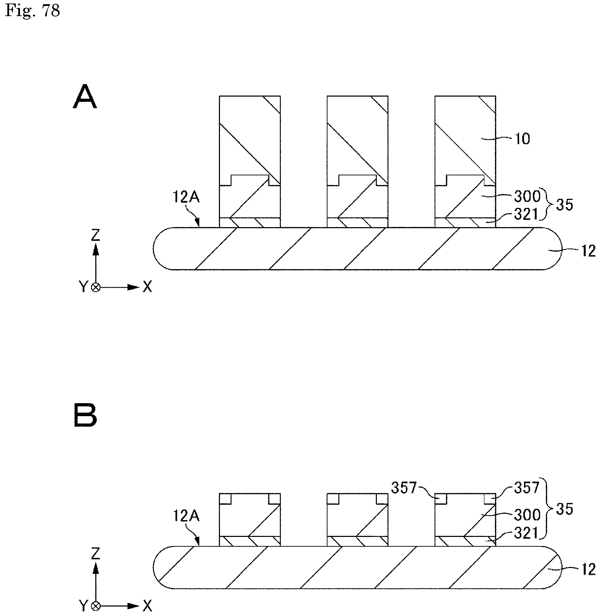

   Figs. 78A and 78B are process charts for describing examples of the method of manufacturing the light-emitting apparatus.
[Fig. 79]

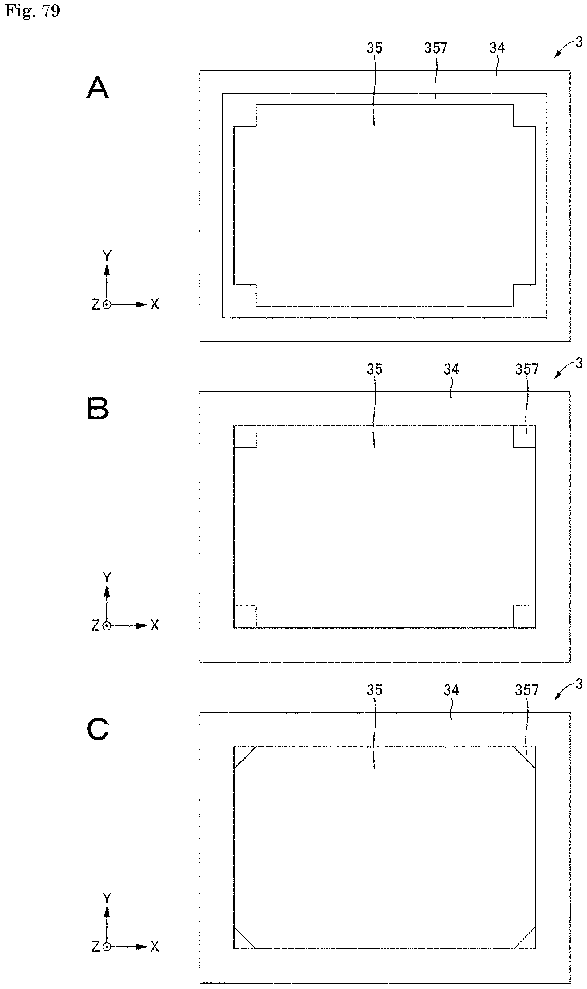

   Figs. 79A, 79B, and 79C are plan views each illustrating a modification of the light-emitting element layer.
[Fig. 80]

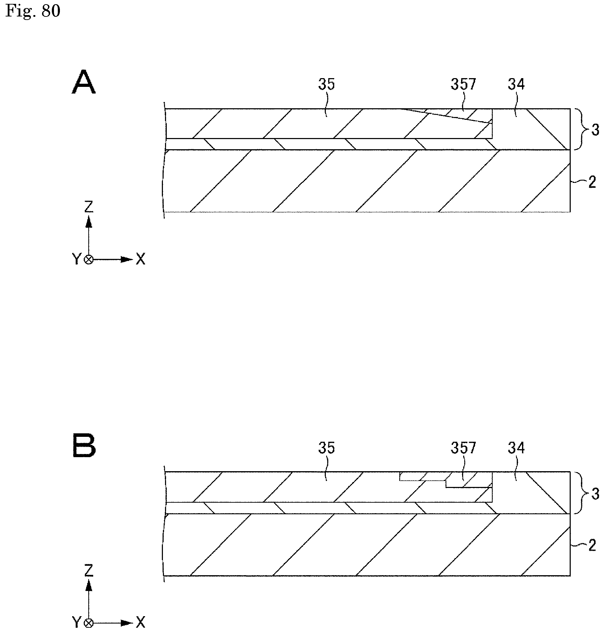

   Figs. 80A and 80B are plan views each illustrating a modification of the light-emitting element layer.
[Fig. 81]

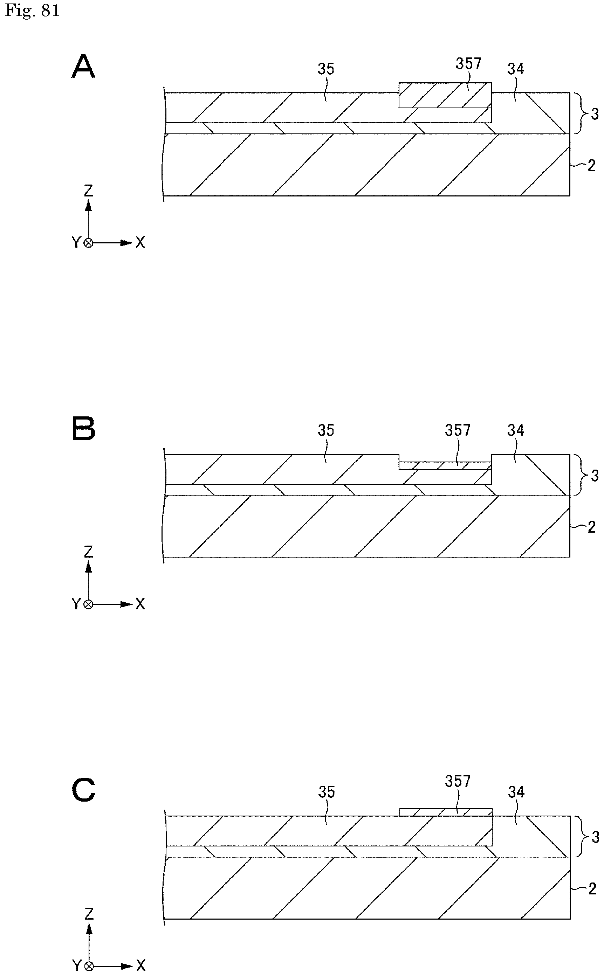

   Figs. 81A, 81B, and 81C are sectional views each illustrating a modification of the light-emitting element layer.
[Fig. 82]

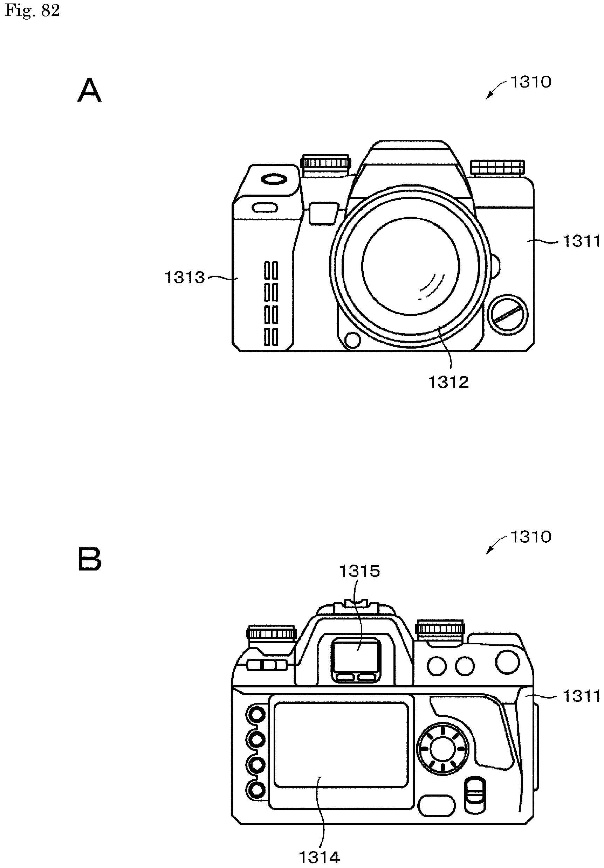

   Fig. 82A is a front view illustrating an example of an appearance of a digital still camera. Fig. 82B is a rear view illustrating an example of the appearance of the digital still camera.
[Fig. 83]

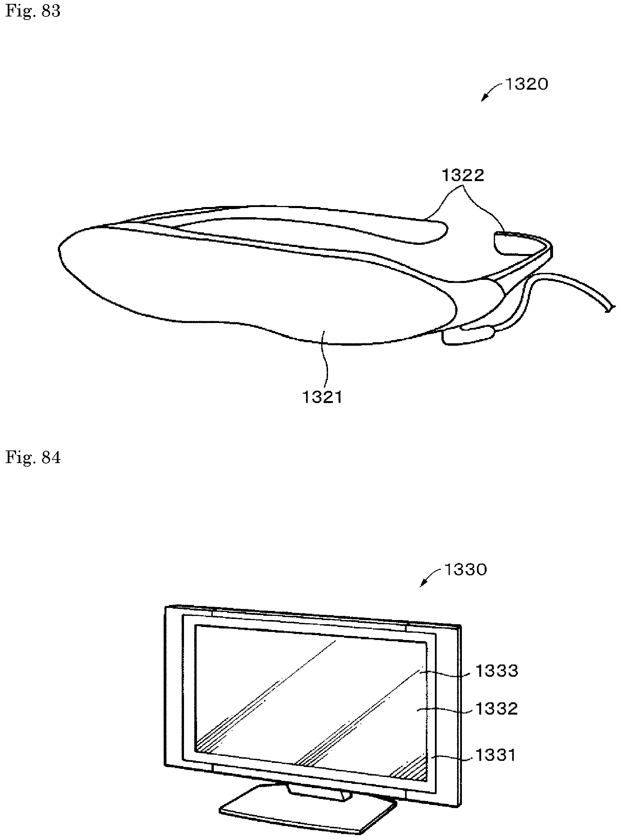

   Fig. 83 is a perspective view illustrating an example of an appearance of a head-mounted display.
[Fig. 84]
   Fig. 84 is a perspective view illustrating an example of an appearance of a television apparatus.
[Fig. 85]

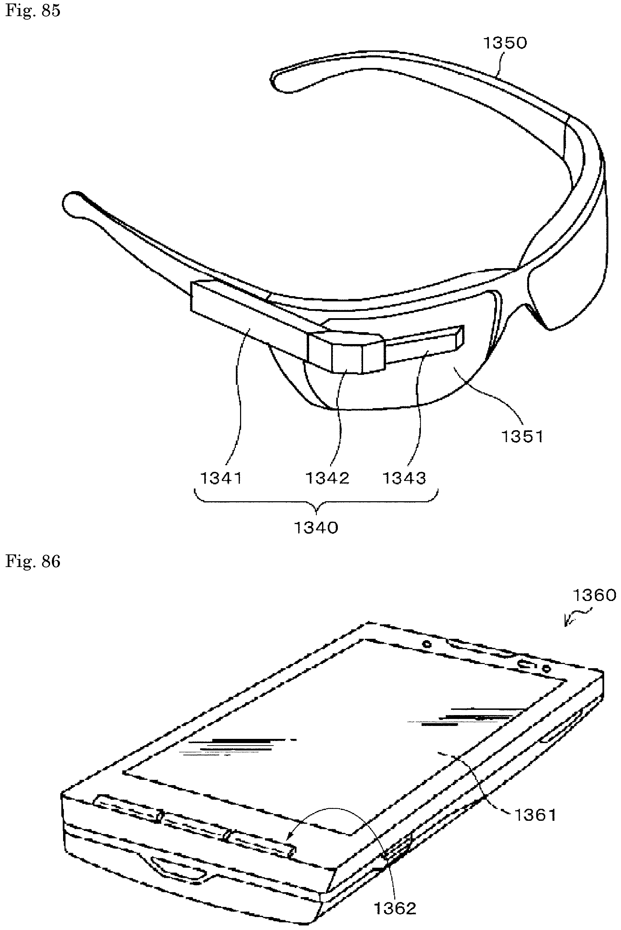

   Fig. 85 is a perspective view illustrating an example of an appearance of a see-through head-mounted display.
[Fig. 86]
   Fig. 86 is a perspective view illustrating an example of an appearance of a smartphone.
[Fig. 87]

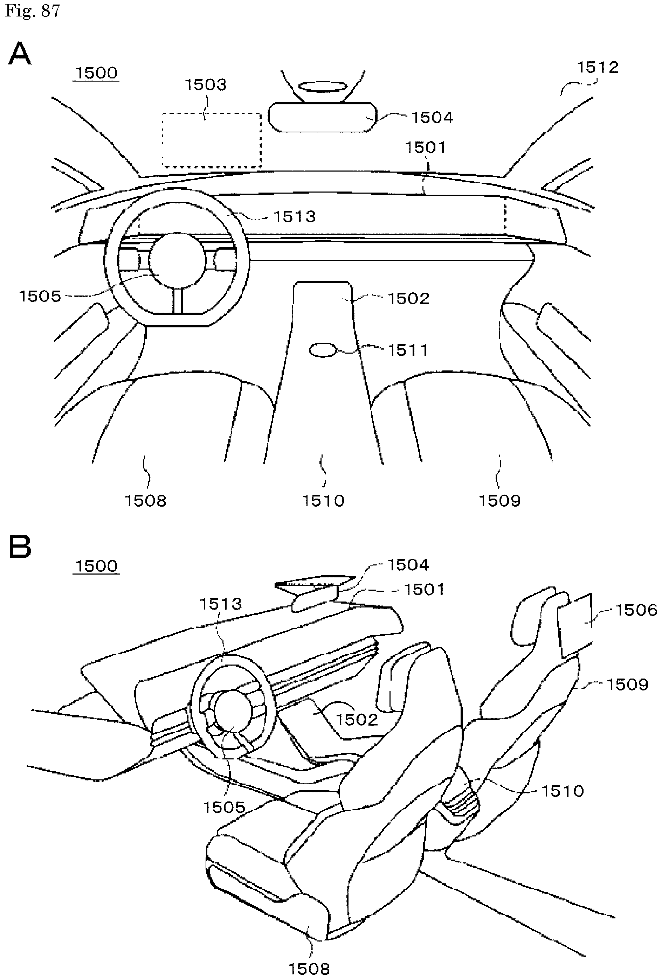

   Fig. 87A is a diagram illustrating an example of a state of an interior of a vehicle from rear to front of the vehicle. Fig. 87B is a diagram illustrating an example of a state of the interior of the vehicle from diagonally rear to diagonally front of the vehicle.
[Fig. 88]

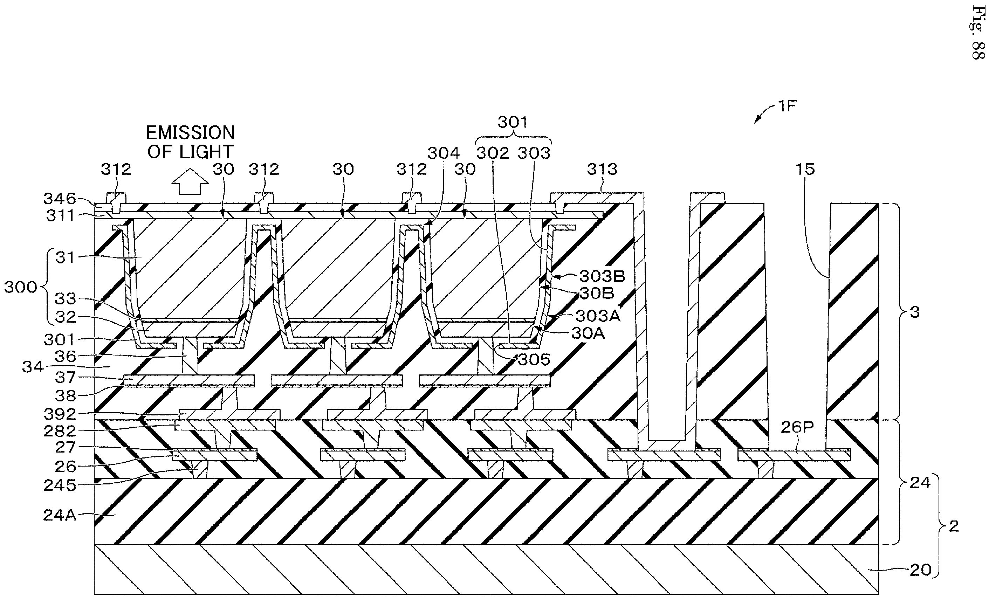

   Fig. 88 is a sectional view illustrating an example of a configuration of a light-emitting apparatus according to a seventh embodiment.
[Fig. 89]

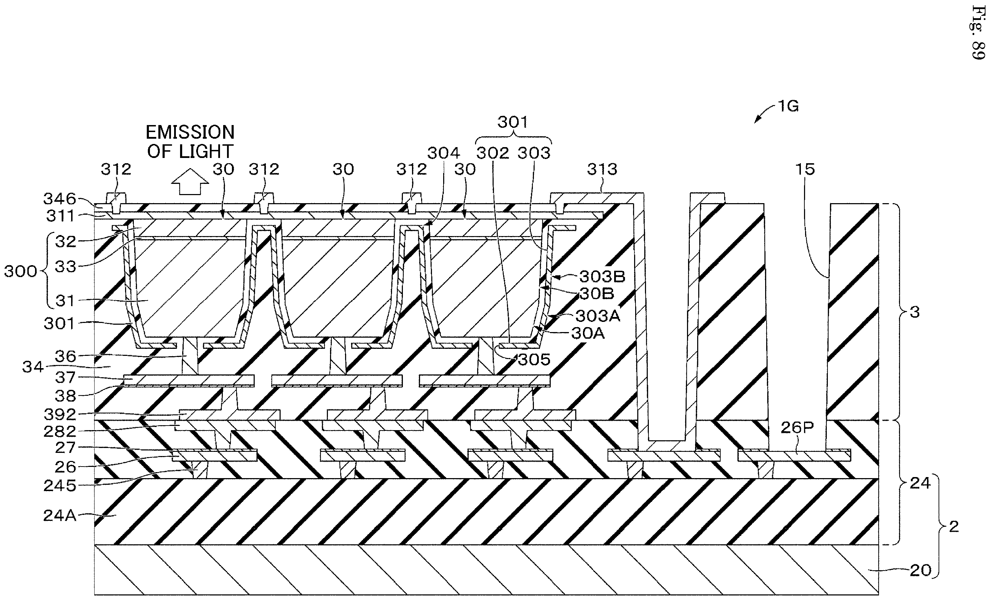

   Fig. 89 is a sectional view illustrating an example of a configuration of a light-emitting apparatus according to an eighth embodiment.
[Fig. 90]

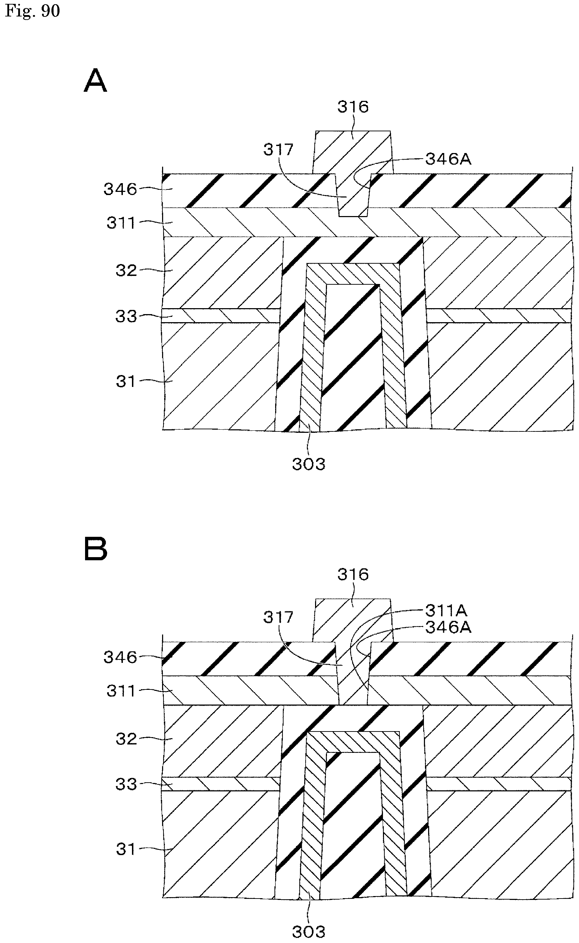

   Figs. 90A and 90B are sectional views of a metal layer.
[Fig. 91]

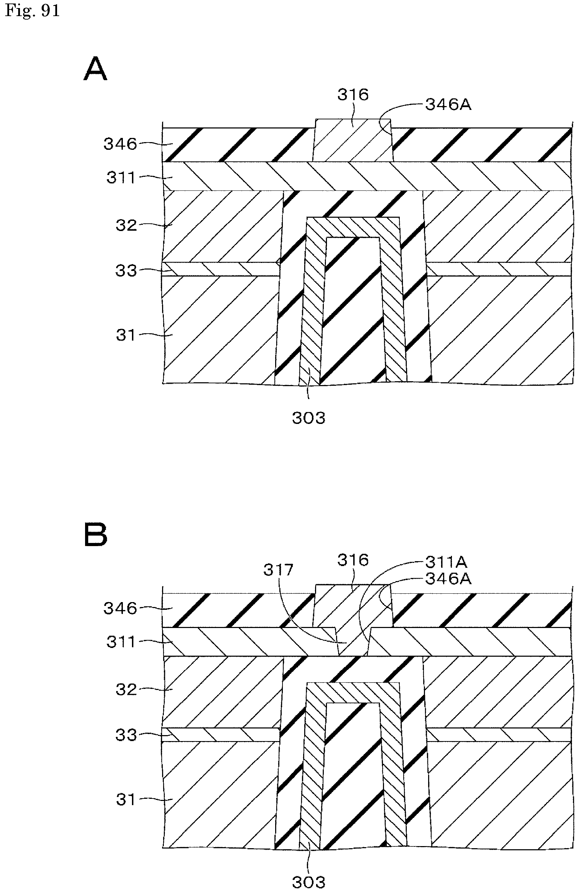

   Figs. 91A and 91B are sectional views of a metal layer.
[Fig. 92]

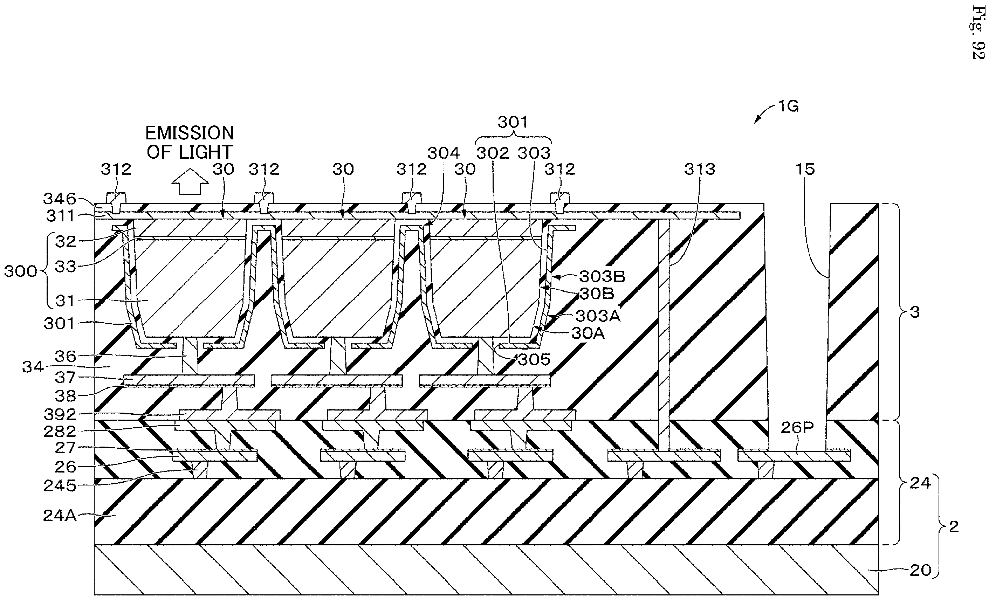

   Fig. 92 is a sectional view illustrating an example of a configuration of a light-emitting apparatus according to a modification.
[Fig. 93]

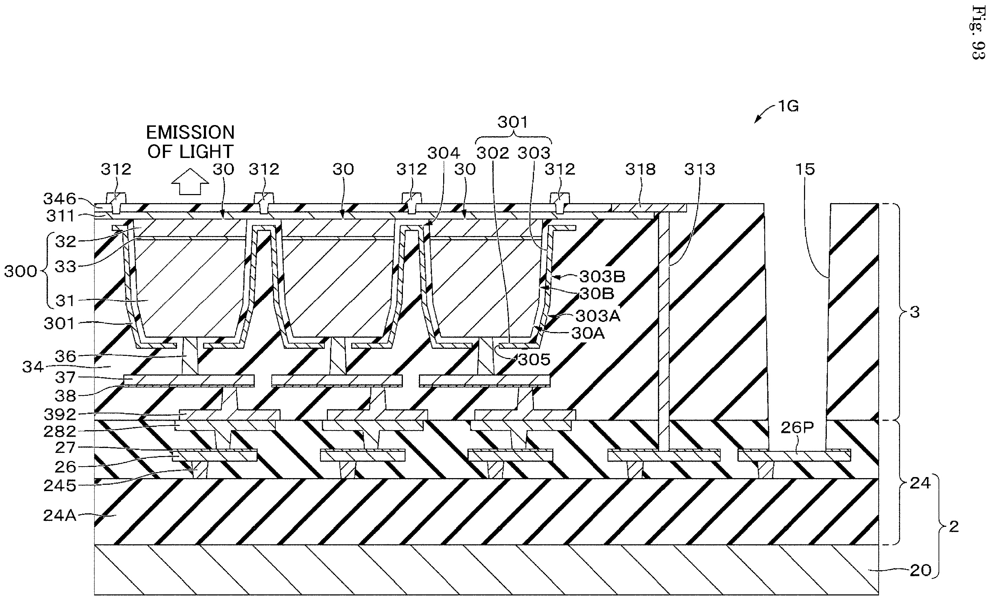

   Fig. 93 is a sectional view illustrating an example of a configuration of a light-emitting apparatus according to a modification.
[Fig. 94]

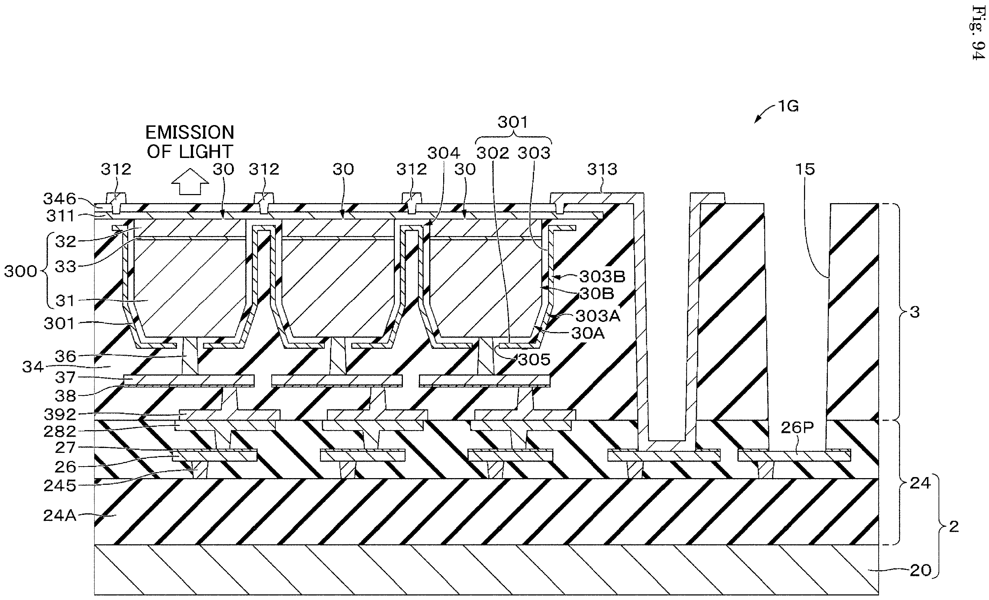

   Fig. 94 is a sectional view illustrating an example of a configuration of a light-emitting apparatus according to a modification.
[Fig. 95]

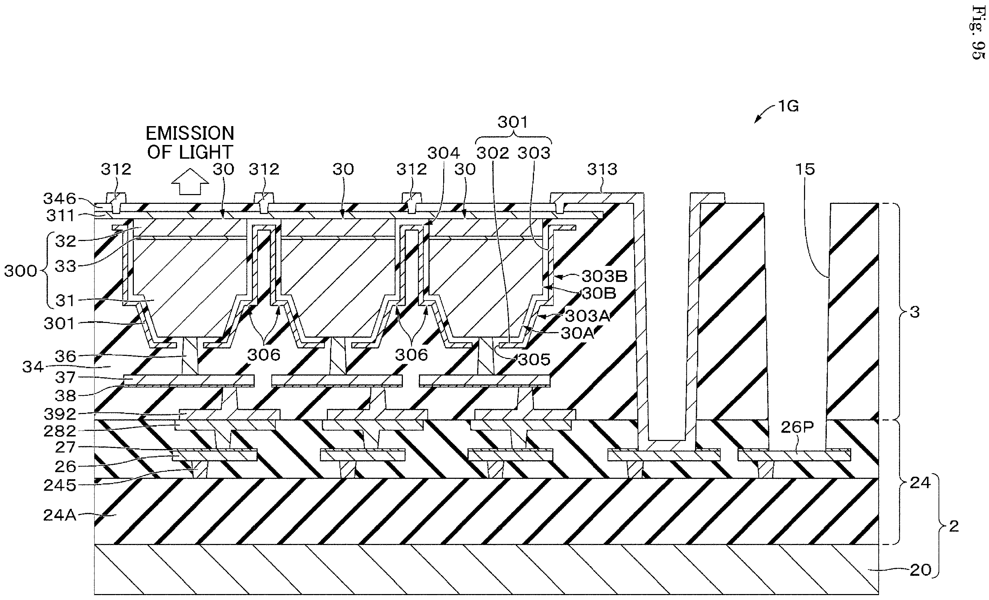

   Fig. 95 is a sectional view illustrating an example of a configuration of a light-emitting apparatus according to a modification.
[Fig. 96]

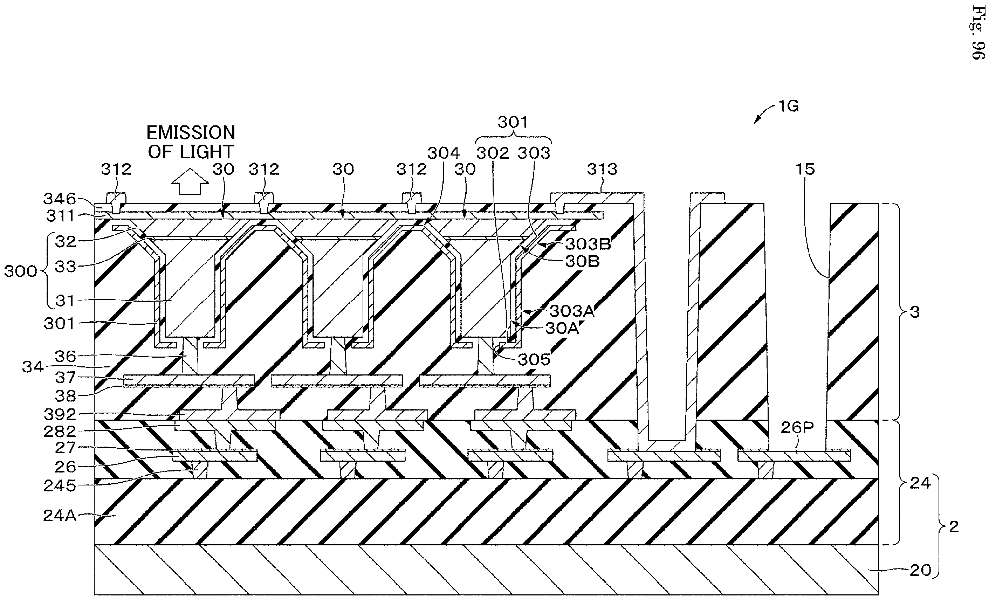

   Fig. 96 is a sectional view illustrating an example of a configuration of a light-emitting apparatus according to a modification.
[Fig. 97]

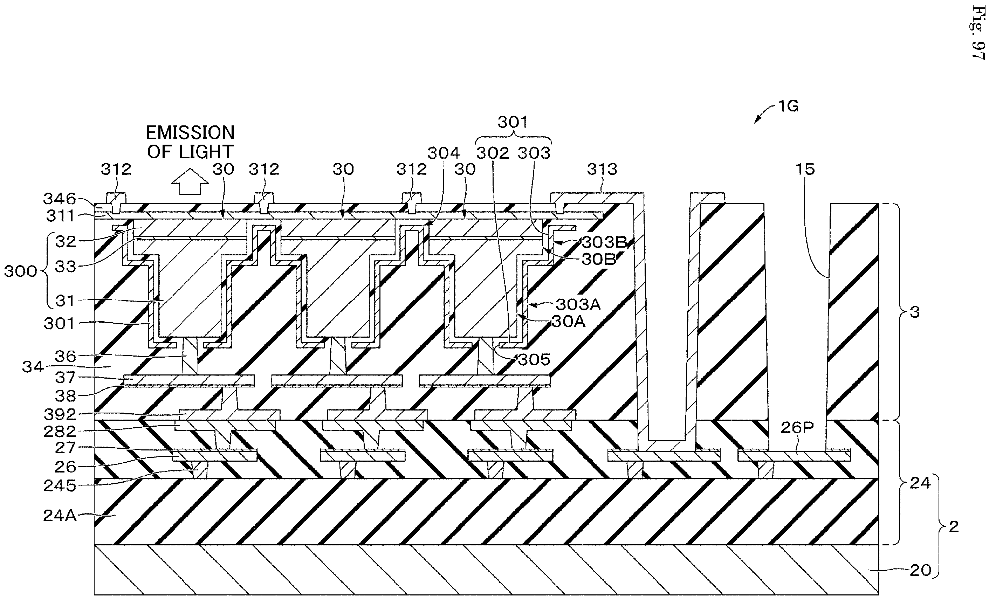

   Fig. 97 is a sectional view illustrating an example of a configuration of a light-emitting apparatus according to a modification.
[Fig. 98]

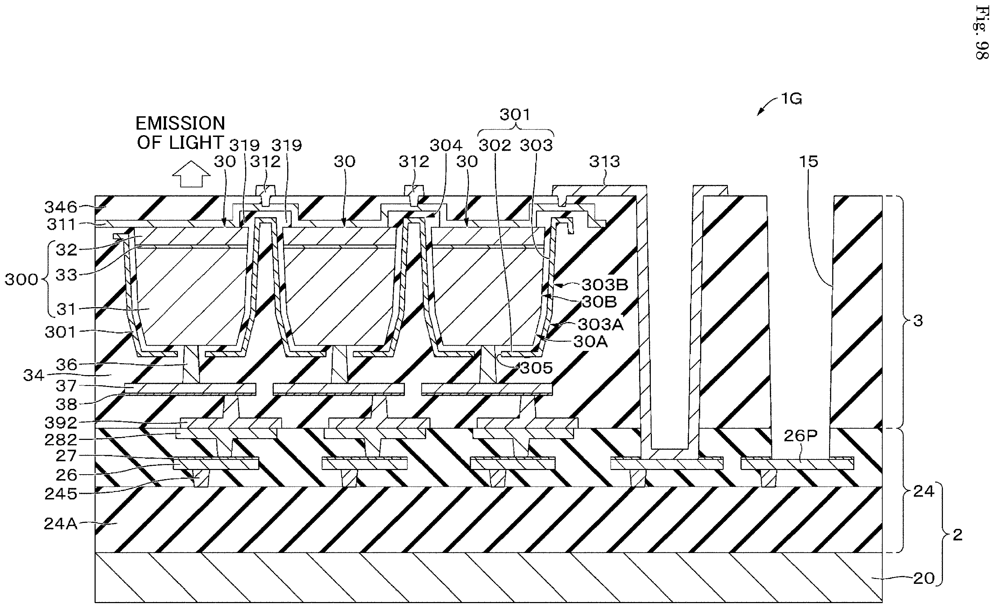

   Fig. 98 is a sectional view illustrating an example of a configuration of a light-emitting apparatus according to a modification.
[Fig. 99]

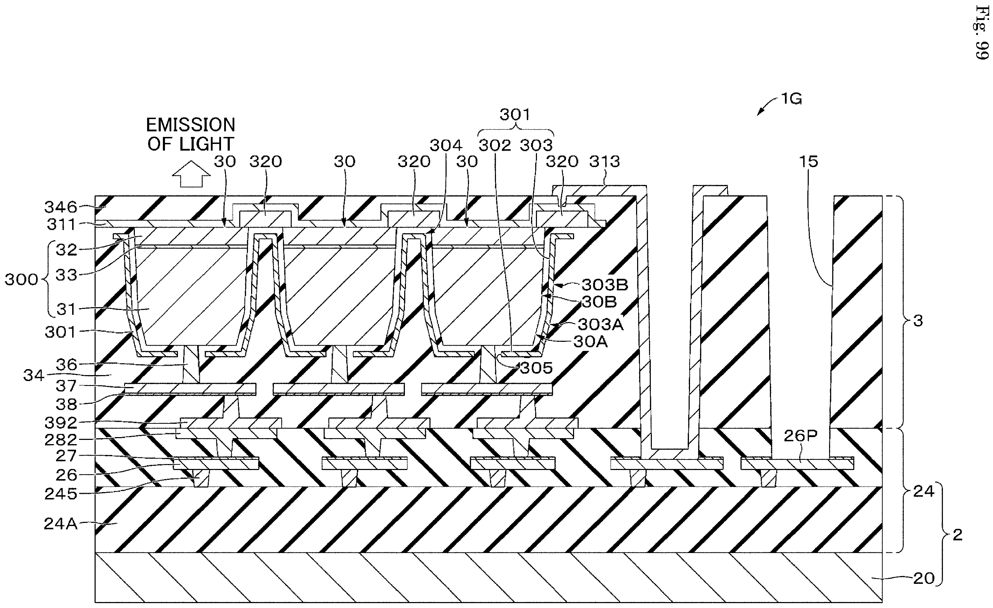

   Fig. 99 is a sectional view illustrating an example of a configuration of a light-emitting apparatus according to a modification.
[Fig. 100]

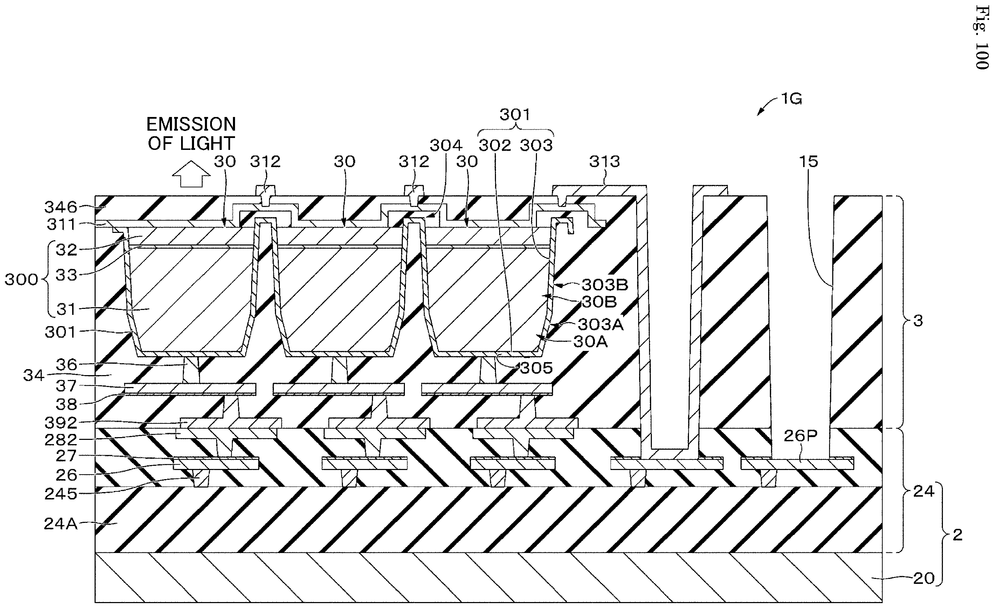

   Fig. 100 is a sectional view illustrating an example of a configuration of a light-emitting apparatus according to a modification.
[Fig. 101]

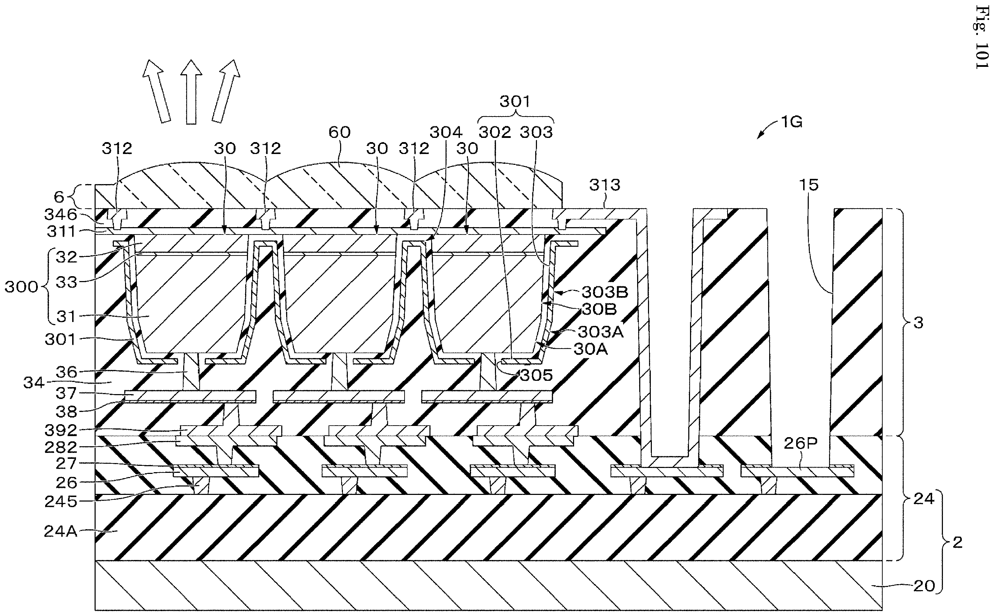

   Fig. 101 is a sectional view illustrating an example of a configuration of a light-emitting apparatus according to a modification.
[Fig. 102]

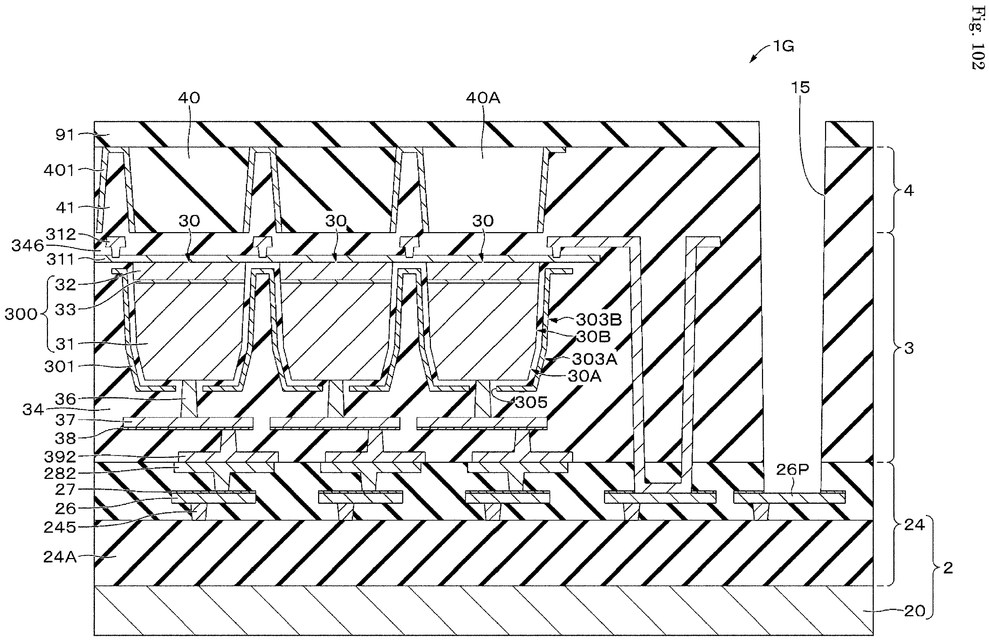

   Fig. 102 is a sectional view illustrating an example of a configuration of a light-emitting apparatus according to a modification.
[Fig. 103]

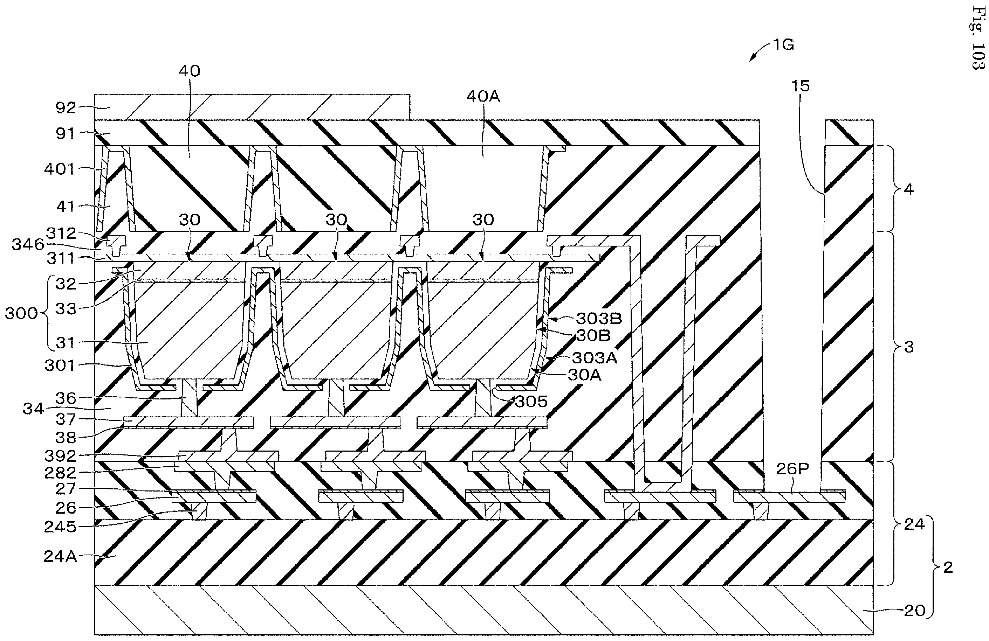

   Fig. 103 is a sectional view illustrating an example of a configuration of a light-emitting apparatus according to a modification.
[Fig. 104]

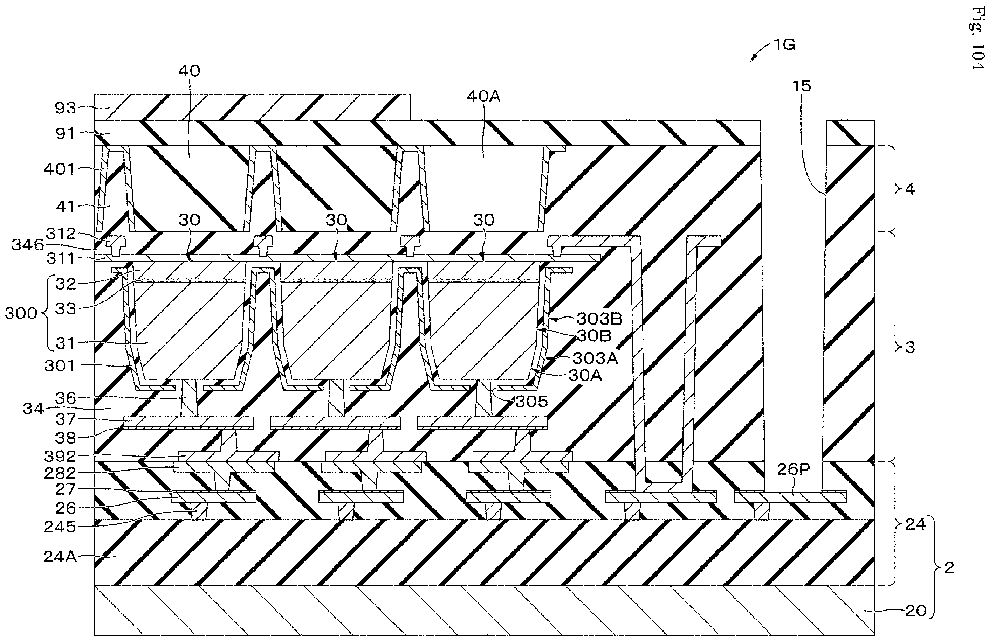

   Fig. 104 is a sectional view illustrating an example of a configuration of a light-emitting apparatus according to a modification.
[Fig. 105]

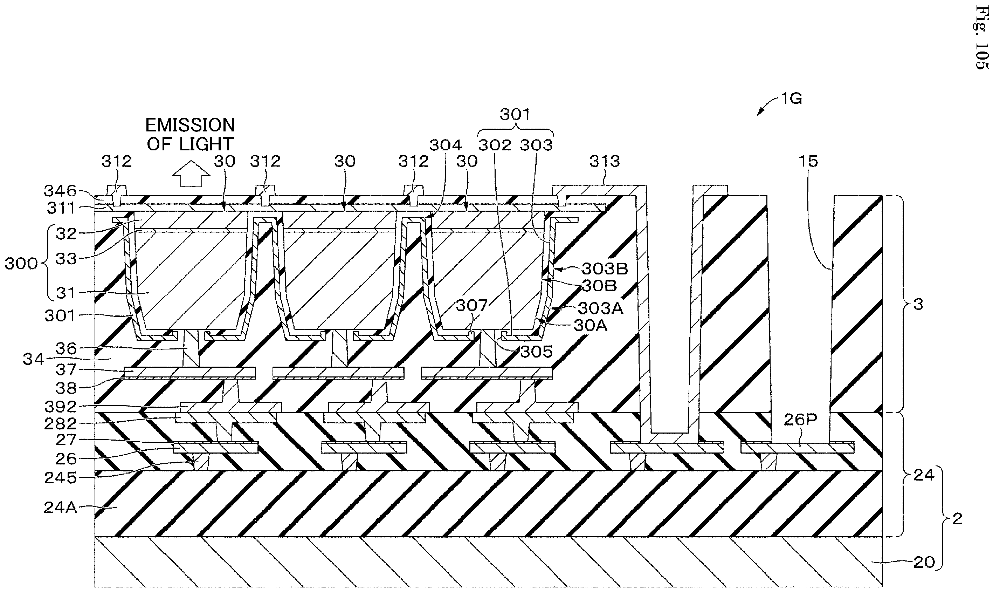

   Fig. 105 is a sectional view illustrating an example of a configuration of a light-emitting apparatus according to a modification.
[Fig. 106]

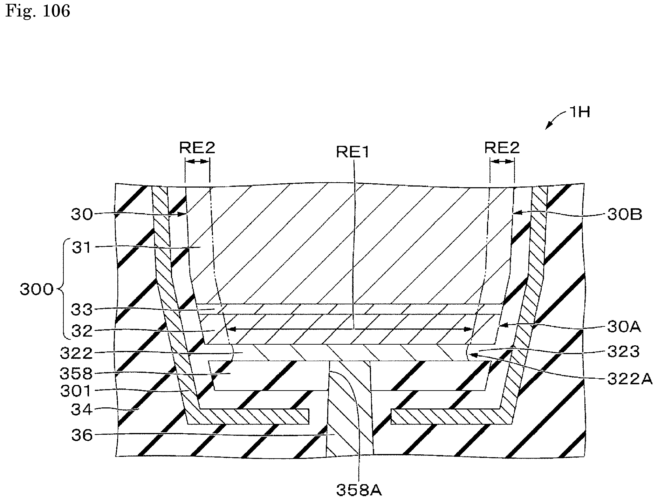

   Fig. 106 is a sectional view illustrating an example of a configuration of a light-emitting apparatus according to a ninth embodiment.
[Fig. 107]

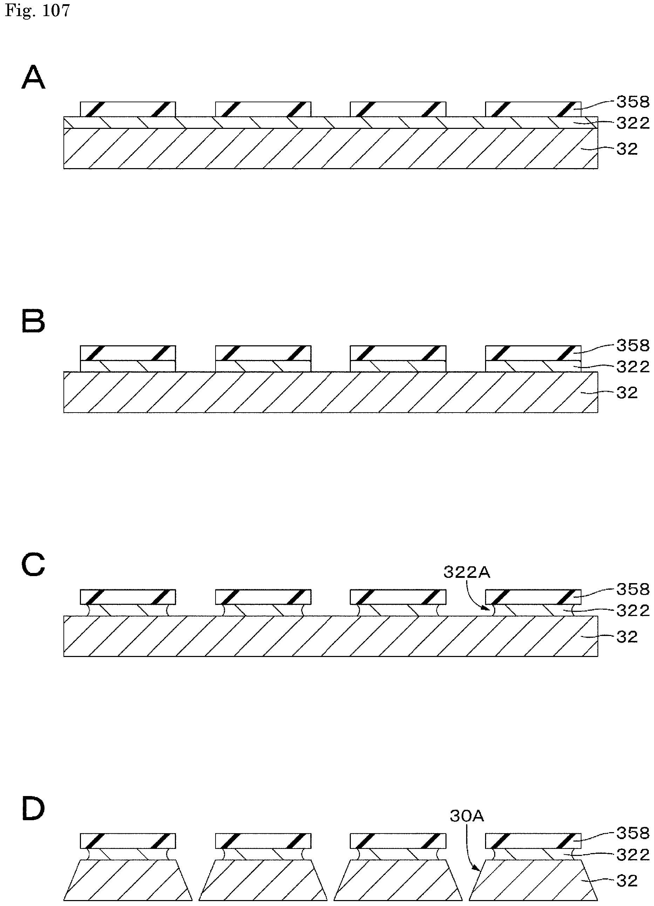

   Figs. 107A, 107B, 107C, and 107D are process charts for describing an example of a method of manufacturing the light-emitting apparatus according to the ninth embodiment.
[Fig. 108]

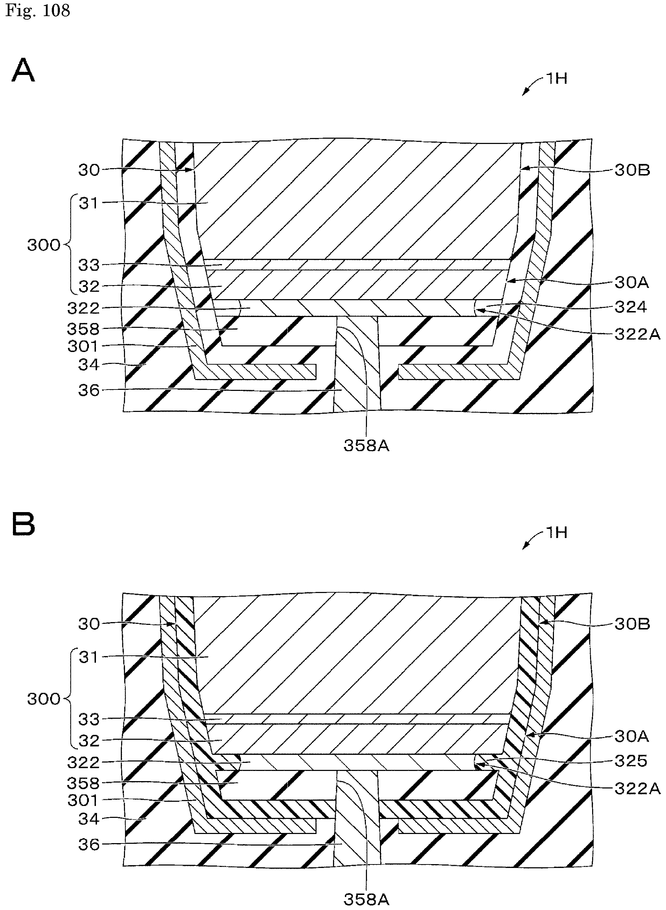

   Figs. 108A and 108B are sectional views illustrating an example of a configuration of a light-emitting apparatus according to a modification.
[Fig. 109]

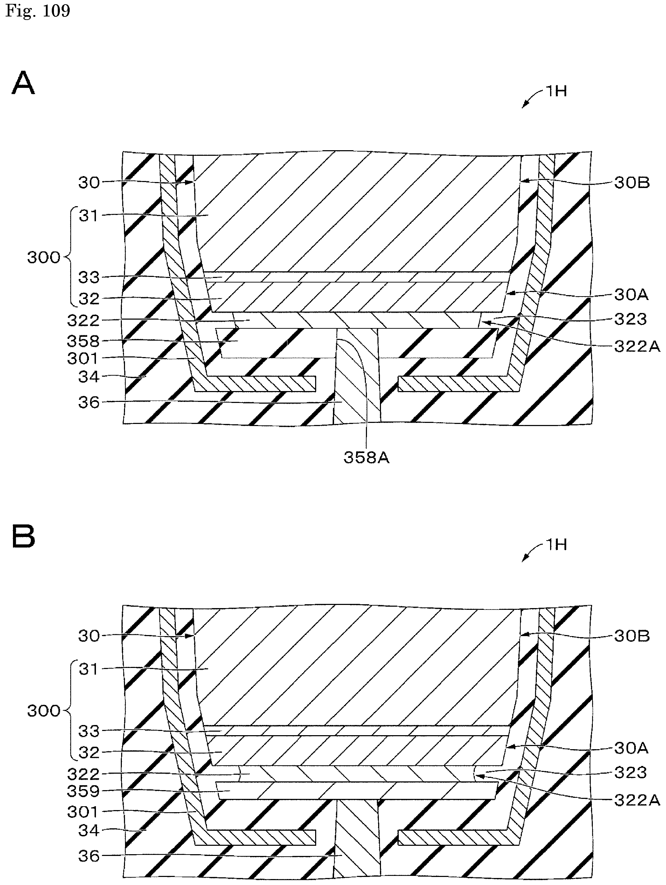

   Figs. 109A and 109B are sectional views illustrating an example of a configuration of a light-emitting apparatus according to a modification.
[Fig. 110]

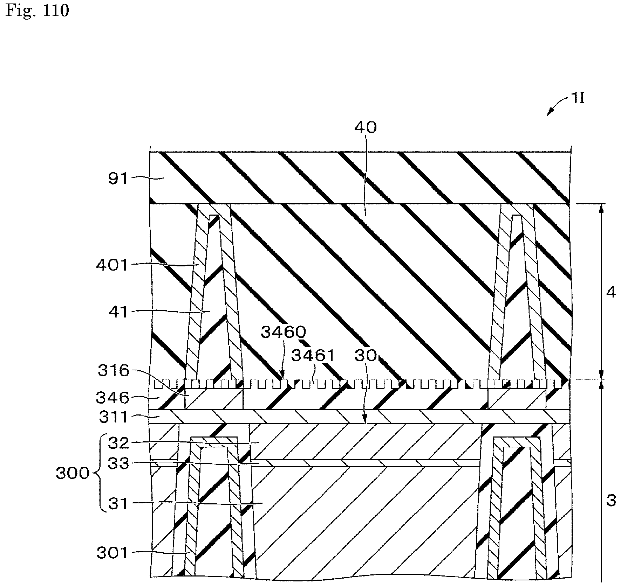

   Fig. 110 is a sectional view illustrating an example of a configuration of a light-emitting apparatus according to a tenth embodiment.
[Fig. 111]

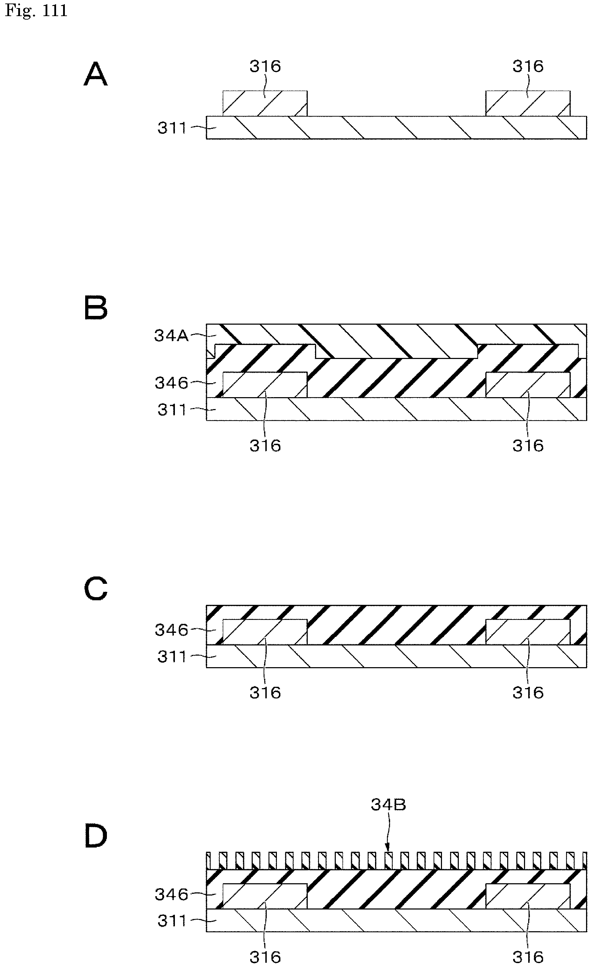

   Figs. 111A, 111B, 111C, and 111D are process charts for describing an example of a method of manufacturing the light-emitting apparatus according to the tenth embodiment.
[Fig. 112]

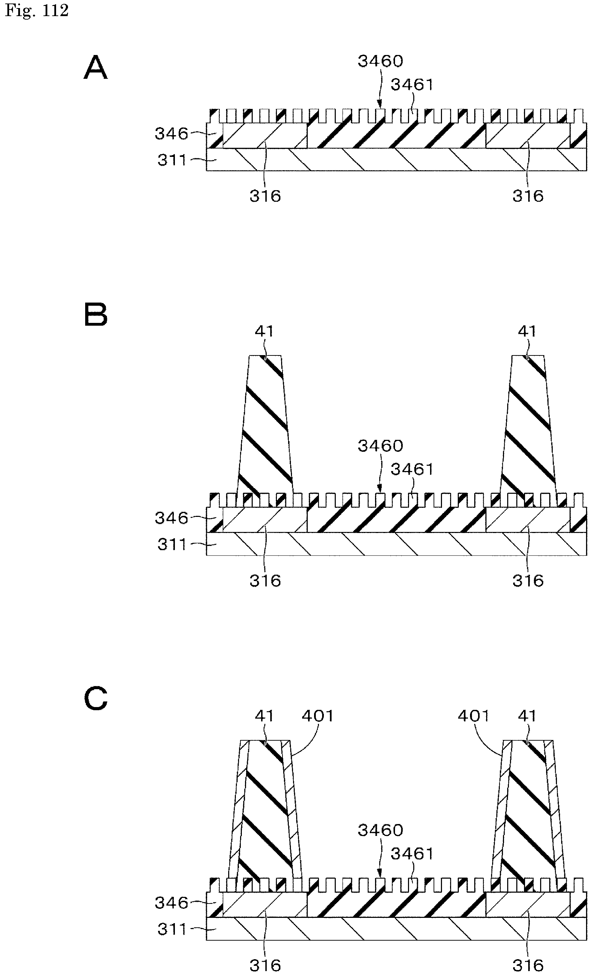

   Figs. 112A, 112B, and 112C are process charts for describing an example of the method of manufacturing the light-emitting apparatus according to the tenth embodiment.
[Fig. 113]

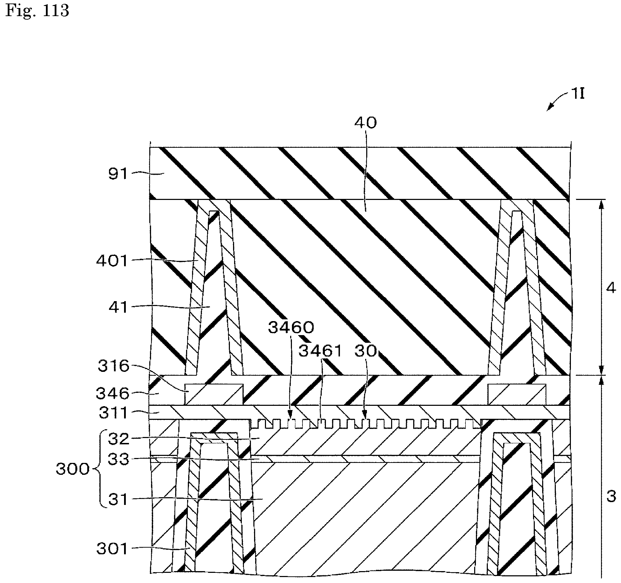

   Fig. 113 is a sectional view illustrating an example of a configuration of a light-emitting apparatus according to a modification.
[Fig. 114]

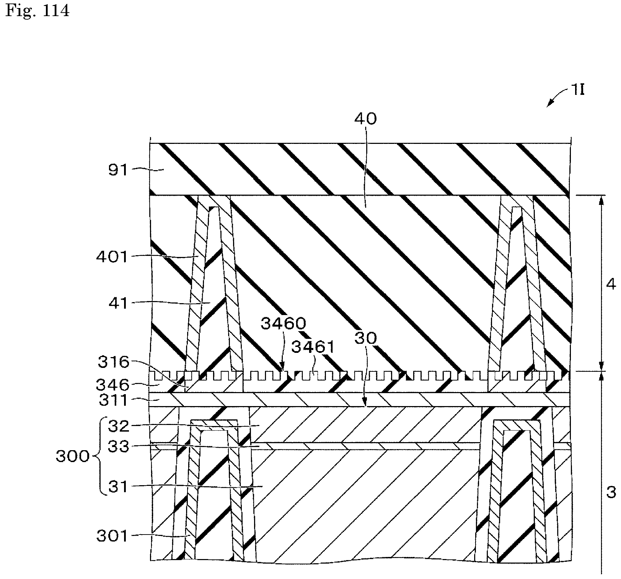

   Fig. 114 is a sectional view illustrating an example of a configuration of a light-emitting apparatus according to a modification.
[Fig. 115]

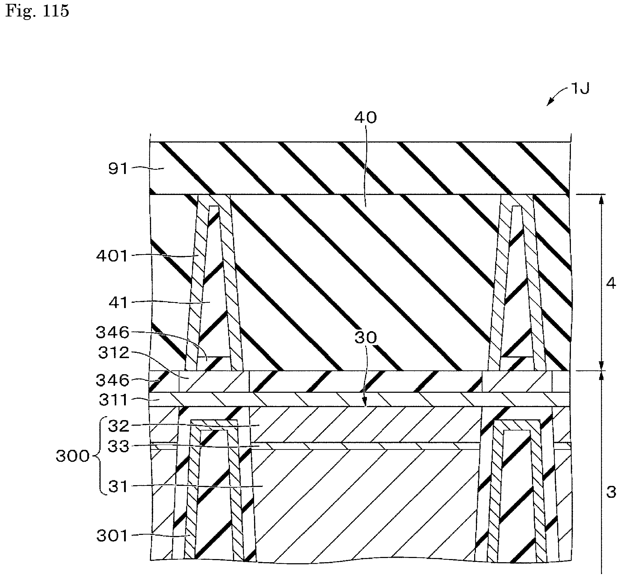

   Fig. 115 is a sectional view illustrating an example of a configuration of a light-emitting apparatus according to an eleventh embodiment.
[Fig. 116]

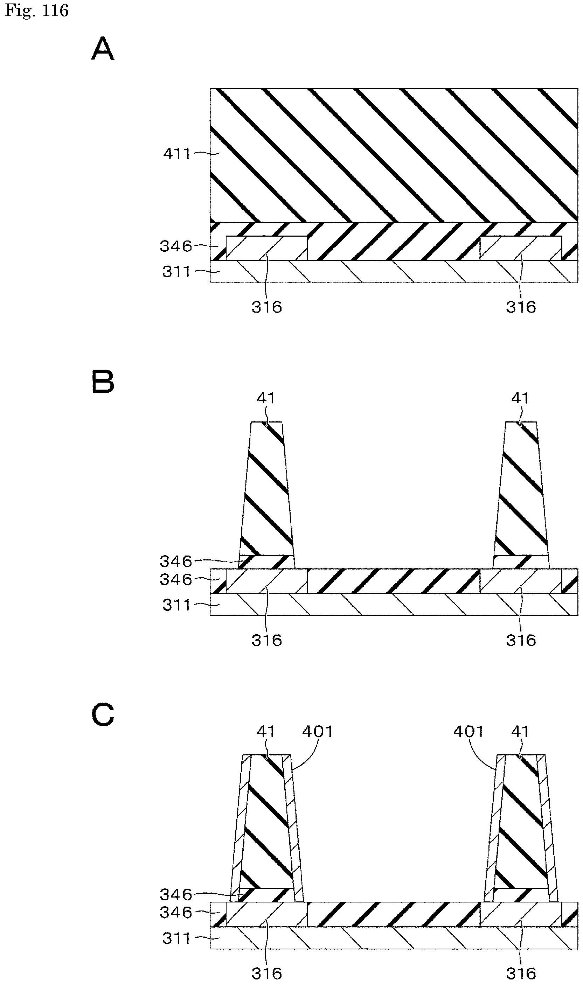

   Figs. 116A, 116B, and 116C are process charts for describing an example of a method of manufacturing the light-emitting apparatus according to the eleventh embodiment.
[Fig. 117]

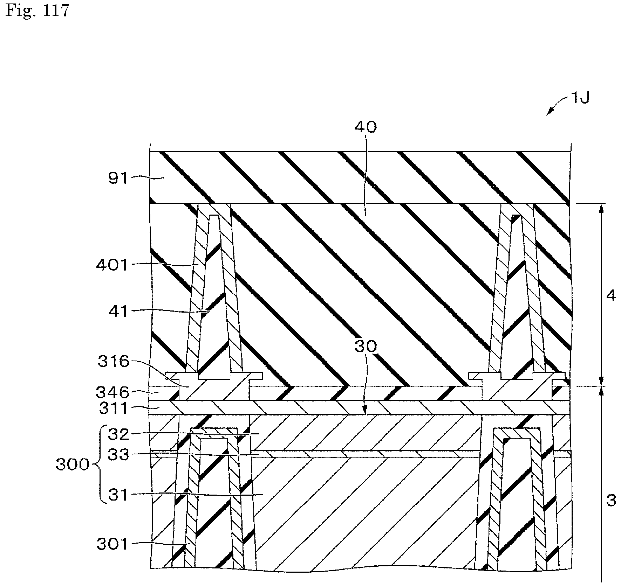

   Fig. 117 is a sectional view illustrating an example of a configuration of a light-emitting apparatus according to a modification.
[Fig. 118]

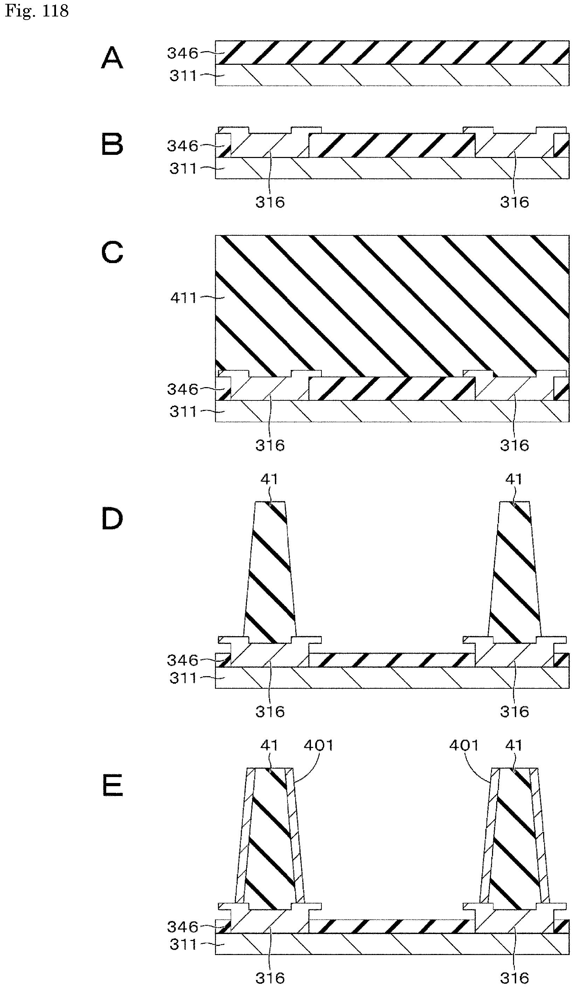

   Figs. 118A, 118B, 118C, 118D, and 118E are process diagrams for describing an example of a method of manufacturing a light-emitting apparatus according to a modification.
[Fig. 119]

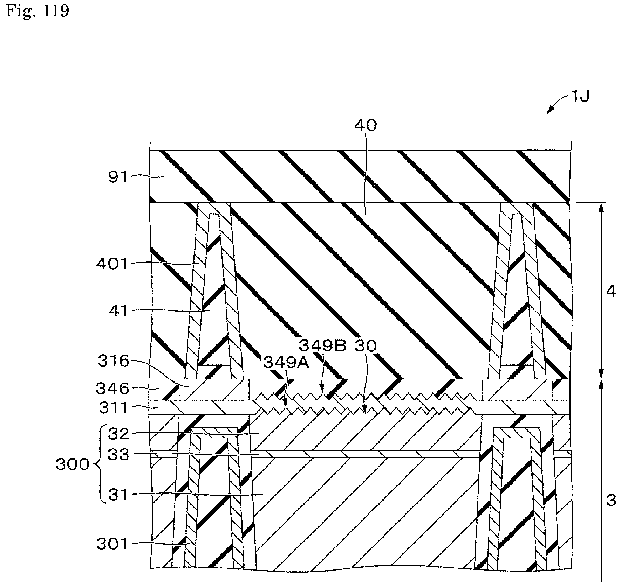

   Fig. 119 is a sectional view illustrating an example of a configuration of a light-emitting apparatus according to a modification.

### [Description of Embodiments]

Embodiments of the present disclosure will be described in the following order with reference to the drawings. Note that in all the drawings of the following embodiments, same or corresponding parts will be denoted with same reference numerals.
1. First embodiment (example of light-emitting apparatus)
2. Second embodiment (example of light-emitting apparatus)
3. Third embodiment (example of light-emitting apparatus)
4. Fourth embodiment (example of light-emitting apparatus)
5. Fifth embodiment (example of light-emitting apparatus)
6. Sixth embodiment (example of light-emitting apparatus)
7. Seventh embodiment (example of light-emitting apparatus)
8. Eighth embodiment (example of light-emitting apparatus)
9. Ninth embodiment (example of light-emitting apparatus)
10. Tenth embodiment (example of light-emitting apparatus)
11. Eleventh embodiment (example of light-emitting apparatus)
12. Application examples

A direction of an arrow X appropriately illustrated in the diagrams represents one planar direction of a light-emitting apparatus from left to right on a paper plane. A direction of an arrow Y represents another planar direction of the light-emitting apparatus which is perpendicular to the arrow X direction and which is oriented from a near side toward a far side of the paper plane. In addition, a direction of an arrow Z represents a height direction of the light-emitting apparatus which is perpendicular to the arrow X direction and the arrow Y direction and which is oriented from a lower side to an upper side of the paper plane. Each of the arrow X direction, the arrow Y direction, and the arrow Z direction corresponds to each of an X-axis direction, a Y-axis direction, and a Z-axis direction of a three-dimensional coordinate system. Note that these directions are merely illustrated in order to help understand the present disclosure and are not intended to limit directions in the present disclosure.

In the present specification, in each layer constituting the light-emitting apparatus, a surface facing a side where light is emitted may be referred to as a first surface and a surface on an opposite side to the first surface may be referred to as a second surface. In the present specification, a plan view refers to viewing an object in the arrow Z direction.

### <1 First embodiment>

### [Configuration of light-emitting apparatus 1]

### 1-1 Overall configuration of light-emitting apparatus 1

As illustrated in Fig. 1, a light-emitting apparatus 1 according to the first embodiment sequentially includes, in a longitudinal sectional direction that is the arrow Z direction, a driving circuit board 2, a light-emitting element layer 3, a color conversion layer 4, a filter layer 5, and a lens array 6. The light-emitting apparatus 1 includes an element array region 7 and a peripheral region 8 in a planar direction that is the arrow X direction and the arrow Y direction. The light-emitting apparatus 1 is an example of a laminate.

### (2) Configuration of driving circuit board 2

The driving circuit board 2 is configured to include a substrate 20 and a drive circuit 21 mounted on a principal surface of the substrate 20. In this case, the principal surface of the substrate 20 is one of the main surfaces of the substrate 20 on which semiconductor elements such as a drive transistor are manufactured and on which the drive circuit 21 is further constructed.

For example, a single-crystal silicon (Si) substrate is used as the substrate 20. An insulator 201 is formed on a rear surface on an opposite side to the principal surface and on side surfaces of the substrate 20. As the insulator 201, for example a silicon nitride (SiN) layer or a silicon oxide (SiO) layer can be practically used.

### (2-1) Configuration of drive circuit 21

The drive circuit 21 is constructed of semiconductor elements formed on a principal surface portion of the substrate 20. The semiconductor elements include a complementary insulated gate field-effect transistor (IGFET) 23. The insulated gate field-effect transistor 23 includes at least both a field-effect transistor with a metal/insulator/semiconductor structure (MISFET) and a field-effect transistor with a metal/oxidation layer/semiconductor structure (MOSFET).

Fig. 1 illustrates an n-channel conductive insulated gate field-effect transistor 23. The insulated gate field-effect transistor 23 is formed in the principal surface portion of the substrate 20 in a region surrounded by an element separation region 22. For example, a trench separation structure is used in the element separation region 22. In other words, the element separation region 22 is configured to include a groove dug from the principal surface of the substrate 20 in a depth direction and an insulator embedded in the groove.

The insulated gate field-effect transistor 23 is configured to include a channel formation region (substrate 20), a gate insulating layer 231, a gate electrode 232, and a pair of n-type semiconductor regions 233 to be used as a source region and a drain region. The gate insulating layer 231 is formed on the channel formation region. The gate electrode 232 is formed on the gate insulating layer 231. The pair of the n-type semiconductor regions 233 are formed on the principal surface portion of the substrate 20 separated in a channel length direction via the channel formation region.

Since only a conductivity type of the semiconductor region differs and a basic structure is the same, illustration of a p-channel conductive insulated gate field-effect transistor and a description of a structure thereof will be omitted.

The drive circuit 21 is electrically connected to each of a first terminal 281 and a second terminal 282 via a wiring layer 24. In this case, the wiring layer 24 includes a plug wiring 241, a first layer wiring 242, a second layer wiring 243, a third layer wiring 244, and a plug wiring 245.

For example, the plug wiring 241 is formed on the n-type semiconductor region 233 of the insulated gate field-effect transistor 23 and one end (a lower end) of the plug wiring 241 is electrically connected to the n-type semiconductor region 233. The plug wiring 241 is formed of, for example, dungsten (W).

The first layer wiring 242 is formed on the plug wiring 241 and the first layer wiring 242 is electrically connected to another end (an upper end) of the plug wiring 241. The second layer wiring 243 is formed on the first layer wiring 242 and the second layer wiring 243 is electrically connected to the first layer wiring 242. The third layer wiring 244 is formed on the second layer wiring 243 and the third layer wiring 244 is electrically connected to the second layer wiring 243. Each of the first layer wiring 242 to the third layer wiring 244 is formed of, for example, aluminum (Al) as a main component.

In addition, an insulator 25 is formed in a periphery of the plug wiring 241, between the first layer wiring 242 and the second layer wiring 243, between the second layer wiring 243 and the third layer wiring 244, and the like. The insulator 25 is formed of, for example, a silicon oxide layer or a silicon nitride layer.

### (2-2) Configuration of second light-shielding layer 26 and second light-absorbing layer 27

The third layer wiring 244 is electrically connected to the first terminal 281 or the second terminal 282 sequentially via the plug wiring 245, a second light-shielding layer 26, and a second light-absorbing layer 27.

The second light-shielding layer 26 is arranged on a side of a light-emitting element 30 of the insulated gate field-effect transistor 23 which constitutes the drive circuit 21. In this case, the second light-shielding layer 26 extends in a planar direction until above the insulated gate field-effect transistor 23. The second light-shielding layer 26 is arranged in the insulator 25. The second light-shielding layer 26 is formed as an electric pathway which shields leaking light emitted from the light-emitting element 30 to a side of the drive circuit 21 and which electrically connects the drive circuit 21, the first terminal 281, and the second terminal 282 to one another.

For example, the second light-shielding layer 26 is formed by a metal monolayer film containing aluminum (Al), copper (Cu), tungsten (W), or titanium (Ti) as a main component.

The second light-absorbing layer 27 is arranged on the second light-shielding layer 26. The second light-absorbing layer 27 is formed in the same planar shape as a planar shape of the second light-shielding layer 26 when viewed in a perpendicular direction with respect to a principal surface of the substrate 20 (hereinafter, simply referred to as a "plan view"). The second light-absorbing layer 27 is arranged inside of the insulator 25. The second light-absorbing layer 27 is formed as an electric pathway which absorbs leaking light emitted from the light-emitting element 30 to the side of the drive circuit 21 and which electrically connects the drive circuit 21, the first terminal 281, and the second terminal 282 to one another.

For example, the second light-absorbing layer 27 is formed by a metal or a metallic-compound monolayer film containing titanium nitride (TiN), cobalt (Co), nitrogen-doped titanium oxide (TiON), tantalum nitride (TaN), or amorphous carbon (a-C) as a main component.

### (2-3) Configuration of first terminal 281 and second terminal 282

The first terminal 281 and the second terminal 282 are formed on the second light-absorbing layer 27 and on the insulator 25. Each of the first terminal 281 and the second terminal 282 is electrically connected to the second light-absorbing layer 27. While examples of a connection method to the driving circuit board 2 (Driver) include a Cu-Cu connection (refer to Fig. 1) and a bump (SnAg, Au) connection, the connection method is not limited to these connection modes.

The first terminal 281 is configured to be electrically connected to one side of the light-emitting element 30 (specifically, a first compound semiconductor layer 31). The second terminal 282 is configured to be electrically connected to another side of the light-emitting element 30 (specifically, a second compound semiconductor layer 32).

Each of the first terminal 281 and the second terminal 282 is formed pf the same conductive material such as copper (Cu).

### (3) Configuration light-emitting element layer 3

As illustrated in Fig. 1, the light-emitting element layer 3 is provided on the driving circuit board 2 and, more specifically, on the insulator 25. As illustrated in Figs. 1, 2, 3A, and 3B, the light-emitting element layer 3 includes a laminated member 35 and an insulating layer 34.

The laminated member 35 has a polygonal shape of which at least a corner has been cut off in a linear shape or the like in a plan view. Fig. 3A illustrates an example in which the laminated member 35 has a polygonal shape of which all corners have been cut off in a linear shape or the like. Due to the laminated member 35 having the shape described above in a plan view, when the laminated member 35 is bonded to a supporting substrate or the like during a manufacturing step of the light-emitting apparatus 1, stress concentration at corners of the laminated member 35 (more specifically, a compound semiconductor layer 300) can be alleviated. In a case of a shape where corners are cut off in a linear shape, corners formed at both ends of the cut-off linear portions may be rounded. Examples of the polygonal shape include a quadrangular shape, a hexagonal shape, and an octagonal shape. Examples of the quadrangular shape include a rectangle, a trapezoid, a parallelogram, and a rhomboid. In this case, rectangles are assumed to include squares.

As illustrated in Fig. 3A, a portion where a corner has been cut off is set back inward by a specified distance from a vertex of a corner 35A of a virtual polygonal shape. From the perspective of alleviating stress concentration, a setback distance D preferably ranges from 10 µm or more and 4000 µm or less, more preferably ranges from 500 µm or more and 4000 µm or less, and even more preferably ranges from 1000 µm or more and 4000 µm or less. The vertex of the corner 35A of the virtual polygonal shape can be imagined by extending two sides L1 and L2 which are positioned on both sides of the portion where the corner has been cut off so that the two sides L1 and L2 intersect with each other. The setback distance D from the vertex of the corner 35A of the virtual polygonal shape is a shortest distance from the vertex of the corner 35A of the virtual polygonal shape to a portion L3 where the corner has been cut off.

As illustrated in Fig. 2, the laminated member 35 sequentially includes a transparent electrode 321 and the compound semiconductor layer 300. The laminated member 35 may sequentially include an insulating layer 341, the transparent electrode 321, and the compound semiconductor layer 300. The compound semiconductor layer 300 sequentially includes the second compound semiconductor layer 32, an active layer 33, and a first compound semiconductor layer 31. The second compound semiconductor layer 32 is arranged on a side of the driving circuit board 2. The compound semiconductor layer 300 includes, for example, a III-V group compound semiconductor. Specifically, for example, the compound semiconductor layer 300 includes GaN or AlInGaP. The second compound semiconductor layer 32 may be a p-type compound semiconductor layer and may include, for example, p-type gallium nitride (p-GaN) or p-type aluminum indium gallium phosphide (p-AlInGaP). The first compound semiconductor layer 31 is arranged on a side of a light-emitting surface which is opposite to the side of the driving circuit board 2. The first compound semiconductor layer 31 may be an n-type compound semiconductor layer and may include, for example, n-type gallium nitride (n-GaN) or n-type aluminum indium gallium phosphide (n-AlInGaP).

The laminated member 35 includes a plurality of light-emitting elements 30. The light-emitting element 30 is an example of an optical semiconductor element. The plurality of light-emitting elements 30 are two-dimensionally arranged in an array pattern (for example, a matrix pattern) in in-plane directions (the arrow X direction and the arrow Y direction) of a light-emitting surface of the laminated member 35. The plurality of light-emitting elements 30 are formed of the compound semiconductor layer 300 (refer to Fig. 8) subjected to singulation. In other words, the plurality of light-emitting elements 30 are formed of the compound semiconductor layer 300 which has been grown on a growth substrate, subjected to dicing together with the growth substrate, and then individually separated. The growth substrate singulated together with the compound semiconductor layer 300 has been removed during a manufacturing process.

The compound semiconductor layer 300 included in the light-emitting element layer 3 has physical properties which differ from, for example, the substrate 20 included in the driving circuit board 2. More specifically, the compound semiconductor layer 300 included in the light-emitting element layer 3 is constituted of a material which differs from the substrate 20 included in the driving circuit board 2. Alternatively, the compound semiconductor layer 300 included in the light-emitting element layer 3 has a compound semiconductor layer which differs from the substrate 20 included in the driving circuit board 2. An area of the compound semiconductor layer 300 included in the light-emitting element layer 3 in a plan view is smaller than an area of the substrate 20 included in the driving circuit board 2. The light-emitting element layer 3 and the driving circuit board 2 are bonded to each other by, for example, metal bonding, insulating film bonding, or a combination thereof.

The insulating layer 34 is formed in a periphery of the laminated member 35 excluding the light-emitting surface. More specifically, the insulating layer 34 covers side surfaces of the laminated member 35 and a second surface (a surface on the side of the driving circuit board 2) of the laminated member 35. For example, the insulating layer 34 includes silicon oxide or silicon nitride.

### (3-1) Configuration of light-emitting element 30

The light-emitting element 30 is configured as a light-emitting diode (LED) including the first compound semiconductor layer 31 which has been divided, the second compound semiconductor layer 32 which has been divided, and the active layer 33 which has been divided. The divided second compound semiconductor layer 32 is arranged on the side of the driving circuit board 2.

### (3-2) Configuration of first light-reflecting layer 301

A first light-reflecting layer 301 is arranged in each of the plurality of light-emitting elements 30. The first light-reflecting layer 301 is formed so as to surround the light-emitting element 30 along a side surface of the first compound semiconductor layer 31, a side surface of the active layer 33, a side surface of the second compound semiconductor layer 32, and a surface on the side of the driving circuit board 2 of the second compound semiconductor layer 32. The first light-reflecting layer 301 is not formed on the light-emitting surface which is a surface on the side of the first compound semiconductor layer 31. The first light-reflecting layer 301 improves light extraction efficiency by reflecting light emitted from the light-emitting element 30 toward a side of the light-emitting surface.

The first light-reflecting layer 301 is formed in the same thickness along the side surface of the first compound semiconductor layer 31, the side surface of the active layer 33, the side surface of the second compound semiconductor layer 32, and the surface of the second compound semiconductor layer 32. This is realized by forming the first light-reflecting layer 301 by a chemical vapor deposition (CVD) method or an atomic layer deposition (ALD) method which provides favorable step coverage.

The first light-reflecting layer 301 is formed of a metal such as aluminum (Al), tungsten (W), silver (Ag), or rhodium (Rh) or a metal compound. Among these materials, aluminum (Al) with superior reflectance and a superior diffusion coefficient is particularly preferable.

### (3-3) Configuration of transparent electrode 311

As illustrated in Figs. 1, 2, 4, and 5, a transparent electrode 311 is arranged on the first compound semiconductor layer 31 of the light-emitting element 30 and the transparent electrode 311 is electrically connected to the first compound semiconductor layer 31. The transparent electrode 311 is integrally formed of the same conductive material in light-emitting elements 30 which are adjacent to each other in a direction of the light-emitting surface. In other words, the transparent electrode 311 is configured as a common electrode which is shared by all light-emitting elements 30 in the element array region 7. The transparent electrode 311 may be formed in a rectangular shape in a plan view. For example, the transparent electrode 311 is formed of indium tin oxide (ITO). The transparent electrode 311 may be formed of indium zinc oxide (IZO), tin oxide (SnO), titanium oxide (TiO), or zinc oxide (ZnO).

The transparent electrode 311 is electrically connected to a first terminal 391 via a through wiring 313 in the peripheral region 8. The through wiring 313 is a wiring which extends in a thickness direction of the light-emitting element layer 3 from a side of the surface of the light-emitting element layer 3 toward an inside of the light-emitting element layer 3. The through wiring 313 may be a TCV (Through Chip Via). A specific material of the through wiring 313 will be described later.

The first terminal 391 is arranged on the surface on the side of the driving circuit board 2 of the light-emitting element layer 3 at a position corresponding to the first terminal 281 of the driving circuit board 2. The first terminal 391 is bonded and electrically connected to the first terminal 281. The first terminal 391 is formed of, for example, copper.

### (3-4) Configuration of reflection attenuation layer 312

As illustrated in Figs. 1 and 5, a reflection attenuation layer 312 is arranged so as to overlap with the transparent electrode 311 on the transparent electrode 311 between the light-emitting elements 30 in the element array region 7. The reflection attenuation layer 312 is formed in a rectangular shape as a whole in a similar manner to the transparent electrode 311 in a plan view and the reflection attenuation layer 312 may be formed in a grid shape which extends in the arrow X direction and the arrow Y direction between the light-emitting elements 30.

In the reflection attenuation layer 312, a reflectance of an interface with the transparent electrode 311 is set smaller than an optical reflectance of an interface between the transparent electrode 311 and an insulating material of the insulating layer 34. In addition, an optical transmittance of the reflection attenuation layer 312 is formed lower than an optical transmittance of the transparent electrode 311. Furthermore, the reflection attenuation layer 312 has conductivity and is electrically connected to the transparent electrode 311.

In the first embodiment, the reflection attenuation layer 312 is formed of a composite film including a titanium nitride layer 312A and a tungsten layer 312B laminated on the titanium nitride layer 312A. In this case, for example, when a thickness of the transparent electrode 311 is set to 10 nm or more and 100 nm or less, a thickness of the titanium nitride layer 312A is set to 3 nm or more and 50 nm or less and a thickness of the tungsten layer 312B is set to 50 nm or more and 200 nm or less.

In addition, the reflection attenuation layer 312 may be formed of a monolayer film or a composite film including two or more layers of which a main component is one or more metals selected from the group consisting of aluminum, titanium, tungsten, and copper. Furthermore, the reflection attenuation layer 312 may be formed of a metal compound of which a main component is the metal described above.

As illustrated in Figs. 1, 2, and 4, the transparent electrode 311 and the reflection attenuation layer 312 are electrically connected to the through wiring 313 in the peripheral region 8. In the first embodiment, the through wiring 313 is formed of the same conductive material as the reflection attenuation layer 312 and formed on the same conductive layer. In other words, in a method of manufacturing the light-emitting apparatus 1, the through wiring 313 is formed by the same manufacturing step as a manufacturing step of the reflection attenuation layer 312.

### (3-5) Configuration of transparent electrode 321

As illustrated in Figs. 1, 2, 4, and 6, the transparent electrode 321 is arranged on a surface on the side of the driving circuit board 2 of the second compound semiconductor layer 32 of the light-emitting element 30. The transparent electrode 321 is electrically connected to the second compound semiconductor layer 32. The transparent electrode 321 is surrounded by the first light-reflecting layer 301 and constructed for each light-emitting element 30 and is formed in a rectangular shape in a plan view in a similar manner to the transparent electrode 311. In addition, the transparent electrode 321 is formed of, for example, indium tin oxide in a similar manner to the transparent electrode 311.

### (3-6) Configuration of plug wiring 36

The transparent electrode 321 is electrically connected to a second terminal 392 via a plug wiring 36 arranged for each light-emitting element 30 directly under the transparent electrode 321 in the element array region 7. The plug wiring 36 is a wiring which extends in a thickness direction of the light-emitting element layer 3 from a side of the surface of the light-emitting element layer 3 toward the inside of the light-emitting element layer 3. An end on the side of the second compound semiconductor layer 32 of the plug wiring 36 penetrates a part of the first light-reflecting layer 301 arranged along the second compound semiconductor layer 32 in a thickness direction and is electrically connected to the second compound semiconductor layer 32. Another end on the side of the driving circuit board 2 of the plug wiring 36 is electrically connected to the second terminal 392 respectively via a first light-absorbing layer 37 and a first light-shielding layer 38.

The plug wiring 36 is formed by embedding a conductive material inside of a connection hole (reference sign omitted) which is formed in the insulating layer 34. In other words, a dimension of one end of the plug wiring 36 matches an opening dimension of the connection hole in a plan view. In the portion of the first light-reflecting layer 301 penetrated by the plug wiring 36, since the first light-reflecting layer 301 and the plug wiring 36 need only be electrically separated from each other, the opening dimension can be set small in a plan view. The plug wiring 36 is formed of tungsten, for example.

The second terminal 392 is arranged on the surface on the side of the driving circuit board 2 of the light-emitting element layer 3 at a position corresponding to the second terminal 282 of the driving circuit board 2. The second terminal 392 is bonded and electrically connected to the second terminal 282. The second terminal 392 is formed of, for example, copper in a similar manner to the first terminal 391.

### (3-7) Configuration of first light-absorbing layer 37 and first light-shielding layer 38

The first light-absorbing layer 37 is arranged in an outer periphery intersecting with an extending direction of the plug wiring 36 (the arrow Z direction) which is, in this case, perpendicular planar directions (the arrow X direction and the arrow Y direction) between the first light-reflecting layer 301 and the second terminal 392 or the second terminal 282 of the driving circuit board 2. The first light-absorbing layer 37 is set to the same dimension as or a larger dimension than the opening dimension of the portion of the first light-reflecting layer 301 penetrated by the plug wiring 36. The first light-absorbing layer 37 is formed as an electric pathway which absorbs leaking light toward the side of the driving circuit board 2 from between the first light-reflecting layer 301 and the plug wiring 36 and which electrically connects the plug wiring 36 and the second terminal 392 to each other. The first light-absorbing layer 37 is arranged inside of the insulator 25.

For example, the first light-absorbing layer is formed of the same conductive material as the second light-absorbing layer.

The first light-shielding layer 38 is arranged under the first light-absorbing layer 37. The first light-shielding layer 38 is formed in the same planar shape as a planar shape of the first light-absorbing layer 37 in a plan view. The first light-shielding layer 38 is arranged inside of the insulator 25. The first light-shielding layer 38 shields leaking light emitted from the light-emitting element 30 toward the side of the drive circuit 21 and is formed as an electric pathway in a similar manner to the first light-absorbing layer 37.

For example, the first light-shielding layer 38 is formed of the same conductive material as the second light-shielding layer 26 and is formed of, for example, a metal monolayer film of which a main component is tungsten or cobalt.

### (4) Configuration of color conversion layer 4

Returning to Fig. 1, the color conversion layer 4 includes a color conversion portion 40 and a second light-reflecting layer 401. The color conversion portion 40 is arranged via an insulating layer 346 on the light-emitting surface of the light-emitting element 30 or, in other words, on the transparent electrode 311. The color conversion portion 40 is arranged for each light-emitting element 30. The color conversion portion 40 converts light emitted from the light-emitting element 30 into a specific color. In this case, the light-emitting apparatus 1 is constructed as a color light-emitting apparatus (or a color image display apparatus). For example, the color conversion portion 40 is formed of a resin material. The color conversion portion 40 may be a quantum dot conversion layer. The quantum dot conversion layer includes, for example, quantum dots (semiconductor particles) and a resin material. The quantum dots include at least one type selected from the group consisting of CdSe quantum dots, InP quantum dots, and CsPb(Br/I)₃ quantum dots. Examples of the resin material include acrylic resin. The color conversion portion 40 may be a colored layer. For example, the colored layer includes a color resist.

The second light-reflecting layer 401 is arranged along a periphery of a side surface of the color conversion portion 40. The second light-reflecting layer 401 improves light extraction efficiency by reflecting light emitted from the light-emitting element 30 and light diffused from the color conversion portion 40. For example, the second light-reflecting layer 401 is formed using a similar method to the first light-reflecting layer 301 and is formed of the same material as the first light-reflecting layer 301.

In the first embodiment, the second light-reflecting layer 401 is separated from the reflection attenuation layer 312 via an insulating layer (reference sign omitted).

In the color conversion layer 4, a partition wall 41 is formed between color conversion portions 40 which are adjacent to each other in planar directions and between adjacent second light-reflecting layers 401. The partition wall 41 is configured to separate the color conversion portions 40 from each other and to hold the color conversion portions 40. For example, the partition wall 41 is formed of a silicon oxide layer or a silicon nitride layer.

### (5) Configuration of filter layer 5

The filter layer 5 is arranged on the color conversion layer 4. The filter layer 5 includes a filter 50. The filter 50 is arranged on the color conversion portion 40 and shields a specific emission color which is emitted from the light-emitting element 30 or absorbs the specific emission color. In this case, the specific emission color is, for example, blue.

### (6) Configuration of lens array 6

The lens array 6 is arranged on the filter layer 5. An on-chip lens 60 is arranged in the lens array 6. In the on-chip lens 60, a plurality of convex lenses arranged for each light-emitting element 30 are integrally formed. However, in the on-chip lens 60, a plurality of concave lenses arranged for each light-emitting element 30 may be integrally formed. The on-chip lens 60 is made of, for example, a resin material or an inorganic material.

### (7) Configuration of element array region 7

As described earlier, the light-emitting element 30 formed from a singulated compound semiconductor layer is arranged in plurality in a matrix pattern in planar directions in the element array region 7. For example, the light-emitting element 30 is formed in a rectangular shape of which a dimension of one side ranges from 0.5 µm or more and 20 µm or less in a plan view.

### (8) Configuration of peripheral region 8

In the peripheral region 8, the through wiring 313 is arranged on a side of the element array region 7 (inner side) and an external terminal 26P is arranged on an outer side.

As described earlier, one end of the through wiring 313 is electrically connected to the first compound semiconductor layer 31 of the light-emitting element 30 via the transparent electrode 311 and the reflection attenuation layer 312. Another end of the through wiring 313 is electrically connected to the drive circuit 21 via a junction of the first terminal 391 and the first terminal 281.

The external terminal 26P is exposed from an opening which penetrates from the filter layer 5 to a part of the driving circuit board 2. The external terminal 26P is electrically connected to the drive circuit 21. The external terminal 26P is configured such that a wire (not illustrated) is electrically connected to the external terminal 26P. The external terminal 26P receives, via the wire, a drive signal to be input to the drive circuit 21 from outside of the light-emitting apparatus 1. For example, the external terminal 26P is formed of the same conductive material as the second light-shielding layer 26.

### [Method of manufacturing light-emitting apparatus 1]

A method of manufacturing the light-emitting apparatus 1 according to the first embodiment includes the following manufacturing steps illustrated in Figs. 7 to 28. Hereinafter, the method of manufacturing the light-emitting apparatus 1 will be described in detail.

### (1) Manufacturing step of light-emitting element layer 3

First, the compound semiconductor layer 300 is formed on a growth substrate 10 (refer to Fig. 7A). A sapphire substrate is used as an epitaxial growth substrate in the growth substrate 10. As the compound semiconductor layer 300, an undoped gallium nitride layer 315, the first compound semiconductor layer (n-GaN) 31, the active layer 33, and the second compound semiconductor layer (p-GaN) 32 are each sequentially formed from the surface of the growth substrate 10 (refer to Fig. 7B).

As illustrated in Figs. 7A and 7B, the transparent electrode 321 and the insulating layer 341 are sequentially formed on the compound semiconductor layer 300. Accordingly, the laminated member 35 is formed on the compound semiconductor layer 300.

Next, after performing photoresist patterning by lithography and forming a specified mask (not illustrated) on the insulating layer 341, the insulating layer 341 and the transparent electrode 321 are etched through the mask. As etching when processing the transparent electrode 321, for example, dry etching or wet etching is used. Next, the compound semiconductor layer 300 is etched through the mask. After removing deposited matter (reactive product) created by the etching of the compound semiconductor layer 300 is removed by DHF, the mask is peeled off using acetone, IPA, methanol, or the like. Accordingly, a pattern of a specified groove 300A is formed in the laminated member 35 or, in other words, the compound semiconductor layer 300, the transparent electrode 321, and the insulating layer 341 (refer to Figs. 8A and 9).

During the etching described above, as illustrated in Fig. 9, the compound semiconductor layer 300, the transparent electrode 321, and the insulating layer 341 are processed in a polygonal shape of which at least a corner has been cut off in a linear shape or, preferably, a polygonal shape of which all corners have been cut off in a linear shape in a plan view. Accordingly, when the growth substrate 10 is peeled off from the compound semiconductor layer 300, the laminated member (chip) 35 with a polygonal shape of which at least a corner has been cut off is formed.

While Fig. 9 illustrates an example in which the groove 300A for processing and separation is formed, instead of the groove 300A, everything other than a region to remain as the laminated member 35 may be processed and removed. In addition, while Fig. 8A illustrates an example in which side surfaces of the laminated member 35 (in other words, side surfaces of the compound semiconductor layer 300, the transparent electrode 321, and the insulating layer 341) are flush, the side surfaces of the laminated member 35 may have a recessed structure as illustrated in Fig. 8B. In other words, a side surface position of the transparent electrode 321 may be set back inward from the positions of the side surfaces of the compound semiconductor layer 300 and the insulating layer 341 and a gap may be formed between peripheral edge portions of the compound semiconductor layer 300 and the insulating layer 341. The recessed structure is formed when, for example, the transparent electrode 321 constituted of a transparent conductive oxide (for example, indium tin oxide (ITO)) is processed by wet etching.

Next, the insulating layer 341 is arranged so as to oppose a dicing tape 11 and, in a state where the growth substrate 10 is inverted, the growth substrate 10 is glued to the dicing tape 11 (refer to Fig. 10). As illustrated in Fig. 10, dicing is performed and the growth substrate 10, the compound semiconductor layer 300, the transparent electrode 321, and the insulating layer 341 are singulated. A dimension of one side of the singulated growth substrate 10 is formed so as to range from 4 mm or more and 30 mm or less in a plan view.

The growth substrate 10, the compound semiconductor layer 300, the transparent electrode 321, and the insulating layer 341 which have been singulated are bonded to a first bonding surface 12A of a first supporting substrate 12 (refer to Figs. 11A and 11B). The bonding is performed by arranging the insulating layer 341 and the first bonding surface 12A of the first supporting substrate 12 so as to oppose each other, subsequently raising the temperature while applying a load, and causing covalent bonding to occur at the interface due to a dehydration condensation reaction. Accordingly, bonding strength is secured. For example, a silicon substrate is used as the first supporting substrate 12 and an insulating layer 121 is formed on the first bonding surface 12A of the first supporting substrate 12. The insulating layer 121 is formed of, for example, a silicon nitride layer.

As illustrated in Fig. 11A, the growth substrate 10 is peeled off from the compound semiconductor layer 300.

Subsequently, as illustrated in Figs. 12A and 12B, the undoped gallium nitride layer 315 of the compound semiconductor layer 300 is removed. The undoped gallium nitride layer 315 is removed by, for example, polishing.

As illustrated in Fig. 13, an insulating layer 342 for embedding the plurality of singulated laminated members 35 (a plurality of compound semiconductor layers 300) is formed on the first supporting substrate 12. The insulating layer 342 is formed by, for example, a silicon oxide layer. After the silicon oxide layer is formed, a surface thereof is subjected to planarization. For the planarization, for example, chemical mechanical polishing (CMP) is used.

A second supporting substrate 13 is prepared. As illustrated in Fig. 14, the first bonding surface 12A of the first supporting substrate 12 is arranged so as to oppose a second bonding surface 13A of the second supporting substrate 13 and the first supporting substrate 12 is bonded to the second bonding surface 13A. Due to the bonding, an up-down orientation of the compound semiconductor layer 300 is reversed. In other words, the second compound semiconductor layer 32 is arranged on an upper layer of the compound semiconductor layer 300 and the first compound semiconductor layer 31 is arranged on a lower layer of the compound semiconductor layer 300. For example, plasma bonding is used for the bonding. An insulating layer 131 is formed in advance on the second bonding surface 13A of the second supporting substrate 13. The insulating layer 131 is formed of, for example, a silicon nitride layer.

As illustrated in Figs. 15A and 15B, the first supporting substrate 12 is peeled off. Fig. 15B illustrates an enlarged sectional view of a region enclosed by a dashed line in Fig. 15A. Note that enlarged sectional views illustrated in Fig. 16 and subsequent drawings correspond to the enlarged sectional view illustrated in Fig. 15B.

As illustrated in Fig. 16, the singulated compound semiconductor layer 300 is separated in plurality and the plurality of light-emitting elements 30 are formed. When one light-emitting element 30 is formed as one pixel, this step becomes a step of separating pixels from each other. The separation of the compound semiconductor layer 300 is performed by, for example, dry etching.

In this case, generally, a thickness of the second compound semiconductor layer 32 is thinner by around an order of magnitude as compared a thickness of the first compound semiconductor layer 31. Therefore, by separating the compound semiconductor layer 300 from the side of the second compound semiconductor layer 32, processing accuracy of the active layer 33 is improved.

As illustrated in Fig. 17, the first light-reflecting layer 301 is formed along a side surface of the light-emitting element 30 and the surface of the second compound semiconductor layer 32. The first light-reflecting layer 301 is formed on the surface of the second compound semiconductor layer 32 with the exception of a connecting portion with the plug wiring 36. Note that in reality, the first light-reflecting layer 301 is formed on the surface of the insulating layer 121.

As described earlier, the first light-reflecting layer 301 is formed in the same thickness using a chemical vapor deposition method or an atomic layer deposition method.

As illustrated in Fig. 18, an insulating layer 343 is formed in a periphery of the light-emitting element 30 including the first light-reflecting layer 301 and the light-emitting element 30 is embedded in the insulating layer 343. A surface of the insulating layer 343 is planarized by, for example, chemical mechanical polishing. For example, the insulating layer 343 is formed of a silicon oxide layer.

A connection hole (reference sign omitted) which reaches the surface of the second compound semiconductor layer 32 of the light-emitting element 30 from the surface of the insulating layer 343 is formed in the insulating layer 343 and the plug wiring 36 is formed in the connection hole (refer to Fig. 19). For the plug wiring 36, first, a connection hole is formed in the insulating layer 343 and a metal layer of the plug wiring 36 is formed inside of the connection hole and on the insulating layer 343. The metal layer is formed using, for example, a chemical vapor deposition method with favorable step coverage. In addition, by removing the metal layer on the insulating layer 343 using chemical mechanical polishing or the like, the metal layer in the connection hole is retained and the metal layer is formed as the plug wiring 36.

Next, the first light-absorbing layer 37 and the first light-shielding layer 38 are each sequentially formed on the plug wiring 36 and on the insulating layer 343 (refer to Fig. 19). After both the first light-absorbing layer 37 and the first light-shielding layer 38 are formed, etching is performed using a mask and the first light-absorbing layer 37 and the first light-shielding layer 38 are processed into predetermined shapes.

As illustrated in Fig. 19, an insulating layer 344 for embedding the first light-absorbing layer 37 and the first light-shielding layer 38 is formed and a surface of the insulating layer 344 is planarized. For example, the insulating layer 344 is formed of a silicon oxide layer.

As illustrated in Fig. 20, the first terminal 391 is formed in the peripheral region 8 on the insulating layer 344 and the second terminal 392 is formed in the element array region 7 in the same manufacturing step. Surfaces of the first terminal 391 and the second terminal 392 are exposed while peripheries of the first terminal 391 and the second terminal 392 are embedded by an insulating layer 345. The surface of the first terminal 391, the surface of the second terminal 392, and a surface of the insulating layer 345 are planarized by chemical mechanical polishing.

In this case, the insulating layers 341 to 345 constitute one insulating layer 34 and the light-emitting elements 30 arrayed in plurality and the insulating layer 34 formed in the periphery of the light-emitting elements 30 constitute the light-emitting element layer 3 (refer to Fig. 1). Once the light-emitting element layer 3 is formed, the light-emitting element layer 3 illustrated in Fig. 1 is substantially completed with the exception of the transparent electrode 311 and the reflection attenuation layer 312.

(2) Bonding method of light-emitting element layer 3 and driving circuit board 2 As illustrated in Fig. 21, the substrate 20 and the second supporting substrate 13 are arranged so as to oppose each other, the light-emitting element layer 3 is mounted on the driving circuit board 2, and the driving circuit board 2 and the light-emitting element layer 3 are bonded to each other.

In the driving circuit board 2, the drive circuit 21 is mounted to a principal surface portion of the substrate 20. Furthermore, in the driving circuit board 2, the wiring layer 24, the second light-shielding layer 26, the second light-absorbing layer 27, the first terminal 281, and the second terminal 282 are formed on the substrate 20. The bonding is performed in a state where the first terminal 391 of the light-emitting element layer 3 is electrically connected to the first terminal 281 of the driving circuit board 2 and the second terminal 392 of the light-emitting element layer 3 is electrically connected to the second terminal 282 of the driving circuit board 2.

### (3) Manufacturing step of transparent electrode 311 and reflection attenuation layer 312

The second supporting substrate 13 is removed (refer to Fig. 22). The removal of the second supporting substrate 13 is performed by, for example, grinding and wet etching.

Subsequently, as illustrated in Fig. 22, the insulating layer 342 of the insulating layer 34 is removed in the light-emitting element layer 3 and the surface of the first compound semiconductor layer 31 of the light-emitting element 30 is exposed. The removal of the insulating layer 342 is performed by, for example, dry etching or wet etching.

As illustrated in Fig. 23, the transparent electrode 311 is formed on the first compound semiconductor layer 31 of the plurality of light-emitting elements 30. As the transparent electrode 311, for example, indium tin oxide is formed using sputtering or a vapor deposition method and the formed indium tin oxide is processed into a predetermined shape by wet etching.

The insulating layer 346 is formed on the transparent electrode 311 (refer to Fig. 24). For example, the insulating layer 346 is formed of a silicon oxide layer. As illustrated in Fig. 24, an opening 346A is formed in the insulating layer 346 between the light-emitting elements 30 in the element array region 7. The opening 346Ais formed by, for example, etching.

As illustrated in Fig. 25, an opening 346B is formed from a surface of the insulating layer 346 to inside of the insulating layer 34 at a position corresponding to the first terminal 391 in the peripheral region 8. In the opening 346B, the surface of the first light-absorbing layer 37 on the first terminal 391 is exposed.

As illustrated in Fig. 26, the reflection attenuation layer 312 is formed on the insulating layer 346 between the light-emitting elements 30. The reflection attenuation layer 312 is electrically connected to the transparent electrode 311 via inside of the opening 346A.

Furthermore, the through wiring 313 is formed inside of the opening 346B in the peripheral region 8 in the same manufacturing step. In the manufacturing method described herein, the through wiring 313 is electrically connected to the second light-shielding layer 26 (which corresponds to the first terminal according to the present disclosure) which is exposed inside of the opening 346B.

For example, the reflection attenuation layer 312 and the through wiring 313 are formed by sputtering and processed into predetermined shapes by dry etching. The light-emitting element layer 3 bonded to the driving circuit board 2 is completed by the manufacturing steps thus far.

(4) Manufacturing step of color conversion layer 4, filter layer 5, and lens array 6 The partition wall 41 is formed between the light-emitting elements 30 of the light-emitting element layer 3 (Fig. 27). The partition wall 41 is formed by forming an insulating layer in an entire region on the light-emitting element layer 3 including the element array region 7 and the peripheral region 8 and removing the insulating layer on the light-emitting elements 30. For example, the insulating layer is formed of a silicon oxide layer and removal of the insulating layer is performed by dry etching.

As illustrated in Fig. 27, the second light-reflecting layer 401 is formed on a side surface of the partition wall 41. The second light-reflecting layer 401 is formed by a chemical vapor deposition method or an atomic layer deposition method with favorable step coverage. The second light-reflecting layer 401 which is also formed on the light-emitting elements 30 and the partition wall 41 is removed by etching-back.

Subsequently, the color conversion portion 40 is formed on the light-emitting elements 30 in a region where a periphery of side surfaces are enclosed by the partition wall 41. The color conversion portion 40 is formed on a resin material (refer to Fig. 28). In addition, a transparent resin layer 40Ais formed on the light-emitting elements 30 to become sub-pixels.

Once the color conversion portion 40 is formed, the color conversion layer 4 is completed.

Note that when the light-emitting apparatus 1 is constructed as a monochromatic light-emitting apparatus, the color conversion layer 4 is omitted.

As illustrated in Fig. 28, the filter 50 is formed on the color conversion portion 40. The filter 50 shields or absorbs a specific emission color. Once the filter 50 is formed, the filter layer 5 is completed.

The on-chip lens 60 is formed on the filter layer 5 (refer to Fig. 1). Once the on-chip lens 60 is formed, the lens array 6 is completed.

As illustrated in Fig. 1 described earlier, in the peripheral region 8, an opening 15 which reaches the external terminal 26P of the driving circuit board 2 from the lens array 6 is formed. The surface of the external terminal 26P is exposed in the opening 15.

Once the series of manufacturing steps described above ends, the method of manufacturing the light-emitting apparatus 1 according to the first embodiment ends and the light-emitting apparatus 1 is completed.

### [Operational effects]

In the light-emitting apparatus 1 according to the first embodiment, the laminated member 35 or, in other words, the compound semiconductor layer 300 has a polygonal shape of which at least a corner has been cut off in a linear shape or, preferably, a polygonal shape of which each corner has been cut off in a linear shape in a plan view. Accordingly, even if there is a mismatch in coefficients of thermal expansion (CTEs) between the growth substrate 10 and the compound semiconductor layer 300 when temperature rises or falls during a bonding process, stress concentration to the corners of the compound semiconductor layer 300 can be alleviated and an amount of warping of the compound semiconductor layer 300 can be reduced. Therefore, peeling or lifting of the compound semiconductor layer 300 from the first supporting substrate 12 can be suppressed and bonding can be held. Accordingly, when the compound semiconductor layer 300 is bonded or pasted to a substrate such as the driving circuit board 2 or the second supporting substrate 13 in a subsequent process, a failure such as peeling of the compound semiconductor layer 300 from the substrate can be prevented.

### [Modifications]

### (First modification)

As illustrated in Fig. 29A, the laminated member 35 may be a polygonal shape of which at least a corner has been bent into a convex shape or, preferably, a polygonal shape of which all corners have been bent into a convex shape in a plan view. The laminated member 35 may be a polygonal shape of which at least a corner has been bent into a convex shape and a polygonal shape of which at least a corner have been bent into a convex shape in a plan view. The laminated member 35 may be a polygonal shape of which a part of a plurality of corners has been bent into a convex shape the remaining corners have been bent into a convex shape in a plan view.

When the laminated member 35 is a polygonal shape of which at least a corner has been bent into a convex shape in a plan view, the bent portion with the convex shape may have an arc shape, an elliptical arc shape, or a polygonal arch shape. The polygonal shape of which at least a corner has been bent into a convex shape is, for example, a rounded polygonal shape such as a rounded rectangular shape.

The portion where a corner is bent in a convex shape is set back inward by a specified distance from the vertex of the corner 35A of a virtual polygonal shape.

The setback distance D preferably ranges from 10 µm or more and 4000 µm or less, more preferably ranges from 500 µm or more and 4000 µm or less, and even more preferably ranges from 1000 µm or more and 4000 µm or less. Definitions of the vertex of the corner 35A of a virtual polygonal shape and the setback distance D from the vertex of the corner 35A of the virtual polygonal shape are as described in the first embodiment.

As illustrated in Fig. 29B, the laminated member 35 may have an oval shape in a plan view. Examples of the oval shape include an oblong shape, an elliptical shape, and an egg shape.

### (Second modification)

Figs. 30A and 30B are each a plan view of an element formation region 30R in the light-emitting element layer 3. An element formation region 30R₁ is a region in which an array of a plurality of light-emitting elements 30 is formed. An element formation region 30R₂ is a region in which an array of a plurality of light-emitting elements 30 is not formed or a region in which a plurality of dummy light-emitting elements 30 are formed. The dummy light-emitting element 30 is, for example, a light-emitting element which is not electrically connected to the drive circuit 21 and which cannot be driven.

As illustrated in Fig. 30A, the element formation region 30R₁ may be formed in a part of the laminated member 35 in a plan view. The element formation region 30R₂ may be formed in a closed-loop shape on an outer side of the element formation region 30R in a plan view. As described above, the laminated member 35 is a laminate constituted of the transparent electrode 321 and the compound semiconductor layer 300 or a laminate constituted of the insulating layer 341, the transparent electrode 321, and the compound semiconductor layer 300.

As illustrated in Fig. 30B, the element formation region 30R₁ may be formed in the entire laminated member 35 in a plan view. In other words, element formation region 30R₂ need not be formed on the laminated member 35 in a plan view.

### (Third modification)

As illustrated in Fig. 31, the laminated member 35 (in other words, the compound semiconductor layer 300) may include a groove 35B provided along a peripheral edge of a first surface (a surface on an opposite side to the driving circuit board) of the laminated member 35. Due to the groove 35B formed in the laminated member 35 in this manner, when a crack or the like occurs in the insulating layer 34, the crack or the like can be prevented from developing inside of the laminated member 35. The groove 35B preferably has a closed loop shape in a plan view. While the groove 35B is preferably continuously provided along the peripheral edge of the first surface of the laminated member 35, the groove 35B may be discontinuously provided along the peripheral edge of the first surface of the laminated member 35.

### (Fourth modification)

While an example in which the plurality of light-emitting elements 30 are formed on the laminated member 35 has been described in the first embodiment, a single light-emitting element 30 may be formed on the laminated member 35.

While the light-emitting apparatus 1 has been described as an example of a laminate in the first embodiment, the laminate may be a light-receiving apparatus.

### <2 Second embodiment>

### [Configuration of light-emitting apparatus 1A]

As illustrated in Figs. 32A and 32B, a light-emitting apparatus 1A according to the second embodiment differs from the light-emitting apparatus 1 according to the first embodiment in that the light-emitting apparatus 1A includes a protective layer 351 and the laminated member 35 has a quadrangular shape (a shape of which corners have not been cut off) in a plan view. While an example in which the laminated member 35 has a quadrangular shape (a shape of which corners have not been cut off) in a plan view will be described in the present embodiment, the laminated member 35 in a plan view may have the shapes described in the first embodiment.

A plurality of light-emitting elements 30 positioned at an outermost periphery among a plurality of light-emitting elements 30 included in the laminated member 35 may be dummy light-emitting elements 30. Alternatively, a plurality of light-emitting elements 30 included in an outer peripheral region with a specified width among the plurality of light-emitting elements 30 included in the laminated member 35 may be dummy light-emitting elements 30. The dummy light-emitting element 30 is, for example, a light-emitting element which is not electrically connected to the drive circuit 21 and which cannot be driven.

The protective layer 351 covers a side wall of the laminated member 35 and also covers a peripheral edge portion of the first surface of the laminated member 35. In this case, the peripheral edge portion of the first surface (a surface on an opposite side to the driving circuit board 2) of the laminated member 35 refers to a region with a predetermined width from the peripheral edge toward the inside of the first surface of the laminated member 35. The protective layer 351 may cover the side surface of the transparent electrode 321. The protective layer 351 has a wall shape.

More specifically, the protective layer 351 covers an outer side surface of the plurality of light-emitting elements 30 positioned at an outermost periphery among the plurality of light-emitting elements 30. In this case, the outer side surface of the light-emitting elements 30 represent side surfaces constituting the side wall of the laminated member 35.

As illustrated in Fig. 33, the protective layer 351 has a closed loop shape in a plan view. In this case, a plan view represents viewing the laminated member 35 from the arrow Z direction (in other words, a direction perpendicular to the first surface (light-emitting surface) of the laminated member 35). While a width of the protective layer 351 in a thickness direction (arrow Z direction) of the laminated member 35 may be the same as a height of the side surface of the laminated member 35 or may be narrower than the height of the side surface of the laminated member 35, the former is preferable from the perspective of suppressing warping of the laminated member 35.

For example, the protective layer 351 includes an inorganic material such as a metal, a metal oxide, or a metal nitride. More specifically, for example, the protective layer 351 includes Ti, W, SiO₂, SiN, or Al₂O₃. The protective layer 351 may be a layer formed by an atomic layer deposition method. In other words, the protective layer 351 may be a layer constituted of a deposited monolayer.

The protective layer 351 includes a first protective layer which covers the side surface of the laminated member 35 and a second protective layer which covers a peripheral edge portion of the second surface of the laminated member 35. The first protective layer and the second protective layer are constituted of the same material. The first protective layer can prevent microcracks from developing. The second protective layer can prevent the compound semiconductor layer 300 from being peeled off from the first supporting substrate 12.

### [Method of manufacturing light-emitting apparatus 1A]

A method of manufacturing the light-emitting apparatus 1A according to the second embodiment is similar to the method of manufacturing the light-emitting apparatus 1 according to the first embodiment with respect to manufacturing steps other than (1) manufacturing step of light-emitting element layer 3. Therefore, hereinafter, only (1) manufacturing step of light-emitting element layer 3 will be described with reference to Figs. 34 to 36.

### (1) Method of manufacturing light-emitting element layer 3

First, after the compound semiconductor layer 300, the transparent electrode 321, and the insulating layer 341 are sequentially laminated on the growth substrate 10 in a similar manner to (1) method of manufacturing light-emitting element layer 3 according to the first embodiment, a pattern of the specified groove 300A is formed in the compound semiconductor layer 300, the transparent electrode 321, and the insulating layer 341 (refer to Figs. 7 to 8).

Next, the groove 300A is also formed on the surface of the growth substrate 10 described above by, for example, isotropic etching (refer to Fig. 34A). Due to erosion by the isotropic etching, a width of the groove 300A of the surface of the growth substrate 10 becomes wider than a width of the groove 300A of the compound semiconductor layer 300, the transparent electrode 321, and the insulating layer 341. Subsequently, a mask of a photoresist is peeled off (refer to Fig. 34A).

Next, the protective layer 351 is formed on the insulating layer 341 so as to follow the groove 300A by, for example, an atomic deposition method or a vapor deposition method (refer to Fig. 34B). Next, the protective layer 351 in bottom portions of the insulating layer 341 and the groove 300A is removed (refer to Fig. 34C). In doing so, in the protective layer 351 in the bottom portion of the groove 300A, the protective layer 351 having intruded below the laminated member 35 is not removed and remains. Accordingly, the protective layer 351 which covers the side surface of the laminated member 35 and which covers the peripheral edge portion of the first surface of the laminated member 35 is obtained.

Next, the insulating layer 341 is arranged so as to oppose the dicing tape 11 and, in a state where the growth substrate 10 is inverted, the growth substrate 10 and the laminated member 35 are glued to the dicing tape 11 (refer to Fig. 35A). Next, dicing is performed and the growth substrate 10 is singulated.

Next, the growth substrate 10 and the laminated member 35 which have been singulated are bonded to the first bonding surface 12A of the first supporting substrate 12 (refer to Fig. 35B). The bonding is performed by arranging the insulating layer 341 and the first bonding surface 12A of the first supporting substrate 12 so as to oppose each other. Next, the growth substrate 10 is removed by, for example, laser liftoff (refer to Fig. 36A). The protective layer 351 obtained as described above includes an opening on the first surface of the laminated member 35 as illustrated in Fig. 36B.

A series of subsequent manufacturing steps is implemented in a similar manner to (1) method of manufacturing light-emitting element layer 3 according to the first embodiment.

### [Operational effects]

When the protective layer 351 is not provided on the side surface of the laminated member 35, the compound semiconductor layer 300 may peel off from the first supporting substrate 12 as will be described below.

When the compound semiconductor layer 300 is formed on the growth substrate 10, although the growth substrate 10 and the compound semiconductor layer 300 are subjected to a high temperature, since a CTE (coefficient of thermal expansion) of the compound semiconductor layer 300 is smaller than that of the growth substrate 10, compressive stress remains in the compound semiconductor layer 300.

After the growth substrate 10 on which the compound semiconductor layer 300 is formed is bonded to the first bonding surface 12A of the first supporting substrate 12, the compound semiconductor layer 300 may peel off from the first supporting substrate 12 in a process of removing the growth substrate 10. While it is speculated that the compressive stress of the compound semiconductor layer 300 has been released by removing the growth substrate 10, development of cracks due to microcracks on the side surface of the compound semiconductor layer 300 as an origin of peeling is also a possible factor.

Note that due to the removal of the growth substrate 10, a side of the first surface (a side of a surface from which the growth substrate 10 has been removed) of the compound semiconductor layer 300 is subjected to tensile stress while a side of the second surface (a side of a surface bonded to the first supporting substrate 12) of the compound semiconductor layer 300 is subjected to compressive stress, and a load due to a difference between stresses inside of the compound semiconductor layer 300 and a force in a peeling direction due to warping of the compound semiconductor layer 300 are also applied.

In the second embodiment, since the protective layer 351 covers the side surface of the laminated member 35 and the peripheral edge portion of the first surface of the laminated member 35, a development of cracks attributable to microcracks and peeling of films as described above can be suppressed.

### [Modifications]

### (First modification)

While an example in which the protective layer 351 has a closed loop shape in a plan view has been described in the second embodiment, the protective layer 351 is not limited to this example. For example, as illustrated in Fig. 37A, the protective layer 351 may only be provided at each corner of the laminated member 35. Alternatively, as illustrated in Fig. 37B, the protective layer 351 may be discontinuously provided in a peripheral direction of the peripheral edge portion of the laminated member 35.

### (Second modification)

As illustrated in Fig. 38, the protective layer 351 may only cover the side wall of the laminated member 35. Such a protective layer 351 can be formed as follows.

First, a series of manufacturing steps from a forming step in which the compound semiconductor layer 300 is formed on the growth substrate 10 to a step in which the growth substrate 10 and the laminated member 35 are singulated is implemented in a similar manner to (1) method of manufacturing light-emitting element layer 3 according to the first embodiment (refer to Figs. 7 to 11).

Next, the growth substrate 10 and the laminated member 35 having been singulated are bonded to the first bonding surface 12A of the first supporting substrate 12 (refer to Fig. 39A). The bonding is performed by arranging the insulating layer 341 and the first bonding surface 12A of the first supporting substrate 12 so as to oppose each other.

Next, the protective layer 351 is formed on the first supporting substrate 12 by, for example, an atomic layer deposition (ALD) method so as to follow the growth substrate 10 and the laminated member 35 having been singulated (refer to Fig. 39B). Next, the protective layer 351 is removed from the first surface of the laminated member 35 by, for example, etching-back (refer to Fig. 40A). Next, the growth substrate 10 is removed by, for example, laser liftoff or polishing (refer to Fig. 40B). Accordingly, the protective layer 351 which only covers the side wall of the laminated member 35 is formed.

### (Third modification)

While an example in which, after the growth substrate 10 and the laminated member 35 having been singulated are bonded to the first bonding surface 12A of the first supporting substrate 12, the growth substrate 10 is removed by laser liftoff (refer to Figs. 35B and 36A) has been described in the second embodiment, a method of removal of the growth substrate 10 is not limited thereto. For example, as illustrated in Fig. 41A, after the growth substrate 10 and the laminated member 35 having been singulated are bonded to the first bonding surface 12A of the first supporting substrate 12, the growth substrate 10 may be removed by polishing such as chemical mechanical polishing (CMP) (refer to Figs. 41A and 41B).

### (Fourth modification)

In the second embodiment, after the growth substrate 10 and the laminated member 35 having been singulated are bonded to the first bonding surface 12A of the first supporting substrate 12, a peripheral edge portion of the first surface (a surface on the side of the compound semiconductor layer 200) of the growth substrate 10 may be ground to form a gap between the protective layer 351 on the first surface of the laminated member 35 and the growth substrate 10 (refer to Fig. 42A). After forming the gap, the growth substrate 10 may be removed by laser liftoff (refer to Fig. 42B). Accordingly, even when a compound semiconductor such as GaN is broken down by the laser liftoff and a gas such as nitrogen is created, the gas such as nitrogen can be released to the outside via the gap.

### <3 Third embodiment>

### [Configuration of light-emitting apparatus 1B]

As illustrated in Figs. 43 and 44, a light-emitting apparatus 1B according to the third embodiment differs from the light-emitting apparatus 1A according to the second embodiment in that the light-emitting apparatus 1B includes a protective layer 352 instead of the protective layer 351 (refer to Fig. 32) and further includes an adhesive layer 353.

The protective layer 352 covers the side wall of the laminated member 35 and covers the peripheral edge portion of a second surface (a surface on the side of the driving circuit board 2) of the laminated member 35. In this case, the peripheral edge portion of the second surface of the laminated member 35 refers to a region having a predetermined width toward the inner side from the peripheral edge of the second surface of the laminated member 35. The protective layer 352 may cover side surfaces of the transparent electrode 321 and the insulating layer 341.

More specifically, the protective layer 352 covers outer side surfaces of a plurality of light-emitting elements 30 positioned at an outermost periphery among the plurality of the light-emitting elements 30 and covers outer peripheral edge portions of the second surfaces of the plurality of light-emitting elements 30. In this case, the outer side surface of the light-emitting element 30 refers to a portion constituting the side wall of the laminated member 35 in the side surface of the light-emitting element 30. The outer peripheral edge portion of the second surface of the light-emitting element 30 refers to a portion constituting the peripheral edge portion of the second surface of the laminated member 35 in the second surface of the light-emitting element 30.

The protective layer 352 may be the same as the protective layer 351 according to the second embodiment except for the above.

The adhesive layer 353 is provided on the second surface of the laminated member 35. The adhesive layer 353 is used to bond the laminated member 35 to the first bonding surface 12A of the first supporting substrate 12 in a manufacturing step of the light-emitting apparatus 1B.

### [Method of manufacturing light-emitting apparatus 1B]

A method of manufacturing the light-emitting apparatus 1B according to the third embodiment is similar to the method of manufacturing the light-emitting apparatus 1 according to the first embodiment with respect to manufacturing steps other than (1) manufacturing step of light-emitting element layer 3. Therefore, hereinafter, only (1) manufacturing step of light-emitting element layer 3 will be described with reference to Figs. 45 and 46.

### (1) Method of manufacturing light-emitting element layer 3

First, a series of manufacturing steps from a forming step in which the compound semiconductor layer 300 is formed on the growth substrate 10 to a step in which the growth substrate 10, the compound semiconductor layer 300, the transparent electrode 321, and the insulating layer 341 are diced is implemented in a similar manner to (1) method of manufacturing light-emitting element layer 3 according to the first embodiment (refer to Figs. 7 to 11).

Next, the growth substrate 10 and the laminated member 35 having been singulated are bonded by the adhesive layer 353 to the first bonding surface 12A of the first supporting substrate 12 (refer to Fig. 45A). The bonding is performed by arranging the insulating layer 341 and the first bonding surface 12A of the first supporting substrate 12 so as to oppose each other.

Next, a peripheral edge portion of the adhesive layer 353 is removed by, for example, ashing. Accordingly, a side surface position of the adhesive layer 353 is set back inward from the position of the side surface of the insulating layer 341 and a gap is formed between the peripheral edge portion of the first surface of the insulating layer 341 and the first bonding surface 12A of the first supporting substrate 12 (refer to Fig. 45B).

Next, the protective layer 351 is formed on the insulating layer 341 so as to follow the groove 300A by, for example, an atomic deposition method or a vapor deposition method (refer to Fig. 46A). Next, the growth substrate 10 is peeled off from the compound semiconductor layer 300 by, for example, laser liftoff (refer to Fig. 46B).

A series of subsequent manufacturing steps is implemented in a similar manner to (1) method of manufacturing light-emitting element layer 3 according to the first embodiment.

### [Effects]

When the protective layer 352 is not provided on the side surface of the laminated member 35, cracks or the like may occur in the laminated member 35 as will be described later.

After the growth substrate 10 and the laminated member having been singulated are bonded to the first bonding surface 12A of the first supporting substrate 12, the growth substrate 10 is peeled off from the laminated member 35 by laser liftoff. In doing so, peeling (lifting) due to stress on an edge of the laminated member 35 may occur on a bonding surface and, due to the laminated member 35 being unable to retain its shape, cracks or the like may occur in the laminated member 35.

In the third embodiment, the side surface of the laminated member 35 is covered by the protective layer 352 before the growth substrate 10 is peeled off from the laminated member 35. Accordingly, peeling (lifting) due to stress on an edge of the laminated member 35 can be suppressed. Therefore, the shape of the laminated member 35 can be retained and an occurrence of cracks or the like in the laminated member 35 can be suppressed.

In a forming step of the protective layer 352, warping of the laminated member 35 or the like may prevent the peripheral edge portion of the second surface of the laminated member 35 from being glued to the first bonding surface 12A of the first supporting substrate 12 and lifting of the peripheral edge portion of the second surface of the laminated member 35 from the first bonding surface 12A of the first supporting substrate 12 may occur. In this case, as illustrated in Fig. 47B, a gap created by the lifting described above may be filled with the protective layer 352. Therefore, adhesion between the laminated member 35 and the first supporting substrate 12 can be improved.

A portion in which a gap is filled as described above may remain as a part of the protective layer 352 as illustrated in Fig. 47A in a state where the laminated member 35 described above is incorporated into the light-emitting apparatus 1B as the light-emitting element 30.

### [Modifications]

### (First modification)

In the forming step of the protective layer 352, a void may be formed between the protective layer 352 and the side surface of the adhesive layer 353 as illustrated in Figs. 48B and 49B. In this case, a gap (refer to Fig. 48A) or a void (refer to Fig. 49A) may be formed between the protective layer 352 and the adhesive layer 353 on the second surface of the laminated member 35 in a state where the laminated member 35 is incorporated into the light-emitting apparatus 1B as the light-emitting element 30.

### (Second modification)

While an example in which the laminated member 35 is bonded via the adhesive layer 353 to the first bonding surface 12A of the first supporting substrate 12 (refer to Fig. 40) has been described in the third embodiment, as illustrated in Fig. 50B, the laminated member 35 may be directly bonded to the first bonding surface 12A of the first supporting substrate 12. In this case, the protective layer 352 may cover the peripheral edge portion of the second surface of the transparent electrode 321 as illustrated in Fig. 50A in a state where the laminated member 35 is incorporated into the light-emitting apparatus 1B as the light-emitting element 30.

When the laminated member 35 is directly bonded to the first bonding surface 12A of the first supporting substrate 12 as described above, a void may be formed between the protective layer 352 and the side surface of the insulating layer 341 as illustrated in Figs. 51B and 52B in the forming step of the protective layer 352. In this case, a gap (refer to Fig. 51A) or a void (refer to Fig. 52A) may be formed between the protective layer 352 and the insulating layer 341 on the second surface of the laminated member 35 in a state where the laminated member is incorporated into the light-emitting apparatus 1B as the light-emitting element 30.

### <4 Fourth embodiment>

### [Configuration of light-emitting apparatus 1C]

As illustrated in Figs. 53A and 53B, a light-emitting apparatus 1C according to the third embodiment differs from the light-emitting apparatus 1 according to the first embodiment in that the laminated member 35 includes an extended portion 354 and the laminated member 35 has a quadrangular shape (a shape of which corners have not been cut off) in a plan view. While an example in which the laminated member 35 has a quadrangular shape (a shape of which corners have not been cut off) in a plan view will be described in the present embodiment, the laminated member 35 in a plan view may have the shapes described in the first embodiment.

The extended portion 354 extends from a lower end portion of the side surface (a side surface end portion on the side of the driving circuit board 2) of the laminated member 35 made up of the compound semiconductor layer 300, the transparent electrode 321, and the insulating layer 341 in in-plane directions of the laminated member 35 (the arrow X direction and the arrow Y direction) or, in other words, a direction perpendicular to the side surface of the laminated member 35.

The extended portion 354 uniformly protrudes from the lower end portion of the side surface of the laminated member 35 and has a flange shape. As illustrated in Fig. 54, the extended portion 354 has a closed loop shape in a plan view. However, the extended portion 354 may be discontinuously provided in a periphery of the laminated member 35 in a plan view. For example, the extended portion 354 may be selectively provided in corner portions or side portions of the laminated member 35.

The extended portion 354 includes a first extended portion which is extended from the compound semiconductor layer 300 and a second extended portion which is extended from the transparent electrode 321. The extended portion 354 may further include a third extended portion which is extended from the insulating layer 341.

A thickness of the first extended portion is thinner than a thickness of the compound semiconductor layer 300 in the laminated member 35. The first extended portion is constituted of the same material as the compound semiconductor layer 300. In other words, the first extended portion is constituted of a compound semiconductor layer. A thickness of the second extended portion is approximately the same as a thickness of the transparent electrode 321 in the laminated member 35. The second extended portion is constituted of the same material as the transparent electrode 321. In other words, the second extended portion is constituted of a transparent electrode.

### [Method of manufacturing light-emitting apparatus 1C]

A method of manufacturing the light-emitting apparatus 1B according to the fourth embodiment is similar to the method of manufacturing the light-emitting apparatus 1 according to the first embodiment with respect to manufacturing steps other than (1) manufacturing step of light-emitting element layer 3. Therefore, hereinafter, only (1) manufacturing step of light-emitting element layer 3 will be described with reference to Figs. 55 to 59.

### (1) Method of manufacturing light-emitting element layer 3

First, photoresist patterning by lithography is performed and a specified mask 354A is formed on the growth substrate 10 (refer to Figs. 55A and 55B). Fig. 55B is a diagram which enlarges a part of Fig. 55A. Figs. 56 to 59 for describing the following steps are enlarged views corresponding to Fig. 55B.

Next, the surface of the growth substrate 10 is etched through the mask 354A. Accordingly, a pattern of a specified concave portion 10B is formed on the surface of the growth substrate 10 (refer to Fig. 56A). Next, after the mask 354Ais peeled off (refer to Fig. 56B), the compound semiconductor layer 300 is formed on the surface of the growth substrate 10 by, for example, epitaxial growth (refer to Fig. 56C). Next, photoresist patterning by lithography is performed and a specified mask 354B is formed in a portion corresponding to the concave portion 10B (refer to Fig. 56D). Next, the compound semiconductor layer 300 is etched through the mask 354B and the compound semiconductor layer 300 in portions other than the concave portion 10B is removed (refer to Fig. 57A). Next, the mask 354B is peeled off from the compound semiconductor layer 300 (refer to Fig. 57B). Next, the compound semiconductor layer 300 constituting the extended portion 354 (liftoff compound semiconductor layer 300) is formed by, for example, epitaxial growth (refer to Fig. 57C).

Next, the transparent electrode 321 is formed on the compound semiconductor layer 300 and the extended portion 354 by, for example, sputtering or a vapor deposition method (refer to Fig. 57D). Next, the insulating layer 341 is formed on the transparent electrode 321 by, for example, sputtering or a vapor deposition method (refer to Fig. 58A). Next, the insulating layer 341 is thinned by, for example, chemical mechanical polishing (CMP) and the surface of the insulating layer 341 is planarized (refer to Fig. 58B). Next, dicing is performed and the growth substrate 10 and the laminated member 35 are singulated (refer to Fig. 58C).

Next, the growth substrate 10 and the laminated member 35 which have been singulated are bonded to the first bonding surface 12A of the first supporting substrate 12 (refer to Fig. 59A). The bonding is performed by arranging the insulating layer 341 and the first bonding surface 12A of the first supporting substrate 12 so as to oppose each other, subsequently raising the temperature while applying a load, and causing covalent bonding to occur at the interface due to a dehydration condensation reaction. Accordingly, bonding strength is secured. Next, the compound semiconductor layer 300 and the extended portion 354 are irradiated with laser light L from the side of the growth substrate 10 and a compound semiconductor included in the first surface of the compound semiconductor layer 300 is decomposed (refer to Fig. 59B). For example, when the compound semiconductor layer includes GaN, GaN is broken down into Ga and N by the irradiation of the laser light. Next, the growth substrate 10 is peeled off from the compound semiconductor layer 300 and the extended portion 354 (refer to Fig. 59C).

A series of subsequent manufacturing steps is implemented in a similar manner to (1) method of manufacturing light-emitting element layer 3 according to the first embodiment.

### [Operational effects]

When the concave portion 10B described above is not formed on the growth substrate 10, warping may occur in the laminated member 35 as will be described later.

In the step where the singulated laminated member 35 is bonded to the first bonding surface 12A of the first supporting substrate 12, the bonding is performed by arranging the insulating layer 341 and the first bonding surface 12A of the first supporting substrate 12 so as to oppose each other, subsequently raising the temperature while applying a load, and causing covalent bonding to occur at the interface due to a dehydration condensation reaction and, accordingly, bonding strength may be secured. However, when warping of the singulated laminated member 35 is large, there is a risk that the peripheral edge portion of the laminated member 35 may be lifted from the first supporting substrate 12 and may cause a problem such as peeling in a subsequent process.

In the fourth embodiment, since the concave portion 10B is formed on the surface of the growth substrate 10, warping of the laminated member 35 can be suppressed in the step where the singulated laminated member 35 is bonded to the first bonding surface 12A of the first supporting substrate 12. Therefore, an occurrence of a problem such as peeling in a subsequent process can be prevented.

Since the extended portion 354 which functions as a peeling layer is provided on the side wall of the laminated member 35, development of cracks in the laminated member 35 can be suppressed when the growth substrate 10 is peeled off from the laminated member 35. Stress concentration with respect to the peripheral edge portion of the laminated member 35 can be alleviated.

### [Modifications]

### (First modification)

The method of manufacturing the light-emitting element layer 3 is not limited to the manufacturing method described in the fourth embodiment. For example, the following manufacturing method may be adopted.

First, a series of manufacturing steps from the step of forming the specified mask 354A on the growth substrate 10 to the step of peeling off the mask 354A is implemented in a similar manner to (1) method of manufacturing light-emitting element layer 3 according to the fourth embodiment (refer to Figs. 55A, 55B, 56A, and 56B).

Next, the compound semiconductor layer 300 is formed on the surface of the growth substrate 10 by, for example, epitaxial growth (refer to Fig. 60A). Next, the compound semiconductor layer 300 in portions other than the concave portion 10B is removed by, for example, chemical mechanical polishing (CMP) (refer to Fig. 60B). Subsequently, a series of manufacturing steps from the forming step of the extended portion 354 (liftoff compound semiconductor layer 300) is implemented in a similar manner to (1) method of manufacturing light-emitting element layer 3 according to the fourth embodiment.

### (Second modification)

While an example in which the extended portion 354 includes the first extended portion which is extended from the compound semiconductor layer 300 and the second extended portion which is extended from the transparent electrode 321 (refer to Figs. 53A and 53B) has been described in the fourth embodiment, a configuration of the extended portion 354 is not limited to this example.

The extended portion 354 may only include the first extended portion which is extended from the compound semiconductor layer 300. Alternatively, as illustrated in Fig. 61A, the extended portion 354 may include the first extended portion which is extended from the compound semiconductor layer 300 and the third extended portion which is extended from the insulating layer 341. The extended portion configured as described above is obtained by, for example, forming the transparent electrode 321 only at locations corresponding to the concave portion 10B of the growth substrate 10 (refer to Fig. 61B).

The first extended portion which is extended from the compound semiconductor layer 300 may be provided at the same height as the transparent electrode 321 (refer to Fig. 62A). The extended portion configured as described above is obtained by, for example, adjusting a thickness of the compound semiconductor layer 300 to be the same as a depth of the concave portion 10B of the growth substrate 10 (refer to Fig. 62B).

### (Third modification)

While an example in which the laminated member 35 has a quadrangular shape in a plan view has been described in the fourth embodiment, the shape of the laminated member 35 in a plan view is not limited thereto. For example, the shape of the laminated member 35 in a plan view may be an oval shape such as an elliptical shape (refer to Fig. 63A), a polygonal shape such as a hexagonal shape (refer to Fig. 63B), or a polygonal shape such as a quadrangular shape of which each corner has been bent into a convex shape (refer to Fig. 63C).

### <5 Fifth embodiment>

### [Configuration of light-emitting apparatus 1D]

As illustrated in Figs. 64A and 64B, a light-emitting apparatus 1D according to a fifth embodiment differs from the light-emitting apparatus 1 according to the first embodiment in that the light-emitting apparatus 1D includes a reinforcing layer 355 and the laminated member 35 has a quadrangular shape (a shape of which corners have not been cut off) in a plan view. While an example in which the laminated member 35 has a quadrangular shape (a shape of which corners have not been cut off) in a plan view will be described in the present embodiment, the laminated member 35 in a plan view may have the shapes described in the first embodiment.

The reinforcing layer 355 may be similar to the protective layer 351 according to the second modification of the second embodiment with the exception of a formation process thereof.

### [Method of manufacturing light-emitting apparatus 1D]

A method of manufacturing the light-emitting apparatus 1D according to the fifth embodiment is similar to the method of manufacturing the light-emitting apparatus 1 according to the first embodiment with respect to manufacturing steps other than (1) manufacturing step of light-emitting element layer 3. Therefore, hereinafter, only (1) manufacturing step of light-emitting element layer 3 will be described with reference to Figs. 65 and 66.

### (1) Method of manufacturing light-emitting element layer 3

First, a series of manufacturing steps from a step in which the compound semiconductor layer 300 is formed on the growth substrate 10 to a step in which a pattern of the specified groove 300A is formed on the compound semiconductor layer 300, the transparent electrode 321, and the insulating layer 341 is implemented in a similar manner to (1) method of manufacturing light-emitting element layer 3 according to the first embodiment (refer to Figs. 7 and 8).

Next, the reinforcing layer 355 is formed on the growth substrate 10 so as to fill the groove 300A by, for example, sputtering or a vapor deposition method (refer to Fig. 65A). Next, the reinforcing layer 355 other than the groove 300A is removed by, for example, chemical mechanical polishing (CMP) and the transparent electrode 321 is exposed (refer to Fig. 65B). Next, dicing is performed and the growth substrate 10, the laminated member 35, and the reinforcing layer 355 are singulated (refer to Fig. 65C).

Next, the growth substrate 10, the laminated member 35, and the reinforcing layer 355 which have been singulated are bonded to the first bonding surface 12A of the first supporting substrate 12 (refer to Fig. 65D). The bonding is performed by arranging the insulating layer 341 and the first bonding surface 12A of the first supporting substrate 12 so as to oppose each other, subsequently raising the temperature while applying a load, and causing covalent bonding to occur at the interface due to a dehydration condensation reaction. Accordingly, bonding strength is secured. Next, the growth substrate 10 is peeled off from the compound semiconductor layer 300 by, for example, laser liftoff (refer to Fig. 66A).

Next, the insulating layer 342 for embedding the laminated member 35 and the reinforcing layer 355 which have been singulated is formed on the first supporting substrate 12 (refer to Fig. 66B). The insulating layer 342 is formed by, for example, a silicon oxide layer. After the silicon oxide layer is formed, a surface thereof is subjected to planarization (refer to Fig. 66C). For the planarization, for example, chemical mechanical polishing (CMP) is used.

A series of subsequent manufacturing steps is implemented in a similar manner to (1) method of manufacturing light-emitting element layer 3 according to the first embodiment.

### [Operational effects]

When the reinforcing layer 355 is not provided on the side surface of the laminated member 35, peeling may occur in the laminated member 35 as will be described later.

In the step where the growth substrate 10 and the laminated member 35 which have been singulated are bonded to the first bonding surface 12A of the first supporting substrate 12, the bonding is performed by arranging the insulating layer 341 and the first bonding surface 12A of the first supporting substrate 12 so as to oppose each other, subsequently raising the temperature while applying a load, and causing covalent bonding to occur at the interface due to a dehydration condensation reaction and, accordingly, bonding strength may be secured. However, microcracks may occur in end portions of the laminated member 35 and on the first surface (upper surface) of the laminated member 35 during singulation of the growth substrate 10 and the laminated member 35 to be bonded or during thinning of the growth substrate 10 and the laminated member 35 after being bonded to the first bonding surface 12A of the first supporting substrate 12. In this case, the laminated member 35 may no longer be able to withstand tensile stress created in a vicinity of the end portions of the laminated member 35 and cracking or peeling of the laminated member 35 may occur.

In the fifth embodiment, by forming the reinforcing layer 355 before singulation of the growth substrate 10 and the laminated member 35 or before thinning (for example, laser liftoff) of the growth substrate 10 and the laminated member 35, an occurrence of peeling of the laminated member 35 can be suppressed and thinning of the laminated member 35 can be realized.

### [Modifications]

### (First modification)

As illustrated in Fig. 67, the reinforcing layer 355 may cover the second surface (the surface on the side of the driving circuit board 2) of the laminated member 35. In other words, the reinforcing layer 355 may cover the second surface (the surface on the side of the driving circuit board 2) of each of the light-emitting elements 30 (including dummy light-emitting elements) constituted of the laminated member 35.

For example, the reinforcing layer 355 configured as described above is formed as described below.

First, a series of manufacturing steps from a step in which the compound semiconductor layer 300 is formed on the growth substrate 10 to a step in which the reinforcing layer 355 is formed on the growth substrate 10 is implemented in a similar manner to (1) method of manufacturing light-emitting element layer 3 according to the fifth embodiment (refer to Figs. 7, 8, and 65A).

Next, the reinforcing layer 355 is formed on the growth substrate 10 so as to fill the groove 300A by, for example, sputtering or a vapor deposition method (refer to Fig. 68A). Next, the reinforcing layer 355 is thinned so that the reinforcing layer 355 remains on the transparent electrode 321 by, for example, chemical mechanical polishing (CMP) and a surface of the reinforcing layer 355 is planarized (refer to Fig. 68B). A series of subsequent manufacturing steps is implemented in a similar manner to (1) method of manufacturing light-emitting element layer 3 according to the fifth embodiment as illustrated in Figs. 68C, 68D, 69A, 69B, and 69C.

### (Second modification)

As illustrated in Fig. 70, the reinforcing layer 355 may uniformly protrude from a lower end portion of the side surface of the laminated member 35 and may include a flange-shaped extended portion. The extended portion may have a closed loop shape in a plan view.

For example, the reinforcing layer 355 configured as described above is formed as described below.

First, a series of manufacturing steps from a forming step in which the compound semiconductor layer 300 is formed on the growth substrate 10 to a step in which the growth substrate 10 and the laminated member 35 are bonded to the first bonding surface 12A of the first supporting substrate 12 is implemented in a similar manner to (1) method of manufacturing light-emitting element layer 3 according to the first embodiment (refer to Figs. 7 to 11).

Next, the reinforcing layer 355 is formed on the first supporting substrate 12 so as to cover the growth substrate 10 and the laminated member 35 by, for example, a chemical vapor deposition (CVD) method or an atomic layer deposition (ALD) method (refer to Fig. 71A). A series of subsequent manufacturing steps is implemented in a similar manner to (1) method of manufacturing light-emitting element layer 3 according to the fifth embodiment as illustrated in Figs. 71B, 71C, and 71D.

### (Third modification)

As illustrated in Figs. 72, 73, and 74, a passivation layer 356 may be provided between the reinforcing layer 355 and the compound semiconductor layer 300.

### <6 Sixth embodiment>

### [Configuration of light-emitting apparatus 1E]

As illustrated in Fig. 75, a light-emitting apparatus 1E according to a sixth embodiment differs from the light-emitting apparatus 1 according to the first embodiment in that the light-emitting apparatus 1E includes a reinforcing member 357 and the laminated member 35 has a quadrangular shape (a shape of which corners have not been cut off) in a plan view. While an example in which the laminated member 35 has a quadrangular shape (a shape of which corners have not been cut off) in a plan view will be described in the present embodiment, the laminated member 35 in a plan view may have the shapes described in the first embodiment.

The compound semiconductor layer 300 includes the first surface on an opposite side to the driving circuit board 2 and the second surface on the side of the driving circuit board 2. The reinforcing member 357 is provided in a peripheral edge portion of the first surface of the compound semiconductor layer 300. In this case, the peripheral edge portion of the first surface of the laminated member 35 refers to a region with a predetermined width from the peripheral edge toward the inside of the first surface of the laminated member 35. The reinforcing member 357 is capable of reinforcing the peripheral edge portion of the first surface of the compound semiconductor layer 300. For example, the reinforcing member 357 can suppress warping, expansion and contraction, and the like of the compound semiconductor layer 300.

As illustrated in Fig. 76A, the reinforcing member 357 has a closed loop shape in a plan view. The reinforcing member 357 has a uniform width in a plan view. As illustrated in Fig. 76B, the reinforcing member 357 has a rectangular shape in a sectional view. A first surface of the reinforcing member 357 is flush with the first surface of the laminated member 35 (specifically, the compound semiconductor layer 300). A side surface of the reinforcing member 357 is flush with the side surface of the laminated member 35 (specifically, the compound semiconductor layer 300). The reinforcing member 357 may include a similar material to the growth substrate 10. Specifically, for example, the reinforcing member 357 may include sapphire or silicon.

The first surface of the compound semiconductor layer 300 includes a third surface on which the reinforcing member 357 is provided and a fourth surface on which the reinforcing member 357 is not provided. A height of the third surface relative to the driving circuit board 2 is lower than a height of the fourth surface relative to the driving circuit board 2.

### [Method of manufacturing light-emitting apparatus 1E]

A method of manufacturing the light-emitting apparatus 1E according to the sixth embodiment is similar to the method of manufacturing the light-emitting apparatus 1 according to the first embodiment with respect to manufacturing steps other than (1) manufacturing step of light-emitting element layer 3. Therefore, hereinafter, only (1) manufacturing step of light-emitting element layer 3 will be described with reference to Figs. 77 and 78.

### (1) Method of manufacturing light-emitting element layer 3

First, a plurality of grooves 10A are formed by patterning the surface of the growth substrate 10 using, for example, a photolithographic technique and an etching technique (refer to Fig. 77A). The grooves 10A have the same shape as an opening of the reinforcing member 357 with a closed loop shape in a plan view.

Next, the compound semiconductor layer 300 is formed on the surface of the growth substrate 10 by, for example, epitaxial growth. In doing so, a plurality of convex portions are formed on the first surface of the compound semiconductor layer 300 due to the grooves 10A. Next, the transparent electrode 321 is formed on the compound semiconductor layer 300 by, for example, sputtering or a vapor deposition method (refer to Fig. 77B). Next, the insulating layer 341 may be formed on the transparent electrode 321 by, for example, sputtering or a vapor deposition method. Hereinafter, a case where the insulating layer 341 is not formed on the transparent electrode 321 will be described as an example.

Next, the growth substrate 10 and the laminated member 35 are diced and the growth substrate 10 and the laminated member 35 which have been singulated are formed (refer to Fig. 77C). Next, the growth substrate 10 and the laminated member 35 which have been singulated are bonded to the first bonding surface 12A of the first supporting substrate 12 (refer to Fig. 78A). The bonding is performed by arranging the insulating layer 341 and the first bonding surface 12A of the first supporting substrate 12 so as to oppose each other, subsequently raising the temperature while applying a load, and causing covalent bonding to occur at the interface due to a dehydration condensation reaction. Accordingly, bonding strength is secured.

Next, the growth substrate 10 is removed to a vertex position of a convex portion provided on the first surface of the compound semiconductor layer 300 by, for example, chemical mechanical polishing (CMP). Accordingly, the reinforcing member 357 remains in a peripheral edge portion of the upper surface of the compound semiconductor layer 300 (refer to Fig. 78B). Next, the growth substrate 10 is peeled off from the compound semiconductor layer 300 by, for example, laser liftoff.

A series of subsequent manufacturing steps is implemented in a similar manner to (1) method of manufacturing light-emitting element layer 3 according to the first embodiment.

### [Operational effects]

In the sixth embodiment, the reinforcing member 357 is provided in the peripheral edge portion of the first surface of the compound semiconductor layer 300. The reinforcing member 357 enables tensile stress created in the peripheral edge portion of the first surface of the compound semiconductor layer 300 to be suppressed. Therefore, as illustrated in Fig. 78B, even when microcracks occur in the peripheral edge portion of the compound semiconductor layer 300 when thinning the growth substrate 10 and the laminated member 35 which have been singulated, the compound semiconductor layer 300 can be prevented from cracking due to tensile stress created in a vicinity of an edge.

### [Modifications]

### (First modification)

A shape, an arrangement, and the like of the reinforcing member 357 are not limited to those according to the sixth embodiment. For example, the shape, the arrangement, and the like of the reinforcing member 357 may be those adopted by the examples described below.

As illustrated in Fig. 79A, a portion corresponding to a corner of the compound semiconductor layer 300 in the reinforcing member 357 may protrude toward inside of the first surface of the compound semiconductor layer 300 in a plan view.

As illustrated in Figs. 79B and 79C, the reinforcing member 357 may only be provided in corners of the compound semiconductor layer 300 in a plan view. In this case, a shape of the reinforcing member 357 may be a rectangular shape in a plan view as illustrated in Fig. 79B or a triangular shape in a plan view as illustrated in Fig. 79C. The reinforcing member 357 may only be provided in side portions of the compound semiconductor layer 300 in a plan view. The reinforcing member 357 may be provided in a corner and on a side of the compound semiconductor layer 300 in a plan view.

As illustrated in Fig. 80A, the reinforcing member 357 may have a triangular shape in a sectional view.

As illustrated in Fig. 80B, the reinforcing member 357 may have one or two or more steps in a sectional view.

As illustrated in Fig. 81A, the reinforcing member 357 may protrude from the first surface of the compound semiconductor layer 300.

As illustrated in Fig. 81B, a first surface (upper surface) of the reinforcing member 357 may be lower than the first surface (upper surface) of the compound semiconductor layer 300.

As illustrated in Fig. 81C, the first surface of the compound semiconductor layer 300 may have a planar shape and the reinforcing member 357 may be provided in a peripheral edge portion of the planar first surface. In other words, the first surface of the compound semiconductor layer 300 includes a first region in which the reinforcing member 357 is provided and a second surface region in which the reinforcing member 357 is not provided and the first region and the second surface region of the first surface of the compound semiconductor layer 300 may be flush with each other.

### <7 Seventh embodiment>

### [Configuration of light-emitting apparatus 1F]

As illustrated in Fig. 88, a light-emitting apparatus 1F according to a seventh embodiment differs from the light-emitting apparatus 1 according to the first embodiment in that the light-emitting element 30 has a tapered shape on a side surface and the first light-reflecting layer 301 has a tapered shape which emulates the side surface of the light-emitting element 30. Note that in Fig. 88, a part of the wiring layer 24 according to the first embodiment is illustrated in an abbreviated manner as a multilayer wiring layer 24A. In addition, while Fig. 88 illustrates a configuration which does not include the color conversion layer 4, the filter layer 5, and the lens array 6, the color conversion layer 4, the filter layer 5, and the lens array 6 may be provided in a similar manner to the first embodiment.

### (Light-emitting element 30)

The light-emitting element 30 includes a light-emitting surface and a rear surface on an opposite side to the light-emitting surface. The light-emitting element 30 sequentially includes a first side surface portion 30A and a second side surface portion 30B on the side surface from the rear surface of the light-emitting element 30 toward the light-emitting surface. The first side surface portion 30A and the second side surface portion 302B have a tapered shape. The tapered shape of the first side surface portion 30A and the second side surface portion 30B is an inclined shape in which a width of the light-emitting element 30 gradually decreases from a side of the light-emitting surface toward a side of the rear surface. A taper angle of the first side surface portion 30A is larger than a taper angle of the second side surface portion 30B. Accordingly, an area of the surface on a side of the n-type first compound semiconductor layer 31 of the light-emitting element 30 (an area of the light-emitting surface of the light-emitting element 30) is larger than an area of the surface on a side of the p-type second compound semiconductor layer 32 of the light-emitting element 30 (an area of the rear surface of the light-emitting element 30). In the seventh embodiment, the p-type second compound semiconductor layer 32 is arranged on the side of the driving circuit board 2 and the n-type first compound semiconductor layer 31 is arranged on the side of the light-emitting surface which is opposite to the driving circuit board 2.

### (First light-reflecting layer 301)

The first light-reflecting layer 301 has a bowl shape and houses the light-emitting element 30. The first light-reflecting layer 301 includes a bottom portion 302 and a peripheral wall portion 303.

The bottom portion 302 covers a rear surface 30S2 of the light-emitting element 30. A hole portion 305 is provided at center of the bottom portion 302 and penetrates the bottom portion 302 in a thickness direction thereof. The plug wiring 36 is connected to the rear surface of the light-emitting element 30 via the hole portion 305. Note that illustration of the transparent electrode 321 provided on a rear surface side of the light-emitting element 30 is omitted in Fig. 88.

The peripheral wall portion 303 covers the side surface of the light-emitting element 30. The peripheral wall portion 303 is erected on a peripheral wall portion on an upper surface of the bottom portion 302. The peripheral wall portion 303 sequentially includes a first peripheral wall portion 303A and a second peripheral wall portion 303B from a lower portion toward an upper portion of the peripheral wall portion 303. The first peripheral wall portion 303A and the second peripheral wall portion 303B have a tapered shape. The tapered shape of the first peripheral wall portion 303A and the second peripheral wall portion 303B is an inclined shape in which a width of the peripheral wall portion 303 gradually decreases from a side of an opening 304 toward a side of the bottom portion 302. A taper angle of the first peripheral wall portion 303A is larger than a taper angle of the second peripheral wall portion 303B.

### [Method of manufacturing light-emitting apparatus 1F]

For example, the light-emitting apparatus 1F configured as described above can be obtained as follows. In a step of separating the singulated compound semiconductor layer 300 in plurality and forming a plurality of the light-emitting elements 30 (for example, the step illustrated in Fig. 16), the light-emitting apparatus 1F can be obtained by adjusting conditions of separation processing such as dry etching and forming a tapered shape on the side surfaces of the light-emitting elements 30.

Specifically, a first pixel separation groove is formed by processing a mesa shape from a surface on the side of the p-type second compound semiconductor layer 32 of the compound semiconductor layer 300 to midway in the thickness direction of the compound semiconductor layer 300. The first side surface portion 30A of the light-emitting element 30 is formed by the first pixel separation groove. After formation of the first pixel separation groove, a second pixel separation groove is formed by processing in approximately the thickness direction of the compound semiconductor layer 300 from the midway position to the surface on the side of the n-type first compound semiconductor layer 31. The second side surface portion 30B of the light-emitting element 30 is formed by the second pixel separation groove.

### [Operational effects]

In the light-emitting apparatus 1F according to the seventh embodiment, the light-emitting element 30 has a tapered shape on the side surface. The tapered shape is an inclined shape in which a width of the light-emitting element 30 gradually decreases from a side of the light-emitting surface toward a side of the rear surface of the light-emitting element 30. In addition, the peripheral wall portion 303 of the first light-reflecting layer 301 has a tapered shape which emulates the side surface of the light-emitting element 30. Accordingly, light emitted toward the side from the active layer 33 can be directed toward the front. Therefore, light extraction efficiency of the light-emitting apparatus 1F can be improved.

### <8 Eighth embodiment>

### [Configuration of light-emitting apparatus 1G]

As illustrated in Fig. 89, a light-emitting apparatus 1G according to an eighth embodiment differs from the light-emitting apparatus 1F according to the seventh embodiment in that the n-type first compound semiconductor layer 31 is arranged on the side of the driving circuit board 2 and the p-type second compound semiconductor layer 32 is arranged on the side of the light-emitting surface which is opposite to the driving circuit board 2.

The light-emitting element 30 sequentially includes the first side surface portion 30A and the second side surface portion 30B on the side surface from the rear surface of the light-emitting element 30 toward the light-emitting surface in a similar manner to the seventh embodiment. The taper angle of the first side surface portion 30A is larger than the taper angle of the second side surface portion 30B in a similar manner to the seventh embodiment. Accordingly, the area of the surface on the side of the p-type second compound semiconductor layer 32 of the light-emitting element 30 (an area of the light-emitting surface of the light-emitting element 30) is larger than the area of the surface on the side of the n-type first compound semiconductor layer 31 of the light-emitting element 30 (an area of the rear surface of the light-emitting element 30). The light-emitting element 30 is configured such that the light-emitting surface side is the p-type second compound semiconductor layer 32 and the rear surface side which does not affect a light emission region is the n-type first compound semiconductor layer 31. In the eighth embodiment, a cathode side of the light-emitting element 30 is made an individual electrode and an anode side is made a common electrode. In the eighth embodiment, from the perspective of improving light emission efficiency, a boundary between the first side surface portion 30A and the second side surface portion 30B is preferably positioned on a side surface of the n-type first compound semiconductor layer 31.

### [Method of manufacturing light-emitting apparatus 1G]

For example, the light-emitting apparatus 1G configured as described above can be obtained as follows. After the step of removing the undoped gallium nitride layer 315 of the compound semiconductor layer 300 (for example, the step illustrated in Figs. 12A and 12B), pixel separation is performed by processing the compound semiconductor layer 300 as follows.

The first pixel separation groove is formed by processing a mesa shape from a surface on the side of the n-type first compound semiconductor layer 31 of the compound semiconductor layer 300 to midway of the first compound semiconductor layer 31 in the thickness direction of the compound semiconductor layer 300. The first side surface portion 30A of the light-emitting element 30 is formed by the first pixel separation groove. After formation of the first pixel separation groove, the second pixel separation groove is formed by processing in approximately the thickness direction of the compound semiconductor layer 300 from the midway position to the surface on the side of the p-type second compound semiconductor layer 32. The second side surface portion 30B of the light-emitting element 30 is formed by the second pixel separation groove.

### [Operational effects]

In the light-emitting apparatus 1F according to the seventh embodiment, the p-type second compound semiconductor layer 32 is arranged on the side of the driving circuit board 2 and the n-type first compound semiconductor layer 31 is arranged on the light-emitting surface side which is opposite to the driving circuit board 2. Usually, the p-type second compound semiconductor layer 32 on the light-emitting surface side is significantly thinner than the n-type first compound semiconductor layer 31 on the rear surface side. Therefore, increasing the taper angle of the light-emitting element 30 causes the light emission region to decrease and the light emission efficiency to decline.

In the light-emitting apparatus 1G according to the eighth embodiment, the n-type first compound semiconductor layer 31 is arranged on the side of the driving circuit board 2 and the p-type second compound semiconductor layer 32 is arranged on the light-emitting surface side which is opposite to the driving circuit board 2. Therefore, even when the taper angle of the light-emitting element 30 is increased, a decrease of the light emission region can be suppressed and a decline of the light emission efficiency can be suppressed.

Conventionally, a compound semiconductor layer was processed from the side of the p-type second compound semiconductor layer in a state of an LED substrate. By comparison, in a method of manufacturing the light-emitting apparatus 1G according to the eighth embodiment, since the light-emitting element 30 is bonded to the driving circuit board 2 after being singulated, the compound semiconductor layer can be processed from the side of the n-type first compound semiconductor layer 31. Therefore, a decrease of the light emission region can be suppressed and a tapered shape which enables high light extraction efficiency to be obtained can be imparted to the light-emitting element 30.

### [Modifications]

### (First modification)

In the first embodiment and the like, an example in which the reflection attenuation layer 312 is arranged on the transparent electrode 311 between light-emitting elements 30 in a plan view has been described (refer to Figs. 1 and 2). However, the present disclosure is not limited to this example and, for example, a metal layer 316 may be arranged instead of the reflection attenuation layer 312 as illustrated in Fig. 90A.

For example, the metal layer 316 includes tungsten (W). The metal layer 316 has a protruding portion 317 on a rear surface which opposes the transparent electrode 311. The protruding portion 317 protrudes toward the transparent electrode 311.

The insulating layer 346 is provided on the transparent electrode 311. The insulating layer 346 includes the opening 346A. The opening 346A is arranged in portions between the light-emitting elements 30 in a plan view. The opening 346A penetrates the insulating layer 346 in a thickness direction and the protruding portion 317 is brought into contact with the upper surface of the transparent electrode 311 via the opening 346A. A hole portion 347 may have a slit shape in a plan view.

A connection mode of the metal layer 316 and the transparent electrode 311 is not limited to the example described above. However, the connection mode described below may be adopted.

As illustrated in Fig. 90B, the transparent electrode 311 may include a hole portion 311A and the protruding portion 317 may be fitted into the hole portion 311A. In this case, the transparent electrode 311 may be segmented by the protruding portion 317 at a position between adjacent light-emitting elements 30. The hole portion 311A may have a slit shape in a plan view.

As illustrated in Fig. 91A, the metal layer 316 may not include the protruding portion 317 and the metal layer 316 may be directly provided on the transparent electrode 311.

As illustrated in Fig. 91B, the metal layer 316 may be directly provided on the transparent electrode 311 and the protruding portion 317 may be fitted into the hole portion 311A of the transparent electrode 311.

### (Second modification)

In the first embodiment and the like, an example in which the through wiring 313 is a TCV has been described (refer to Fig. 1). However, the through wiring 313 is not limited thereto and may be configured as described below.

As illustrated in Fig. 92, the through wiring 313 may be a plug. The plug is, for example, a tungsten plug. An upper end of the through wiring 313 is connected to the rear surface of the transparent electrode 311 and a lower end of the through wiring 313 is connected to the second light-shielding layer 26.

As illustrated in Fig. 93, the transparent electrode 311 may be connected to a plug as the through wiring 313 via a metal pad 318. The metal pad 318 is provided on an upper surface of the transparent electrode 311 and a part of the metal pad 318 is extended from a peripheral edge to the outside of the transparent electrode 311. The upper end of the through wiring 313 is connected to a rear surface of the extended portion.

### (Third modification)

In the seventh embodiment and the like, an example in which the first side surface portion 30A and the second side surface portion 30B of the light-emitting element 30 have a tapered shape and the first peripheral wall portion 303A and the second peripheral wall portion 303B of the first light-reflecting layer 301 have a tapered shape has been described (refer to Fig. 88). However, configurations of the light-emitting element 30 and the first light-reflecting layer 301 are not limited to this example and, for example, the light-emitting element 30 and the first light-reflecting layer 301 may be configured as follows.

As illustrated in Fig. 94, the light-emitting element 30 may have a tapered shape in a range from the rear surface to a predetermined thickness of the light-emitting element 30. More specifically, the light-emitting element 30 sequentially includes the first side surface portion 30A with a tapered shape and the second side surface portion 30B which is approximately parallel with respect to an axis extending in the thickness direction of the light-emitting element 30 on the side surface from the rear surface of the light-emitting element 30 toward the light-emitting surface. In this case, approximately parallel is assumed to include parallel.

As illustrated in Fig. 94, the peripheral wall portion 303 may have a tapered shape in a range from a lower portion to a predetermined height of the peripheral wall portion 303. More specifically, the peripheral wall portion 303 may sequentially include the first peripheral wall portion 303A with a tapered shape and the second peripheral wall portion 303B which is approximately parallel with respect to an axis extending in the thickness direction of the light-emitting element 30 from the lower portion toward the upper portion of the peripheral wall portion 303.

As illustrated in Fig. 95, the peripheral wall portion 303 of the first light-reflecting layer 301 may include a step 306 between the first peripheral wall portion 303A and the second peripheral wall portion 303B.

As illustrated in Fig. 96, the light-emitting element 30 may sequentially include the first side surface portion 30A which is approximately parallel with respect to an axis extending in the thickness direction of the light-emitting element 30 and the second side surface portion 30B with a tapered shape on the side surface from the rear surface of the light-emitting element 30 toward the light-emitting surface. The peripheral wall portion 303 may sequentially include the first peripheral wall portion 303A which is approximately parallel with respect to an axis extending in the thickness direction of the light-emitting element 30 and the second peripheral wall portion 303B with a tapered shape from the lower portion toward the upper portion of the peripheral wall portion 303.

Although not illustrated, the light-emitting element 30 may sequentially include the first side surface portion 30A with a tapered shape and the second side surface portion 30B with a tapered shape on the side surface from the rear surface of the light-emitting element 30 toward the light-emitting surface and a taper angle of the first side surface portion 30A may be smaller than a taper angle of the second side surface portion 30B. The peripheral wall portion 303 may sequentially include the first peripheral wall portion 303A with a tapered shape and the second peripheral wall portion 303B with a tapered shape from the lower portion toward the upper portion of the peripheral wall portion 303 and a taper angle of the first peripheral wall portion 303A may be smaller than a taper angle of the second peripheral wall portion 303B.

As illustrated in Fig. 97, the light-emitting element 30 may sequentially include the first side surface portion 30A which is approximately parallel with respect to an axis extending in the thickness direction of the light-emitting element 30 and the second side surface portion 30B which is approximately parallel with respect to an axis extending in the thickness direction of the light-emitting element 30 on the side surface from the rear surface of the light-emitting element 30 toward the light-emitting surface. In this case, the width of the light-emitting element 30 in the second side surface portion 30B is larger than the width of the light-emitting element 30 in the first side surface portion 30A.

The peripheral wall portion 303 may sequentially include the first peripheral wall portion 303A which is approximately parallel with respect to an axis extending in the thickness direction of the light-emitting element 30 and the second peripheral wall portion 303B which is approximately parallel with respect to an axis extending in the thickness direction of the light-emitting element 30 from the lower portion toward the upper portion of the peripheral wall portion 303. In this case, a width of an accommodation space in the second peripheral wall portion 303B is larger than a width of an accommodation space in the first peripheral wall portion 303A.

### (Fourth modification)

As illustrated in Fig. 98, an insulating material 319 may be provided between the peripheral edge portion of the light-emitting surface of the light-emitting element 30 and the transparent electrode 311. In this case, a non-injection region is formed in the peripheral edge portion of the light-emitting surface of the light-emitting element 30. Here, the peripheral edge portion of the light-emitting surface of the light-emitting element 30 refers to a region having a predetermined width toward the inner side from the peripheral edge of the light-emitting surface of the light-emitting element 30. The insulating material 319 may be a part of the insulating layer 34.

As illustrated in Fig. 99, a metal layer 320 may be provided between the peripheral edge portion of the light-emitting surface of the light-emitting element 30 and the transparent electrode 311. In this case, a non-injection region is formed in the peripheral edge portion of the light-emitting surface of the light-emitting element 30. The metal layer 320 may be arranged so as to straddle adjacent light-emitting elements 30. For example, the metal layer 320 contains metal incapable of obtaining favorable ohmic contact with the second compound semiconductor layer 32 including p-type gallium nitride (p-GaN). Examples of such a metal include titanium (Ti) and tungsten (W).

### (Fifth modification)

In the eighth embodiment and the like, an example in which the plug wiring 36 is connected to the rear surface side of the light-emitting element 30 via the hole portion 305 provided in the bottom portion 302 of the first light-reflecting layer 301 has been described (refer to Fig. 89). However, the present disclosure is not limited to this example and, for example, as illustrated in Fig. 100, the plug wiring 36 may be connected to the rear surface of the bottom portion 302 of the first light-reflecting layer 301, insulating material may not be provided between the light-emitting element 30 and the first light-reflecting layer 301, and the light-emitting element 30 and the first light-reflecting layer 301 may be in contact with each other. In this case, as a material of the first light-reflecting layer 301, a metal is used which enables a contact between the second compound semiconductor layer 32 including p-type gallium nitride (p-GaN) or the like and the first light-reflecting layer 301 to be a Schottky contact and a contact between the first compound semiconductor layer 31 including n-type gallium nitride (n-GaN) and the first light-reflecting layer 301 to be a favorable ohmic contact. Examples of such a metal include Ti and Al. In such a case, the first light-reflecting layer 301 can doubly serve a function as a reflecting layer or a light-shielding layer and a function as a contact electrode with the first compound semiconductor layer 31.

### (Sixth modification)

The light-emitting apparatus 1G and the like may further include various layers on the light-emitting surface. Hereinafter, examples of the various layers included on the light-emitting surface will be described.

As illustrated in Fig. 101, the light-emitting apparatus 1G may include the lens array 6 on the insulating layer 346. The configuration of the lens array 6 is as described in the first embodiment.

As illustrated in Fig. 102, the light-emitting apparatus 1G may sequentially include the color conversion portion 40 and a protective layer 91 on the insulating layer 346. The configuration of the color conversion portion 40 is as described in the first embodiment. The protective layer 91 is, for example, a hard coat layer.

As illustrated in Fig. 103, the light-emitting apparatus 1G may sequentially include the protective layer 91 and a Distributed Bragg Reflector (DBR) 92 on the insulating layer 346.

As illustrated in Fig. 104, the light-emitting apparatus 1G may sequentially include the protective layer 91 and a color filter 93 on the insulating layer 346.

Note that the light-emitting apparatus 1G may include a combination of two or more or three or more of the various layers described above. In addition, while an example in which the light-emitting apparatus 1G according to the eighth embodiment includes the various layers has been described above, the display apparatus according to each embodiment other than the eighth embodiment may include the various layers.

### (Seventh modification)

As illustrated in Fig. 105, the bottom portion 302 of the first light-reflecting layer 301 may include a wall portion 307. The wall portion 307 is provided along the hole portion 305 on the upper surface of the bottom portion 302. The wall portion 307 may have a ring shape. A vertex of the wall portion 307 may be separated from a surface on a rear surface side of the light-emitting element 30 or may be in contact with the surface on the rear surface side of the light-emitting element 30.

### <9 Ninth embodiment>

### [Configuration of light-emitting apparatus 1H]

As illustrated in Fig. 106, a light-emitting apparatus 1H according to a ninth embodiment differs from the light-emitting apparatus 1F according to the seventh embodiment in that the light-emitting apparatus 1H includes a contact electrode 322 in place of the transparent electrode 321.

An insulating layer 358 is provided on a rear surface side of the contact electrode 322. The insulating layer 358 includes a hole portion 358A at a position corresponding to a center of the rear surface of the light-emitting element 30. The hole portion 358A penetrates in a thickness direction of the insulating layer 358. The plug wiring 36 is connected to the rear surface of the contact electrode 322 via the hole portion 358A. The insulating layer 358 may be used as a hard mask when forming the contact electrode 322 by etching.

A side surface of the contact electrode 322 is set back with respect to the side surface of the light-emitting element 30 (second compound semiconductor layer 32) and the side surface of the insulating layer 341 and a concave structure (recessed structure) 322A is constructed between an upper surface of the insulating layer 358 and the peripheral edge portion of the rear surface of the light-emitting element 30 (second compound semiconductor layer 32). The concave structure 322A may be filled with an inorganic material 323 with insulation properties. The inorganic material 323 may be the same as a material of the insulating layer 34 which covers the side surface of the light-emitting element 30 or may differ from the material of the insulating layer 34. For example, the inorganic material 323 includes silicon oxide (SiOₓ) or silicon nitride (SiNₓ). For example, as illustrated in Fig. 106, a sectional shape of the side surface of the contact electrode 322 may be a concave curved shape.

For example, the contact electrode 322 includes at least one selected from the group consisting of zinc oxide (ZnO), indium tin oxide (ITO), indium zinc oxide (IZO), tin oxide (SnO), palladium (Pd), chromium (Cr), titanium (Ti), aluminum (Al), platinum (Pt), silver (Ag), nickel (Ni), and gold (Au). The contact electrode 322 may have a laminated structure in which a plurality of layers are laminated. In this case, each layer constituting the laminated structure independently includes at least one selected from the group of materials described above.

### [Method of manufacturing light-emitting apparatus 1H]

For example, the light-emitting apparatus 1H configured as described above can be obtained as follows.

First, steps up to the peeling step of the first supporting substrate 12 (refer to Figs. 15A and 15B) are implemented in a similar manner to the method of manufacturing the light-emitting apparatus 1 according to the first embodiment with the exception of forming the contact electrode 322 instead of the transparent electrode 321.

Next, as illustrated in Fig. 107A, the insulating layer 358 is formed on the contact electrode 322 as a hard mask. Note that illustration of layers below the second compound semiconductor layer 32 is omitted in Fig. 107A. Next, as illustrated in Fig. 107B, the contact electrode 322 is dry-etched through the insulating layer 358 as a hard mask.

Next, as illustrated in Fig. 107C, the contact electrode 322 is wet-etched through the insulating layer 358 as hard mask. Accordingly, the side surface of the contact electrode 322 is set back with respect to a side surface of an opening pattern of the insulating layer 358 and the concave structure (recessed structure) 322Ais formed. Next, as illustrated in Fig. 107D, the first pixel separation groove is formed by performing mesa processing of the second compound semiconductor layer 32 and the like. The first side surface portion 30A of the light-emitting element 30 is formed by the first pixel separation groove. Subsequent steps are similar to those of the method of manufacturing the light-emitting apparatus 1F according to the seventh embodiment.

### [Operational effects]

When separating light-emitting elements (pixels) from each other by dry etching (mesa processing), there is a risk that side surfaces of the light-emitting elements 30 are damaged by plasma and defects are created on the side surfaces of the light-emitting elements 30. When a defect is created on the side surfaces of the light-emitting elements 30, the defect is to act as a non-light-emitting recombination center (refer to Applied Physics Express 12, 097004 (2019)).

When sizes of the second compound semiconductor layer 32 and the transparent electrode (contact electrode) 321 are approximately the same as in the light-emitting apparatus 1F according to the seventh embodiment, the transparent electrode 321 is to overlap with a damage occurrence region where damage occurs due to plasma in the thickness direction of the light-emitting element 30. Therefore, when the light-emitting element 30 is driven, holes are also injected into the damage occurrence region and internal quantum efficiency (IQE) drops. In other words, light emission efficiency declines.

In the light-emitting apparatus 1H according to the ninth embodiment, the contact electrode 322 is set back with respect to the side surface of the light-emitting element 30 (second compound semiconductor layer 32) and the side surface of the insulating layer 358 and the concave structure (recessed structure) 322A is constructed between the upper surface of the insulating layer 358 and the peripheral edge portion of the rear surface of the light-emitting element 30 (second compound semiconductor layer 32). Accordingly, carrier trapping to a defect which is created during dry etching (mesa processing) is suppressed and a drop in internal quantum efficiency is suppressed. In other words, a decline in light emission efficiency is suppressed.

When the p-type second compound semiconductor layer 32 is arranged on the side of the driving circuit board 2 as in the light-emitting apparatus 1H according to the ninth embodiment, holes are less likely to be diffused in a lateral direction (the in-plane directions of the light-emitting element 30) due to high sheet resistance of p-type compound semiconductors such as p-type gallium nitride (p-GaN). Therefore, holes are particularly less likely to be injected into the damage occurrence region due to plasma.

### [Modifications]

### (First modification)

An example in which the concave structure 322A is filled with the inorganic material 323 with insulation properties has been described in the ninth embodiment (refer to Fig. 106). However, the present disclosure is not limited to this example and, for example, the concave structure 322A may be configured as described below.

As illustrated in Fig. 108A, the concave structure 322A may be a cavity 324.

As illustrated in Fig. 108B, the concave structure 322A may be filled with an organic material 325 with insulation properties. In this case, the side surface of the light-emitting element 30 may also be covered by the organic material 325. For example, a space between the side surface of the light-emitting element 30 and the first light-reflecting layer 301 may be filled with the organic material 325.

### (Second modification)

An example in which the sectional shape of the side surface of the contact electrode 322 is a concave curved shape has been described in the ninth embodiment (refer to Fig. 106). However, the side surface shape of the contact electrode 322 is not limited to this example and, for example, the side surface of the contact electrode 322 may have a tapered shape as illustrated in Fig. 109A. The tapered shape may be an inclined shape in which the width of the light-emitting element 30 gradually decreases from the side of the light-emitting surface toward the side of the rear surface of the light-emitting element 30.

### (Third modification)

An example in which the insulating layer 358 is provided on the rear surface of the contact electrode 322 has been described in the ninth embodiment (refer to Fig. 106). However, the present disclosure is not limited to this example and, for example, a metal layer 359 may be provided in place of the insulating layer 358 as illustrated in Fig. 109B. The metal layer 359 may be used as a hard mask when forming the contact electrode 322 by etching.

As illustrated in Fig. 106, when the insulating layer 358 is provided on the rear surface of the contact electrode 322, the hole portion 358A is provided in the insulating layer 358 and the plug wiring 36 is connected to the rear surface of the contact electrode 322 via the hole portion 358A. However, when the metal layer 359 is provided on the rear surface of the contact electrode 322 as described above, the hole portion 358A may not be provided on the metal layer 359 and the plug wiring 36 may be connected to a rear surface of the metal layer 359.

### <10 Tenth embodiment>

In the light-emitting apparatus 1G illustrated in Fig. 103 and the like, a laminate including the transparent electrode 311 and the insulating layer 346 is provided between the second compound semiconductor layer 32 of the light-emitting element 30 and the color conversion portion 40 and a large number of interfaces exist. Since refractive indexes of two layers which constitute an interface usually differ from each other, there is a risk that light loss may occur due to interfacial reflection and light emission efficiency may decline. In addition, interfacially-reflected light may cause noise such as crosstalk.

An example of materials used in the second compound semiconductor layer 32, the contact electrode 322, the insulating layer 346, and the color conversion portion 40 and a refractive index n (a refractive index n relative to visible light) of each of the materials are listed below.
Color conversion portion 40: acrylic resin (n = 1.5) used together with quantum dots (QDs)
Insulating layer 346: SiN (n = 2.0) or SiO (n = 1.4)
Contact electrode 322: ITO (n = 2.1 to 2.2)
Second compound semiconductor layer 32: GaN (n = 2.37 to 2.44)

In the tenth embodiment, a light-emitting apparatus capable of suppressing interfacial reflection by providing a concave-convex structure equal to or shorter than a wavelength of light on a layer with a lower refractive index of the two layers which constitute an interface will be described.

The concave-convex structure is preferably provided on the interface between the light-emitting element 30 (for example, the second compound semiconductor layer 32) and the transparent electrode 311 and on the interface between the insulating layer 346 and the color conversion portion 40.

The concave-convex structure is preferably formed by maskless patterning. Examples of a formation method of the concave-convex structure by maskless patterning include nanoimprinting, self-assembling lithography (Directed Self-Assembly: DSA), and a formation method using nanoparticles. With a formation method of the concave-convex structure using DSA and the like, since there is no need to use an exposure machine as in optical lithography, the concave-convex structure can be formed at low cost.

For example, self-assembling lithography is as described above. With a polymer compound (diblock copolymer) which chemically combines two polymers, characteristically, repulsion between polymers tends to cause phase separation due to low compatibility. Using this characteristic, by applying a diblock copolymer on a substrate, reacting the copolymer by heat, and causing self-assembly, a fine concave-convex pattern can be formed.

### [Configuration of light-emitting apparatus 1I]

As illustrated in Fig. 110, the light-emitting apparatus 1I according to the tenth embodiment differs from the light-emitting apparatus 1G according to the eighth embodiment in that a concave-convex structure 3460 is provided on an upper surface (a surface to be on the side of the color conversion layer 4) of the insulating layer 346 and an upper surface (a surface to be on the side of the partition wall 41) of the metal layer 316 or, in other words, the concave-convex structure 3460 is provided on an interface between an insulating layer 340 and the color conversion portion 40 and an interface between the metal layer 316 and the partition wall 41. The light-emitting apparatus 1I may include the reflection attenuation layer 312 in place of the metal layer 316.

The concave-convex structure 3460 on the upper surface of the insulating layer 346 and the concave-convex structure 3460 on the upper surface of the metal layer 316 may be constituted of the same material as the insulating layer 346. The insulating layer 346 and the concave-convex structure 3460 on the upper surface of the insulating layer 346 may be integrally formed. The concave-convex structure 3460 on the upper surface of the insulating layer 346 and the concave-convex structure 3460 on the upper surface of the metal layer 316 may be provided at the same height or provided at different heights.

The concave-convex structure 3460 is constituted of a plurality of structures 3461 two-dimensionally arranged on the upper surface of the insulating layer 346 and the upper surface of the metal layer 316. The plurality of structures 3461 may be randomly arranged or periodically arranged. The structures 3461 are so-called nanostructures and may be any of convex structures and concave structures. The concave-convex structure 3460 may include both convex structures 3461 and concave structures 3461.

A size of the structure 3461 is preferably equal to or less than the wavelength of light λ and more preferably equal to or less than 1/2 of the wavelength of light λ. The wavelength of light λ is preferably selected from a wavelength region of visible light in accordance with desired characteristics. The wavelength of light λ is particularly preferably approximately equal to a peak wavelength of light emitted from the light-emitting element 30. In the present specification, visible light refers to light in a wavelength range from 360 nm or more to 830 nm.

An arrangement period of the structures 3461 is preferably equal to or less than the wavelength of light λ and more preferably equal to or less than 1/2 of the wavelength of light λ. The wavelength of light λ is preferably selected from a wavelength region of visible light in accordance with desired characteristics. The wavelength of light λ is particularly preferably approximately equal to a peak wavelength of light emitted from the light-emitting element 30.

While examples of a shape of the structures 3461 include a pyramid shape, an inverted pyramid shape, a bell shape, and a columnar shape, the shape of the structures 3461 is not limited to these shapes. The plurality of structures 3461 may include structures 3461 with two or more shapes. The concave-convex structure 3460 may be a random hole.

### [Method of manufacturing light-emitting apparatus 1I]

For example, the light-emitting apparatus 1I configured as described above can be obtained as follows.

First, steps up to the forming step of the transparent electrode 311 are implemented in a similar manner to the method of manufacturing the light-emitting apparatus 1 according to the first embodiment. Next, for example, after forming the metal layer 316 made of tungsten on the transparent electrode 311, the metal layer 316 is patterned as illustrated in Fig. 111A. A region where the metal layer 316 has been removed becomes an optical path along which light is emitted.

Next, for example, the insulating layer 346 including SiN is formed on the transparent electrode 311 so as to cover the patterned metal layer 316. The insulating layer 346 functions as an etching stopper layer when forming the partition wall 41. Next, as illustrated in Fig. 111B, by applying a resin composition on the insulating layer 346 and curing the resin composition, a resin layer 34A is formed on the insulating layer 346. Next, as illustrated in Fig. 111C, by etching-back the resin layer 34A and the insulating layer 346 using dry etching, the upper surface of the insulating layer 346 is planarized. Note that a processing method of the resin layer 34A and the insulating layer 346 for planarizing the upper surface of the insulating layer 346 is not limited to dry etching and CMP (Chemical Mechanical Polishing) may be used.

Next, for example, by applying a diblock copolymer on the planarized insulating layer 346 and prompting the polymer to react with heat, a concave-convex structure 34B is formed in a self-aligning manner as illustrated in Fig. 111D. Next, for example, as illustrated in Fig. 112A, by processing the insulating layer 346 by dry etching using the concave-convex structure 34B as a mask, the concave-convex structure 3460 is formed on an upper surface of the insulating layer 346 and an upper surface of a metal layer 316B. In doing so, for example, the concave-convex structure 3460 is formed at a position at the same height as the upper surface of the metal layer 316 or at a position which is higher than the upper surface of the metal layer 316.

Next, as illustrated in Fig. 112B, the partition wall 41 made of an oxide such as silicon oxide (SiOₓ) is formed on the concave-convex structure 3460 of the metal layer 316. Next, as illustrated in Fig. 112C, the second light-reflecting layer 401 made of, for example, aluminum (Al) is formed on a side surface of the partition wall 41. Subsequent steps are performed in a similar manner to the method of manufacturing the light-emitting apparatus 1 according to the first embodiment to form the color conversion layer 4 and the like.

### [Operational effects]

In the light-emitting apparatus 1I according to the tenth embodiment, the concave-convex structure 3460 is provided on the upper surface (a surface to be on the side of the color conversion layer 4) of the insulating layer 346. In other words, the concave-convex structure 3460 is provided on the interface between the insulating layer 340 and the color conversion portion 40. Due to the fine concave-convex structure 3460 being provided on the interface, a smooth refractive index distribution is formed on the interface. Therefore, interfacial reflection between the insulating layer 346 and the color conversion portion 40 can be reduced and light extraction efficiency from the light-emitting element 30 can be improved.

Since the concave-convex structure 3460 is also provided on the upper surface of the metal layer 316, crosstalk due to guided light and leaking light between pixels can be reduced.

Using DSA, nanoimprinting, nanoparticles, or the like as a patterning method of the concave-convex structure 3460 enables fabrication cost of the concave-convex structure 3460 to be reduced as compared to general optical lithography.

### [Modifications]

### (First modification)

An example in which the concave-convex structure 3460 is provided on the upper surface of the insulating layer 346 has been described in the tenth embodiment. However, the present disclosure is not limited to this example and, for example, as illustrated in Fig. 113, the concave-convex structure 3460 may be provided on the upper surface of the light-emitting element 30 (specifically, the upper surface of the second compound semiconductor layer 32). In other words, the concave-convex structure 3460 may be provided on the interface between the light-emitting element 30 (specifically, the second compound semiconductor layer 32) and the transparent electrode (contact electrode) 311. The concave-convex structure 3460 on the upper surface of the light-emitting element 30 may be constituted of the same material as the second compound semiconductor layer 32. The second compound semiconductor layer 32 and the concave-convex structure 3460 on the upper surface of the second compound semiconductor layer 32 may be integrally formed.

### (Second modification)

An example in which the concave-convex structure 3460 on the upper surface of the insulating layer 346 and the concave-convex structure 3460 on the upper surface of the metal layer 316 are constituted of the same material as the insulating layer 346 has been described in the tenth embodiment. However, the present disclosure is not limited to this example and, for example, as illustrated in Fig. 114, while the concave-convex structure 3460 on the upper surface of the insulating layer 346 is constituted of the same material as the insulating layer 346, the concave-convex structure 3460 on the upper surface of the metal layer 316 may be constituted of the same material as the metal layer 316. The insulating layer 346 and the concave-convex structure 3460 on the upper surface of the insulating layer 346 may be integrally formed and the metal layer 316 and the concave-convex structure 3460 on the upper surface of the metal layer 316 may be integrally formed.

For example, the concave-convex structure 3460 on the upper surface of the insulating layer 346 and the upper surface of the metal layer 316 can be formed as follows. The concave-convex structure 34B is formed on the insulating layer 346 in a similar manner to the method of manufacturing the light-emitting apparatus 1I according to the tenth embodiment (refer to Fig. 111D). Subsequently, the insulating layer 346 and the metal layer 316 are processed by dry etching using the concave-convex structure 34B as a mask. Accordingly, the concave-convex structure 3460 is formed on the upper surface of the insulating layer 346 and the upper surface of the metal layer 316.

### <11 Eleventh embodiment>

In the manufacturing step of the light-emitting apparatus 1 according to the first embodiment or, more specifically, the step of processing an insulating layer by dry etching and forming the partition wall 41 (refer to Fig. 27), it is difficult to stop processing at a position of the upper surface of the reflection attenuation layer 312 and there is a risk of exposing and inadvertently grinding the transparent electrode 311. Grinding of the transparent electrode 311 may impact optical characteristics and electrical characteristics of the light-emitting apparatus 1. In an eleventh embodiment, a light-emitting apparatus 1J capable of suppressing such an impact on optical characteristics and electrical characteristics will be described.

### [Light-emitting apparatus 1J]

As illustrated in Fig. 115, the light-emitting apparatus 1J according to the eleventh embodiment differs from the light-emitting apparatus 1G according to the eighth embodiment in that the light-emitting apparatus 1J includes the insulating layer 346 as an etching stopper layer between the transparent electrode (contact electrode) 311 and the color conversion portion 40. The light-emitting apparatus 1J according to the eleventh embodiment may include the insulating layer 346 between the metal layer 316 and the partition wall 41. The insulating layer 346 between the transparent electrode 311 and the color conversion portion 40 and the insulating layer 346 between the metal layer 316 and the partition wall 41 may be constituted of the same insulating material.

An etching rate of the insulating material which constitutes the insulating layer 346 is lower than an etching rate of the insulating material which constitutes the partition wall 41. Examples of the insulating material which constitutes the insulating layer 346 include silicon nitride (SiNₓ), silicon oxynitride (SiOₓN_{y}), and silicon carbonitride (SiCₓN_{y}). Examples of the insulating material which constitutes the partition wall 41 include silicon oxide (SiOₓ).

A lower portion of the second light-reflecting layer 401 is preferably in contact with the upper surface of the metal layer 316. Accordingly, emitted light from the light-emitting element 30 can be prevented from penetrating into the partition wall 41.

### [Method of manufacturing light-emitting apparatus 1J]

For example, the light-emitting apparatus 1J configured as described above can be obtained as follows.

First, steps up to the forming step of the transparent electrode 311 is implemented in a similar manner to the method of manufacturing the light-emitting apparatus 1 according to the first embodiment. Next, in a similar manner to the method of manufacturing the light-emitting apparatus 1J according to the tenth embodiment, after forming the metal layer 316 on the transparent electrode 311 and patterning the metal layer 316, the insulating layer 346 made of SiN or the like is formed on the transparent electrode 311 so as to cover the patterned metal layer 316 (refer to Figs. 111A and 111B). Next, in a similar manner to the method of manufacturing the light-emitting apparatus 1J according to the tenth embodiment, after forming the resin layer 34A on the insulating layer 346, the upper surface of the insulating layer 346 is planarized by etching-back the resin layer 34A and the insulating layer 346 using dry etching (refer to Fig. 111C).

Next, as illustrated in Fig. 116A, an insulating layer 411 made of silicon oxide (SiOₓ) or the like is formed on the insulating layer 346 by, for example, a chemical vapor deposition (CVD) method or sputtering. Next, as illustrated in Fig. 116B, the partition wall 41 is formed between the light-emitting elements 30 by, for example, photolithography and dry etching. The etching is stopped at the insulating layer 346 as an etching stopper layer. The etching is preferably performed until the upper surface of the metal layer 316 is exposed. Exposing the upper surface of the metal layer 316 enables the lower portion of the second light-reflecting layer 401 and the upper surface of the metal layer 316 to come into contact with each other in a next step (forming step of the second light-reflecting layer 401). Next, as illustrated in Fig. 116C, the second light-reflecting layer 401 made of, for example, aluminum (Al) is formed on the side surface of the partition wall 41 by, for example, a chemical vapor deposition (CVD) method. Subsequent steps are performed in a similar manner to the method of manufacturing the light-emitting apparatus 1 according to the first embodiment to form the color conversion layer 4 and the like.

### [Operational effects]

The light-emitting apparatus 1J according to the eleventh embodiment includes the insulating layer 346 as an etching stopper layer between the transparent electrode (contact electrode) 311 and the color conversion portion 40. Accordingly, when forming the partition wall 41 by etching, the etching is stopped at the insulating layer 346 as an etching stopper layer. Therefore, grinding of the transparent electrode 311 due to etching can be suppressed. As a result, an effect of grinding of the transparent electrode 311 with respect to optical characteristics and electrical characteristics of the light-emitting apparatus 1J can be suppressed.

Including the forming step of the insulating layer 346 as an etching stopper layer and a planarizing step of the insulating layer 346 enables the insulating layer 346 to be thickly formed on the transparent electrode 311. Therefore, grinding of the transparent electrode 311 due to etching can be further suppressed.

### [Modifications]

### (First modification)

As illustrated in Fig. 117, the peripheral edge portion of the metal layer 316 may project over the insulating layer 346 in a flange shape. The metal layer 316 configured in this manner can be formed by reversing a formation order of the metal layer 316 and the insulating layer 346 in the method of manufacturing the light-emitting apparatus 1J according to the eleventh embodiment or, in other words, forming the metal layer 316 after forming the insulating layer 346. Hereinafter, details of the method of manufacturing the light-emitting apparatus 1J will be described.

First, as illustrated in Fig. 118A, the insulating layer 346 made of silicon nitride (SiNₓ) or the like is formed on the transparent electrode 311 by, for example, a chemical vapor deposition (CVD) method or sputtering. Next, the insulating layer 346 is patterned by, for example, photolithography and etching. Next, the metal layer 316 is formed on the transparent electrode 311 by, for example, a chemical vapor deposition (CVD) method or sputtering. Next, the metal layer 316 is patterned as illustrated in Fig. 118B by, for example, photolithography and etching. In doing so, the peripheral edge portion of the metal layer 316 remains in a state where the peripheral edge portion projects over the insulating layer 346 in a flange shape.

Next, as illustrated in Fig. 118C, the insulating layer 411 made of silicon oxide (SiOₓ) or the like is formed on the insulating layer 346 and the metal layer 316 by, for example, a chemical vapor deposition (CVD) method or sputtering. Next, as illustrated in Fig. 118D, the partition wall 41 is formed on the metal layer 316 by, for example, photolithography and dry etching. The etching is stopped at the insulating layer 346 as an etching stopper layer. A gap may be formed between the portion projected in a flange shape of the metal layer 316 and the upper surface of the insulating layer 346. Next, as illustrated in Fig. 118E, the second light-reflecting layer 401 made of, for example, aluminum (Al) is formed on the side surface of the partition wall 41 by, for example, a chemical vapor deposition (CVD) method.

### (Second modification)

As illustrated in Fig. 119, the upper surface of the light-emitting element 30 or, in other words, the upper surface of the second compound semiconductor layer 32 may be roughened. Due to the roughening, a concave-convex structure 349A may be formed. The concave-convex structure 349A may be similar to the concave-convex structure 3460 according to the tenth embodiment. A concave-convex structure 349B which emulates the concave-convex structure 349A may be formed on the upper surface of the transparent electrode 311.

### <12 Application examples>

### (Electronic devices)

The light-emitting apparatuses 1, 1A, 1B, 1C, 1D, 1E, 1F, 1G, 1H, 1I, and 1J (hereinafter, referred to as "light-emitting apparatuses 1 and the like") according to the embodiments and modifications described above may be included in various electronic devices as display apparatuses. Particularly, the light-emitting apparatuses 1 and the like are suitable for applications where high resolution is required and the light-emitting apparatuses are used for enlargement near eyes such as an electronic viewfinder of a video camera or a single-lens reflex camera or a head-mounted display.

### (Specific example 1)

Figs. 82A and 82B illustrate an example of an appearance of a digital still camera 1310. The digital still camera 1310 is of a lens exchange-type single-lens reflex type and includes an exchange-type photographing lens unit (exchange lens) 1312 substantially at a center of a front surface of a camera main body unit (camera body) 1311 and a grip portion 1313 which is to be gripped by a photographer and which is provided on a left side of the front surface.

A monitor 1314 is provided at a position shifted to the left from a center of a rear surface of the camera main body unit 1311. An electronic viewfinder (eyepiece window) 1315 is provided in an upper part of the monitor 1314. Viewing through the electronic viewfinder 1315 allows the photographer to visually recognize an optical subject image guided from the photographing lens unit 1312 and determine a composition. The electronic viewfinder 1315 includes any of the light-emitting apparatuses 1 and the like described above.

### (Specific example 2)

Fig. 83 illustrates an example of an appearance of a head-mounted display 1320. The head-mounted display 1320 includes, for example, ear hooks 1322 on both sides of an eyeglasses-shaped display unit 1321 for wearing the display on the head of a user. The display unit 1321 includes any of the light-emitting apparatuses 1 and the like described above.

### (Specific example 3)

Fig. 84 illustrates an example of an appearance of a television device 1330. The television device 1330 includes, for example, a video display screen unit 1331 including a front panel 1332 and a filter glass 1333, and the video display screen unit 1331 includes any of the light-emitting apparatuses 1 and the like.

### (Specific example 4)

Fig. 85 illustrates an example of an appearance of a see-through head-mounted display 1340. The see-through head-mounted display 1340 includes a main body unit 1341, an arm 1342, and a lens barrel 1343.

The main body unit 1341 is connected to the arm 1342 and eyeglasses 1350. Specifically, an end of the main body unit 1341 in a long-side direction is coupled to the arm 1342, and one side surface of the main body unit 1341 is connected to the eyeglasses 1350 via a connecting member. Note that the main body unit 1341 may be directly mounted to a head of a person.

The main body unit 1341 has a built-in control board for controlling operations of the see-through head-mounted display 1340 and a built-in display unit. The arm 1342 connects the main body unit 1341 to the lens barrel 1343 and supports the lens barrel 1343. Specifically, the arm 1342 is coupled to both an end part of the main body unit 1341 and an end part of the lens barrel 1343 and anchors the lens barrel 1343. The arm 1342 also has a built-in signal line for communicating data pertaining to images provided from the main body unit 1341 to the lens barrel 1343.

The lens barrel 1343 projects image light provided from the main body unit 1341 via the arm 1342 through an ocular lens 1351 toward an eye of a user wearing the see-through head-mounted display 1340. In the see-through head-mounted display 1340, the display unit of the main body unit 1341 includes any of the light-emitting apparatuses 1 and the like described above.

### (Specific example 5)

Fig. 86 illustrates an example of an appearance of a smartphone 1360. The smartphone 1360 includes a display unit 1361 that displays various information and an operation unit 1362 that includes buttons and the like that accept an operation input by a user. The display unit 1361 includes any of the light-emitting apparatuses 1 and the like described above.

### (Specific example 6)

The light-emitting apparatuses 1 and the like described above may be included in various displays included in a vehicle.

Figs. 87A and 87B are diagrams illustrating an example of a configuration of an interior of a vehicle 1500 including various displays. Specifically, Fig. 50A is a diagram illustrating an example of a state of the interior of the vehicle 1500 from the rear to the front of the vehicle 1500, and Fig. 50B is a diagram illustrating an example of a state of the interior of the vehicle 1500 from diagonally rear to diagonally front of the vehicle 1500.

The vehicle 1500 includes a center display 1501, a console display 1502, a head-up display 1503, a digital rearview mirror 1504, a steering wheel display 1505, and a rear entertainment display 1506. At least one of these displays includes any of the light-emitting apparatuses 1 and the like described above. For example, all of these displays may include any of the light-emitting apparatuses 1 and the like described above.

The center display 1501 is disposed on a dashboard facing a driver's seat 1508 and a passenger seat 1509. Although Figs. 87A and 87B illustrate an example of a horizontally-long center display 1501 which extends from a side of the driver's seat 1508 to a side of the passenger seat 1509, a screen size and an arrangement location of the center display 1501 are optional. The center display 1501 can display information detected by various sensors. As specific examples, the center display 1501 can display a photographed image taken by an image sensor, a distance image to an obstacle in front of or to the side of the vehicle 1500 as measured by a ToF sensor, and an occupant's body temperature detected by an infrared sensor. The center display 1501 can be used to display, for example, at least one of safety-related information, operation-related information, a lifelog, health-related information, authentication/identification-related information, and entertainment-related information.

The safety-related information includes dozing detection, looking-aside detection, the detection of mischief by kids on board, seat-belt usage, and the detection of occupants left behind. The safety-related information is detected by, for example, a sensor placed in an overlapping manner on a rear surface side of the center display 1501. For the operation-related information, gestures of occupants' operations are detected by using a sensor. The detected gestures may include the operations of various kinds of equipment in the vehicle 1500. For example, the operations of air-conditioning equipment, a navigation system, an AV system, and a lighting system are detected. The lifelog includes lifelogs of all occupants. For example, the lifelog includes an action record of each of the occupants on board. Obtaining and storing the lifelogs makes it possible to confirm the states of occupants in the event of an accident. The health-related information is obtained by detecting the body temperature of an occupant using a sensor such as a temperature sensor and estimating the state of health of the occupant based on the detected body temperature. Alternatively, an image of the occupant's face may be captured using an image sensor and the state of health of the occupant may then be estimated on the basis of the occupant's facial expression in the image. Furthermore, automatic speech conversations may be performed with the occupant and the state of health of the occupant may then be estimated on the basis of the content of the occupant's responses. The authentication/identification-related information includes a remote keyless entry function for performing face authentication using a sensor and an automatic adjustment function of a seat height or position in face authentication. The entertainment-related information includes a function of detecting occupant operation information about an AV system by using a sensor and a function of recognizing the face of an occupant through a sensor and providing suitable contents for the occupant through the AV system.

The console display 1502 can be used to display lifelog information, for example. The console display 1502 is disposed near a shift lever 1511 of a central console 1510 between the driver's seat 1508 and the passenger seat 1509. Information detected by various sensors can also be displayed on the console display 1502. Furthermore, the console display 1502 may display an image captured around the vehicle by an image sensor or a distance image to an obstacle around the vehicle.

The head-up display 1503 is virtually displayed at the front of a windshield 1512 in front of the driver's seat 1508. The head-up display 1503 can be used for displaying, for example, at least one of safety-related information, operation-related information, a lifelog, health-related information, authentication/identification-related information, and entertainment-related information. Since the head-up display 1503 is often virtually disposed in front of the driver's seat 1508, the head-up display 1503 is suitable for displaying information directly related to the operations of the vehicle 1500 such as a speed or an amount of remaining fuel (battery) of the vehicle 1500.

The digital rearview mirror 1504 can not only display the rear of the vehicle 1500 but can also display a state of an occupant in the rear seat. Thus, by placing a sensor on the rear surface side of the digital rearview mirror 1504 in an overlapping manner, the digital rearview mirror 1504 can be used for displaying, for example, lifelog information.

The steering wheel display 1505 is disposed around a center of a steering wheel 1513 of the vehicle 1500. The steering wheel display 1505 can be used to display, for example, at least one of safety-related information, operation-related information, a lifelog, health-related information, authentication/identification-related information, and entertainment-related information. In particular, since the steering wheel display 1505 is disposed near the hands of the driver, the steering wheel display 1505 is suitable for displaying lifelog information such as the driver's body temperature, information about the operations of the AV system or air-conditioning equipment, and the like.

The rear entertainment display 1506 is attached to the rear surface side of the driver's seat 1508 or the passenger seat 1509 and allows an occupant in the rear seat to view information. The rear entertainment display 1506 can be used to display, for example, at least one of safety-related information, operation-related information, a lifelog, health-related information, authentication/identification-related information, and entertainment-related information. In particular, since the rear entertainment display 1506 is disposed directly in front of the occupant in the rear seat, the rear entertainment display 1506 displays information related to the occupant in the rear seat. For example, the rear entertainment display 1506 may display information about the operations of the AV system or the air-conditioning equipment or the result of measuring a body temperature or the like of an occupant in the rear seat by a temperature sensor.

A configuration may be adopted in which a sensor is displayed on a rear surface side of the light-emitting apparatuses 1 and the like in an overlapping manner to enable a distance to an object near the vehicle to be measured. Optical rangefinding methods are broadly classified into passive types and active types. The passive type measures a distance by receiving light from an object without projecting light onto the object from a sensor. Examples of the passive type include a lens focal method, a stereo method, and a monocular method. The active type measures a distance by projecting light onto an object and receiving reflected light from the object by a sensor. Examples of the active type include an optical radar system, an active stereo system, an illuminance difference stereo method, a moire topography method, and interferometry. The light-emitting apparatuses 1 and the like described above can be applied to any of these rangefinding methods. Using the sensor overlaid on the rear surface side of the light-emitting apparatuses 1 and the like described above enables the passive-type or active-type rangefinding described above to be performed.

While the first to sixth embodiments, the seventh to eleventh embodiments, and modification of the embodiments of the present disclosure have been specifically described above, the present disclosure is not limited to the first to sixth embodiments, the seventh to eleventh embodiments, and the modification of the embodiments and various modifications based on the technical idea of the present disclosure can be made.

For example, the configurations, methods, processes, shapes, materials, numerical values, and the like described in the first to sixth embodiments, the seventh to eleventh embodiments, and the modification of the embodiments are merely exemplary and different configurations, methods, processes, shapes, materials, numerical values, and the like may be optionally used.

For example, the configurations, methods, processes, shapes, materials, numerical values, and the like of the first to sixth embodiments, the seventh to eleventh embodiments, and the modification of the embodiments can be mutually combined without departing from the gist of the present disclosure.

For example, unless otherwise specified, among the materials exemplified in the first to sixth embodiments, the seventh to eleventh embodiments, and the modification of the embodiments, one of the materials may be used alone or two or more of the materials may be used in combination.

In addition, the present disclosure may also adopt the following configurations.
(1) A laminate, including:
   a driving circuit board; and
   a semiconductor element layer which is provided on the driving circuit board and which includes a compound semiconductor layer,
   wherein
   the compound semiconductor layer has an oval shape, a polygonal shape of which at least a corner has been cut off, or a polygonal shape of which at least a corner has been bent into a convex shape in a plan view.
(2) The laminate according to (1), wherein
   the compound semiconductor layer has an oval shape, a polygonal shape of which each corner has been cut off, or a polygonal shape of which each corner has been bent into a convex shape in a plan view.
(3) The laminate according to (1) or (2), wherein
   the polygonal shape is a rectangular shape.
(4) The laminate according to any one of (1) to (3), wherein
   the driving circuit board includes a substrate, and
   the substrate and the compound semiconductor layer are constituted of different materials.
(5) The laminate according to any one of (1) to (4), wherein
   an area of the semiconductor element layer in a plan view is smaller than an area of the driving circuit board in a plan view, and
   the driving circuit board and the semiconductor element layer are bonded to each other by metal bonding, insulating layer bonding, or hybrid bonding which combines the metal bonding and the insulating layer bonding.
(6) The laminate according to any one of (1) to (5), wherein
   the compound semiconductor layer includes at least one optical semiconductor element.
(7) The laminate according to (6), wherein
   the at least one optical semiconductor element includes a plurality of optical semiconductor elements, and
   the plurality of optical semiconductor elements are provided in an array.
(8) The laminate according to (7), wherein
   the plurality of optical semiconductor elements are formed over an entire surface of the compound semiconductor layer or in a part of the compound semiconductor layer.
(9) The laminate according to any one of (1) to (8), wherein
   the semiconductor element layer further includes an insulating layer, and the insulating layer is configured to cover a side surface of the compound semiconductor layer and a surface on a side of the driving circuit board of the compound semiconductor layer.
(10) The laminate according to any one of (1) to (9), wherein
   a portion where the corner has been cut off and a portion where the corner has been bent into the convex shape are set back inward by 10 µm or more from a vertex of the corner of the polygonal shape.
(11) The laminate according to any one of (1) to (10), wherein
   the semiconductor element layer includes a groove and the groove is provided along a peripheral edge of a surface on an opposite side to the driving circuit board.
(12) The laminate according to any one of (1) to (11), further including
   a protective layer configured to cover a side surface of the compound semiconductor layer.
(13) The laminate according to (12), wherein
   the compound semiconductor layer includes a surface on an opposite side to the compound semiconductor layer, and
   the protective layer is configured to further cover a peripheral edge portion of the surface on the opposite side.
(14) The laminate according to (12) or (13), wherein
   the compound semiconductor layer includes a surface on a side of the driving circuit board, and
   the protective layer is configured to further cover a peripheral edge portion of the surface on the side of the driving circuit board.
(15) The laminate according to any one of (1) to (14), wherein
   the compound semiconductor layer includes an extended portion which is extended from a side surface of the compound semiconductor layer.
(16) The laminate according to (15), wherein
   the extended portion includes the same material as the compound semiconductor layer.
(17) The laminate according to any one of (1) to (8), wherein
   the compound semiconductor layer includes a surface on an opposite side to the driving circuit board, and
   the laminate further includes a reinforcing member provided in a peripheral edge portion of the surface on the opposite side.
(18) The laminate according to (17), wherein
   the reinforcing member is provided on at least one of a corner and a side which constitute the peripheral edge portion of the surface on the opposite side.
(19) The laminate according to (17) or (18), wherein
   the reinforcing member includes sapphire or silicon.
(20) An electronic device including the laminate according to any one of (1) to (19).
(2-1) A light-emitting apparatus, including:
   a driving circuit board;
   a semiconductor element layer which is provided on the driving circuit board and which includes a compound semiconductor layer; and
   a first protective layer configured to cover a side surface of the compound semiconductor layer.
(2-2) The light-emitting apparatus according to (2-1), further including a second protective layer configured to cover a peripheral edge portion of an upper surface of the compound semiconductor layer.
(2-3) The light-emitting apparatus according to (2-1), wherein
   the first protective layer and the second protective layer are constituted of the same material.
(2-4) The light-emitting apparatus according to (2-1), wherein
   the semiconductor element layer further includes a transparent electrode, and
   the first protective layer is configured to also cover a side surface of the transparent electrode.
(2-5) The light-emitting apparatus according to (2-1), wherein
   an area of the compound semiconductor layer in a plan view is smaller than an area of the driving circuit board in a plan view, and
   the driving circuit board and the semiconductor element layer are bonded to each other by metal bonding, insulating layer bonding, or hybrid bonding which combines the metal bonding and the insulating layer bonding.
(2-6) The light-emitting apparatus according to (2-1), wherein
   the semiconductor element layer further includes an insulating layer, and
   the insulating layer is configured to cover a side surface of the compound semiconductor layer and a surface on a side of the driving circuit board of the compound semiconductor layer.
(2-7) The light-emitting apparatus according to (2-1), wherein
   the compound semiconductor layer has an oval shape, a polygonal shape of which at least a corner has been cut off, or a polygonal shape of which at least a corner has been bent into a convex shape in a plan view.
(3-1) A light-emitting apparatus, including:
   a first substrate which includes a drive circuit; and
   a second substrate which includes a light-emitting element including a compound layer,
   wherein
   the light-emitting element and the drive circuit are electrically connected to each other.
(3-2) The light-emitting apparatus according to (3-1), wherein
   the compound layer is a compound semiconductor layer.
(3-3) The light-emitting apparatus according to (3-2), wherein
   the compound semiconductor layer includes GaN.
(3-4) The light-emitting apparatus according to (3-1), wherein
   the compound semiconductor layer is separated from an end surface of the light-emitting element, and
   an end surface of the compound semiconductor layer is inside of the element.
(3-5) The light-emitting apparatus according to (3-2), further including
   a protective layer configured to protect a side surface of the compound semiconductor layer.
(3-6) The light-emitting apparatus according to (3-5), wherein
   the second substrate further includes an insulating layer, and
   the insulating layer and the protective layer are made of the same material.
(3-7) The light-emitting apparatus according to (3-5), wherein
   the light-emitting element includes a transparent electrode, and
   the protective layer is configured to protect a side surface of the transparent electrode and a side surface of the compound semiconductor layer.
(3-8) The light-emitting apparatus according to (3-5), wherein
   the compound semiconductor layer includes a surface positioned on a side of the first substrate, and
   the protective layer is configured to protect an outer peripheral portion of the surface.
(4-1) A light-emitting apparatus, including:
   a driving circuit board; and
   a semiconductor element layer which is provided on the driving circuit board and which includes a compound semiconductor layer,
   wherein
   the compound semiconductor layer includes an extended portion which is extended from a side surface of the compound semiconductor layer.
(4-2) The light-emitting apparatus according to (4-1), wherein
   the extended portion includes the same material as the compound semiconductor layer.
(4-3) The light-emitting apparatus according to (4-1), wherein
   the compound semiconductor layer and the extended portion include GaN.
(4-4) The light-emitting apparatus according to (4-1), wherein
   the semiconductor element layer includes an insulating layer and/or a metal layer on a side of the drive circuit.
(4-5) The light-emitting apparatus according to (4-1), wherein
   the extended portion includes a compound semiconductor layer.
(4-6) The light-emitting apparatus according to (4-5), wherein
   the extended portion includes a transparent electrode.
(5-1) A light-emitting apparatus, including:
   a driving circuit board;
   a semiconductor element layer which is provided on the driving circuit board and which includes a compound semiconductor layer; and
   a protective layer configured to cover a side surface of the compound semiconductor layer.
(5-2) The light-emitting apparatus according to (5-1), further including
   a wiring configured to electrically connect the driving circuit board and the semiconductor element layer to each other, wherein
   an area of the compound semiconductor layer in a plan view is smaller than an area of the driving circuit board in a plan view.
(5-3) The light-emitting apparatus according to (5-1), further including
   an insulating layer (buried layer) provided on an outer side of the reinforcing layer.
(5-4) The light-emitting apparatus according to (5-1), wherein
   the driving circuit board includes a substrate, and
   the substrate and the compound semiconductor layer are constituted of different materials.
(5-5) The light-emitting apparatus according to (5-1), wherein
   the compound semiconductor layer includes GaN or AlInGaP.
(5-6) The light-emitting apparatus according to (5-1), wherein
   the driving circuit board and the semiconductor element layer are bonded to each other by metal bonding, insulating layer bonding, or hybrid bonding which combines the metal bonding and the insulating layer bonding.
(5-7) The light-emitting apparatus according to (5-1), wherein
   the reinforcing layer is the same layer as a layer present between the driving circuit board and the semiconductor element layer so as to straddle a light-emitting element.
(5-8) The light-emitting apparatus according to (5-1), further including:
   an insulating layer (buried layer) provided on an outer side of the reinforcing layer, wherein
   the reinforcing layer is the same layer as a layer present between the insulating layer and the driving circuit board.
(5-9) The light-emitting apparatus according to (5-1), wherein
   the reinforcing layer is an inorganic oxide layer or an organic layer.
(5-10) The light-emitting apparatus according to (5-1), further including
   an insulating layer (buried layer) provided on an outer side of the reinforcing layer, wherein
   the insulating layer is an inorganic oxide layer or an organic layer.
(5-11) The light-emitting apparatus according to (5-1), further including
   a passivation layer provided between the compound semiconductor layer and the reinforcing layer.
(6-1) A light-emitting apparatus, including:
   a driving circuit board; and
   a semiconductor element layer which is provided on the driving circuit board and which includes a compound semiconductor layer,
   wherein
   the compound semiconductor layer includes a surface on an opposite side to the driving circuit board, and
   a reinforcing member is provided in a peripheral edge portion of the surface on the opposite side.
(6-2) The light-emitting apparatus according to (6-1), wherein
   the reinforcing member is provided on at least one of a corner and a side which constitute the peripheral edge portion.
(6-3) The light-emitting apparatus according to (6-1), wherein
   the surface on the opposite side includes a first region where the reinforcing member is provided and a second region where the reinforcing member is not provided, and
   the first region and the second region of the surface on the opposite side are flush with each other.
(6-4) The light-emitting apparatus according to (6-1), wherein
   the surface on the opposite side includes a first surface on which the reinforcing member is provided and a second surface on which the reinforcing member is not provided, and
   a height of the first surface relative to the driving circuit board is lower than a height of the second surface relative to the driving circuit board.
(6-5) The light-emitting apparatus according to (6-1), wherein
   the driving circuit board includes a substrate, and
   the substrate and the compound semiconductor layer are constituted of different materials.
(6-6) The light-emitting apparatus according to (6-1), wherein
   the compound semiconductor layer includes GaN or AlInGaP.
(6-7) The light-emitting apparatus according to (6-1), wherein
   the driving circuit board and the semiconductor element layer are bonded to each other by metal bonding, insulating layer bonding, or hybrid bonding which combines the metal bonding and the insulating layer bonding.
(6-8) The light-emitting apparatus according to (6-1), wherein
   the reinforcing member includes sapphire or silicon.
(7-1) A light-emitting apparatus, including
   an optical semiconductor element which sequentially includes an n-type compound semiconductor layer, an active layer, and a p-type compound semiconductor layer, wherein
   a surface on a side of the p-type compound semiconductor layer of the optical semiconductor element is configured as a light-emitting surface, and
   an area of the surface on the side of the p-type compound semiconductor layer of the optical semiconductor element is larger than a surface on a side of the n-type compound semiconductor layer of the optical semiconductor element.
(7-2) The light-emitting apparatus according to (7-1), wherein
   the optical semiconductor element sequentially includes a first side surface portion and a second side surface portion on a side surface from the surface on the side of the n-type compound semiconductor layer toward the surface on the side of the p-type compound semiconductor layer,
   the first side surface portion and the second side surface portion have tapered shapes, and
   a taper angle of the first side surface portion and a taper angle of the second side surface portion differ from each other.
(7-3) The light-emitting apparatus according to (7-1), wherein
   the optical semiconductor element sequentially includes a first side surface portion and a second side surface portion on a side surface from the surface on the side of the n-type compound semiconductor layer toward the surface on the side of the p-type compound semiconductor layer,
   the first side surface portion and the second side surface portion have tapered shapes, and
   a taper angle of the first side surface portion is larger than a taper angle of the second side surface portion.
(7-4) The light-emitting apparatus according to (7-1), wherein
   the optical semiconductor element sequentially includes a first side surface portion and a second side surface portion on a side surface from the surface on the side of the n-type compound semiconductor layer toward the surface on the side of the p-type compound semiconductor layer,
   the first side surface portion has a tapered shape, and
   the second side surface portion is approximately parallel with respect to an axis extending in a thickness direction of the light-emitting element.
(7-5) A method of manufacturing a light-emitting apparatus, including the steps of:
   forming a first pixel separation groove by processing a mesa shape in a compound semiconductor layer sequentially including an n-type compound semiconductor layer, an active layer, and a p-type compound semiconductor layer from a surface on a side of the n-type compound semiconductor layer to a position midway through the n-type compound semiconductor layer; and
   forming a second pixel separation groove by processing from the midway position to a surface on the side of the p-type compound semiconductor layer.
(7-6) The method of manufacturing a light-emitting apparatus according to (7-5), wherein
   in the step of forming a second pixel separation groove, re-patterning is performed.
(7-7) The method of manufacturing a light-emitting apparatus according to (7-5), wherein
   a direction of processing from the midway position of the n-type compound semiconductor layer to a surface on the side of the p-type compound semiconductor layer is approximately equivalent to a thickness direction of the compound semiconductor layer.
(7-8) The method of manufacturing a light-emitting apparatus according to (7-5), wherein
   in the step of forming a first pixel separation groove, a first side surface portion with a tapered shape is formed,
   in the step of forming a second pixel separation groove, a second side surface portion with a tapered shape is formed, and
   a taper angle of the first side surface portion and a taper angle of the second side surface portion differ from each other.
(7-9) The method of manufacturing a light-emitting apparatus according to (7-5), wherein
   in the step of forming a first pixel separation groove, a first side surface portion with a tapered shape is formed,
   in the step of forming a second pixel separation groove, a second side surface portion with a tapered shape is formed, and
   a taper angle of the first side surface portion is larger than a taper angle of the second side surface portion.
(7-10) The method of manufacturing a light-emitting apparatus according to (7-5), wherein
   in the step of forming a first pixel separation groove, a first side surface portion with a tapered shape is formed, and
   in the step of forming a second pixel separation groove, a second side surface portion which is approximately parallel with respect to an axis extending in a thickness direction of the compound semiconductor layer is formed.
(8-1) A light-emitting apparatus, including
   an insulating layer, a contact electrode, and an optical semiconductor element in sequence, wherein
   a side surface of the contact electrode is set back with respect to a side surface of the insulating layer and a side surface of the optical semiconductor element.
(8-2) The light-emitting apparatus, including
   a metal layer, a contact electrode, and an optical semiconductor element in sequence, wherein
   a side surface of the contact electrode is set back with respect to a side surface of the metal layer and a side surface of the optical semiconductor element.
(8-3) The light-emitting apparatus according to (8-1) or (8-2), wherein
   the optical semiconductor element sequentially includes a p-type compound semiconductor layer, an active layer, and an n-type compound semiconductor layer, and
   the p-type compound semiconductor layer is provided on a side of the contact electrode.
(9-1) A light-emitting apparatus, including:
   a light-emitting element layer including a plurality of optical semiconductor elements; and
   a color conversion layer which is provided on the light-emitting element layer and which includes a plurality of color conversion portions,
   wherein
   a boundary portion between the light-emitting element layer and the color conversion layer includes at least one interface provided with a concave-convex structure, and
   the concave-convex structure is constituted of a plurality of nanostructures.
(9-2) The light-emitting apparatus according to (9-1), wherein
   the plurality of nanostructures are arranged at a period equal to or less than the wavelength of light.
(9-3) The light-emitting apparatus according to (9-1), wherein
   the light-emitting element layer includes an insulating layer provided under the color conversion portions, and
   the at least one interface includes an interface between the insulating layer and the color conversion portions.
(9-4) The light-emitting apparatus according to (9-3), wherein
   the color conversion layer includes a wall portion in which a reflecting layer is provided on a side surface,
   the light-emitting element layer includes a metal layer provided under a bottom portion of the wall portion, and
   the at least one interface includes an interface between the metal layer and the wall portion.
(9-5) The light-emitting apparatus according to (9-1), wherein
   the light-emitting element layer includes a contact electrode provided on the plurality of light-emitting elements, and
   the at least one interface includes an interface between the light-emitting elements and the contact electrode.
(9-6) The light-emitting apparatus according to (9-1), wherein
   the color conversion portions include quantum dots and a resin material.
(10-1) A light-emitting apparatus, including:
   a plurality of optical semiconductor elements;
   a transparent electrode provided on the plurality of optical semiconductor elements;
   a plurality of color conversion portions, each of which being provided above each of the plurality of optical semiconductor elements;
   an insulating layer provided between the transparent electrode and the plurality of color conversion portions; and
   a partition wall provided between the color conversion portions,
   wherein
   an etching rate of the insulating layer is lower than an etching rate of the partition wall.
(10-2) The light-emitting apparatus according to (10-1), wherein
   the insulating layer functions as an etching stopper layer.
(10-3) The light-emitting apparatus according to (10-1), further including:
   a reflecting layer provided on a side surface of the partition wall; and
   a metal layer provided in a portion corresponding to a space between adjacent light-emitting elements on the transparent electrode,
   wherein
   a lower portion of the reflecting layer is in contact with an upper surface of the metal layer.
(10-4) The light-emitting apparatus according to (10-1), wherein
   the insulating layer includes silicon nitride (SiNₓ), silicon oxynitride (SiOₓN_{y}), or silicon carbonitride (SiCₓN_{y}).
(10-5) The light-emitting apparatus according to (10-1), wherein
   the partition wall includes silicon oxide (SiOₓ).
(10-6) The light-emitting apparatus according to (10-1), wherein
   an upper surface of the light-emitting element has been roughened.
(10-7) A method of manufacturing a light-emitting apparatus, including the steps of: forming a plurality of optical semiconductor elements;
   forming a transparent electrode on the plurality of optical semiconductor elements;
   forming a metal layer in a portion corresponding to a space between adjacent light-emitting elements on the transparent electrode;
   forming a first insulating film on the transparent electrode so as to cover the metal layer;
   forming a resin layer on the first insulating layer;
   planarizing a surface of the first insulating layer by sequentially processing the resin layer and the first insulating layer; and
   forming a partition wall on the metal layer by forming a second insulating layer on the first insulating layer and etching the second insulating layer,
   wherein
   an etching rate of the first insulating layer is lower than an etching rate of the second insulating layer.
(10-8) The method of manufacturing a light-emitting apparatus according to (10-7), wherein
   the processing with respect to the resin layer and the first insulating layer is dry etching or CMP (Chemical Mechanical Polishing).
(10-9) The method of manufacturing a light-emitting apparatus according to (10-7), wherein
   the first insulating layer functions as an etching stopper layer.
(10-10) The method of manufacturing a light-emitting apparatus according to (10-7), further including the step of
   forming a reflecting layer on a side surface of the partition wall, wherein the etching of the second insulating layer is performed until an upper surface of the metal layer is exposed, and
   when forming the reflecting layer, a lower portion of the reflecting layer is brought into contact with the upper surface of the metal layer.
(10-11) The method of manufacturing a light-emitting apparatus according to (10-7), wherein
   the first insulating layer includes silicon nitride (SiNₓ), silicon oxynitride (SiOₓN_{y}), or silicon carbonitride (SiCₓN_{y}).
(10-12) The method of manufacturing a light-emitting apparatus according to (10-7), wherein
   the second insulating layer includes silicon oxide (SiOₓ).
(10-13) The method of manufacturing a light-emitting apparatus according to (10-7), further including the step of
   roughening an upper surface of the light-emitting elements.

### [Reference Signs List]

- 1, 1A, 1B, 1C, 1D, 1E: Light-emitting apparatus
- 10: Growth substrate
- 10A: Groove
- 10B: Concave portion
- 12: First supporting substrate
- 13: Second supporting substrate
- 2: Driving circuit board
- 20: Substrate
- 21: Drive circuit
- 23: Insulated gate field-effect transistor
- 27: Second light-absorbing layer
- 26, 271: Second light-shielding layer
- 281, 391: First terminal
- 282, 392: Second terminal
- 3: Light-emitting element layer
- 30: Light-emitting element
- 300A: Groove
- 301: First light-reflecting layer
- 31: First compound semiconductor layer
- 311, 321: Transparent electrode
- 312: Reflection attenuation layer
- 313: Through wiring
- 32: Second compound semiconductor layer
- 33: Active layer
- 34: Insulating layer
- 35: Compound semiconductor layer
- 35A: Corner
- 351, 352: Protective layer
- 353: Adhesive layer
- 354: Extended portion
- 354A: Mask
- 355: Reinforcing layer
- 356: Passivation layer
- 357: Reinforcing member
- 36: Plug wiring
- 37: First light-absorbing layer
- 38, 381, 382: First light-shielding layer
- 4: Color conversion layer
- 40: Color conversion portion
- 401: Second light-reflecting layer
- 41: Partition wall
- 5: Filter layer
- 50: Filter portion
- 6: Lens array
- 60: On-chip lens
- 7: Element array region
- 8: Peripheral region

## Claims

1. A laminate, comprising:
a driving circuit board; and
a semiconductor element layer which is provided on the driving circuit board and which includes a compound semiconductor layer,
wherein
the compound semiconductor layer has an oval shape, a polygonal shape of which at least a corner has been cut off, or a polygonal shape of which at least a corner has been bent into a convex shape in a plan view.

2. The laminate according to claim 1, wherein
the compound semiconductor layer has an oval shape, a polygonal shape of which each corner has been cut off, or a polygonal shape of which each corner has been bent into a convex shape in a plan view.

3. The laminate according to claim 1, wherein
the polygonal shape is a rectangular shape.

4. The laminate according to claim 1, wherein
the driving circuit board includes a substrate, and
the substrate and the compound semiconductor layer are constituted of different materials.

5. The laminate according to claim 1, wherein
an area of the semiconductor element layer in a plan view is smaller than an area of the driving circuit board in a plan view, and
the driving circuit board and the semiconductor element layer are bonded to each other by metal bonding, insulating layer bonding, or hybrid bonding which combines the metal bonding and the insulating layer bonding.

6. The laminate according to claim 1, wherein
the compound semiconductor layer includes at least one optical semiconductor element.

7. The laminate according to claim 6, wherein
the at least one optical semiconductor element includes a plurality of optical semiconductor elements, and
the plurality of optical semiconductor elements are provided in an array.

8. The laminate according to claim 7, wherein
the plurality of optical semiconductor elements are formed over an entire surface of the compound semiconductor layer or in a part of the compound semiconductor layer.

9. The laminate according to claim 1, wherein
the semiconductor element layer further includes an insulating layer, and
the insulating layer is configured to cover a side surface of the compound semiconductor layer and a surface on a side of the driving circuit board of the compound semiconductor layer.

10. The laminate according to claim 1, wherein
a portion where the corner has been cut off and a portion where the corner has been bent into the convex shape are set back inward by 10 µm or more from a vertex of the corner of the polygonal shape.

11. The laminate according to claim 1, wherein
the semiconductor element layer includes a groove and the groove is provided along a peripheral edge of a surface on an opposite side to the driving circuit board.

12. The laminate according to claim 1, further comprising
a protective layer configured to cover a side surface of the compound semiconductor layer.

13. The laminate according to claim 12, wherein
the compound semiconductor layer includes a surface on an opposite side to the compound semiconductor layer, and
the protective layer is configured to further cover a peripheral edge portion of the surface on the opposite side.

14. The laminate according to claim 12, wherein
the compound semiconductor layer includes a surface on a side of the driving circuit board, and
the protective layer is configured to further cover a peripheral edge portion of the surface on the side of the driving circuit board.

15. The laminate according to claim 1, wherein
the compound semiconductor layer includes an extended portion which is extended from a side surface of the compound semiconductor layer.

16. The laminate according to claim 15, wherein
the extended portion includes the same material as the compound semiconductor layer.

17. The laminate according to claim 1, wherein
the compound semiconductor layer includes a surface on an opposite side to the driving circuit board, and
the laminate further comprises a reinforcing member provided in a peripheral edge portion of the surface on the opposite side.

18. The laminate according to claim 17, wherein
the reinforcing member is provided on at least one of a corner and a side which constitute the peripheral edge portion of the surface on the opposite side.

19. The laminate according to claim 17, wherein
the reinforcing member includes sapphire or silicon.

20. An electronic device comprising the laminate according to claim 1.
